# EUROPEAN PATENT SPECIFICATION

(11) **EP 4 306 609 B1**
(45) Date of publication and mention of the grant of the patent: **14.10.2026**
(21) Application number: 22780452.3
(22) Date of filing: 24.03.2022
(51) Int. Cl.: C09K 3/00, B32B 7/06, C08G 77/20, C09D 183/04

(54) **LAMINATE, RELEASE AGENT COMPOSITION, AND METHOD FOR MANUFACTURING PROCESSED SEMICONDUCTOR SUBSTRATE**
LAMINAT, TRENNMITTELZUSAMMENSETZUNG UND VERFAHREN ZUR HERSTELLUNG EINES VERARBEITETEN HALBLEITERSUBSTRATS
STRATIFIÉ, COMPOSITION D'AGENT ANTIADHÉSIF ET PROCÉDÉ DE FABRICATION DE SUBSTRAT SEMI-CONDUCTEUR TRAITÉ

(30) Priority: 31.03.2021 JP 2021061710
(43) Date of publication of application: 17.01.2024
(73) Proprietor: Nissan Chemical Corporation, Tokyo 103-6119 (JP)
(72) Inventor: OGATA Hiroto, Toyama-shi, Toyama 939-2792 (JP); OKUNO Takahisa, Toyama-shi, Toyama 939-2792 (JP); SHINJO Tetsuya, Toyama-shi, Toyama 939-2792 (JP)
(74) Representative: Hoffmann Eitle
(86) International application number: PCT/JP2022/013858
(87) International publication number: WO 2022/210238

(56) References cited:
- WO-A1-2009/122984
- WO-A1-2018/056298
- WO-A1-2020/184618
- JP-A- 2013 133 580
- JP-A- 2019 186 352
- JP-B1- S5 221 083
- US-A1- 2017 326 850
- US-A1- 2018 223 181
- KAWAKAMI YUHSUKE ET AL: "Alternative Copolymers of Polydimethylsiloxane Macromers with 7, 7, 8, 8-Tetracyanoquidimethane-Syntheses and Evaluation as an Oxygen Permeable Membrane Material", JAPANESE JOURNAL OF POLYMER SCIENCE AND TECHNOLOGY, SOCIETY OF POLYMER SCIENCE JP, JP, vol. 43, no. 11, 25 November 1986 (1986-11-25), pages 741 - 746, XP009540131, ISSN: 0386-2186, DOI: 10.1295/KORON.43.741
- KAWAKAMI, YUHSUKE; AOKI, TOSHIKI; YAMASHITA, YUYA: "Alternative Copolymers of Polydimethylsiloxane Macromers with 7, 7, 8, 8-Tetracyanoquidimethane-Syntheses and Evaluation as an Oxygen Permeable Membrane Material", JAPANESE JOURNAL OF POLYMER SCIENCE AND TECHNOLOGY, SOCIETY OF POLYMER SCIENCE JP, JP, vol. 43, no. 11, 25 November 1986 (1986-11-25), JP , pages 741 - 746, XP009540131, ISSN: 0386-2186, DOI: 10.1295/koron.43.741

## Description

### Technical Field

The present invention relates to a compound, a release agent composition, a laminate and a method for manufacturing a processed semiconductor substrate.

### Background Art

Conventionally, for a semiconductor wafer that has been integrated in a two-dimensional planar direction, a semiconductor integration technique of further integrating (laminating) a planar surface also in a three-dimensional direction for the purpose of further integration is required. This three-dimensional lamination is a technique of integrating layers into a multilayer while connecting wires with a through silicon via (TSV). When layers are integrated into a multilayer, each wafer to be integrated is thinned by polishing on a side opposite to a formed circuit surface (that is, a back surface), and the thinned semiconductor wafers are laminated.

A semiconductor wafer (here, also referred to simply as a wafer) before thinning is bonded to a support in order to be polished with a polishing apparatus. The bonding at this time is referred to as temporary bonding because the bonding needs to be easily released after polishing. This temporary bonding needs to be easily removed from the support, and when a large force is applied for the removal, the thinned semiconductor wafer may be cut or deformed. The semiconductor wafer is easily removed such that the cutting or deformation does not occur. However, when the back surface of the semiconductor wafer is polished, detachment or displacement of the semiconductor wafer due to a polishing stress is not preferable. Therefore, performance required for the temporary bonding is to withstand a stress at the time of polishing and to be easily removed after polishing.

For example, performance having a high stress (strong adhesive force) in a planar direction at the time of polishing and a low stress (weak adhesive force) in a longitudinal direction at the time of removal is required.

A method using laser irradiation has been disclosed for such bonding and separation processes (see, for example, Patent Literatures 1 and 2). However, with further progress in the recent semiconductor field, a new technique related to release by irradiation with light such as a laser is required all the time.

US 2018/223181 A1 describes a polymer obtained from siloxane monomers.

Kawakami Yuhsuke et al: "Alternative Copolymers of Polydimethylsiloxane Macromers with 7, 7, 8, 8-Tetracyanoquidimethane-Syntheses and Evaluation as an Oxygen Permeable Membrane Material", Japanese Journal of Polymer Science and Technology, Vol. 43, No. 11, pages 741-746 discloses high molecular weight alternative copolymers obtained by the copolymerization of ω-(4-vinylphenyl)polydimethylsiloxane macromers with 7,7,8,8-tetracyanoquinodi-methane.

US 2017/326850 A1 describes a production method of a laminate including a substrate and a light-transmitting support plate that are laminated each other via an adhesive layer and a release layer that is altered through absorption of light, the method including a release layer forming step of coating a reactive polysilsesquioxane on a surface of the support plate, the surface being opposed to the substrate, and heating the reactive polysilsesquioxane to perform polymerization, thereby forming the release layer.

### Citation List

### Patent Literature

Patent Literature 1: JP 2004-64040 A
Patent Literature 2: JP 2012 -106486 A

### Summary of Invention

### Technical Problem

The present invention has been made in view of the above circumstances, and an object of the present invention is to provide a laminate in which a support substrate and a semiconductor substrate can be easily separated from each other when the support substrate and the semiconductor substrate are separated from each other and in which a release layer after light irradiation can be dissolved in a cleaning agent composition when the semiconductor substrate is cleaned, a release agent composition that provides a film suitable as such a release layer, a method for manufacturing a processed semiconductor substrate using such a laminate, and a compound that can be suitably used for the release agent composition.

### Solution to Problem

As a result of intensive studies to solve the above problems, the present inventors have found that the above problems can be solved, and have completed the present invention having the following gist.

That is, the present invention includes the following.
[1] A compound having a styrylene structure represented by the following formula (1) as a first structure and a siloxane structure as a second structure, 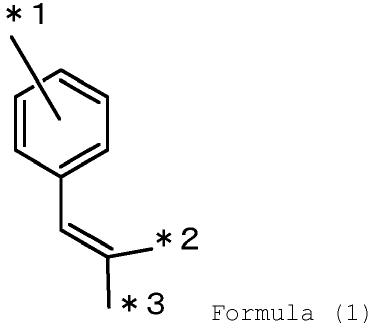
   wherein, in formula (1), *1 to *3 each independently represent a bond, and
      wherein the compound having a styrylene structure is selected from the group consisting of a compound having a structure represented by the following formula (2-1) and a repeating unit represented by the following formula (2-2), a compound having a repeating unit represented by the following formula (3-1) and a repeating unit represented by the following formula (3-2), a compound having a repeating unit represented by the following formula (4-1) and a repeating unit represented by the following formula (4-2), and a compound represented by the following formula (5), 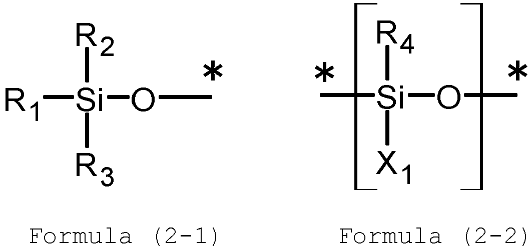
   wherein, in formula (2-1), R₁ to R₃ each independently represent a hydrogen atom, a hydroxy group, or a hydrocarbon group having 1 to 6 carbon atoms, and * represents a bond,
   wherein, in formula (2-2), R₄ represents a hydrogen atom, a hydroxy group, or a hydrocarbon group having 1 to 6 carbon atoms, X₁ represents a monovalent group having 9 to 30 carbon atoms and having a styrylene structure represented by the formula (1), and * represents a bond, 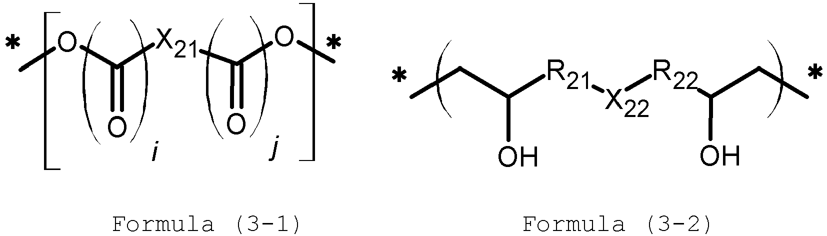
   wherein, in formula (3-1), X₂₁ represents a divalent group having 8 to 30 carbon atoms and having a styrylene structure represented by the formula (1), i and j each independently represent 0 or 1, and * represents a bond,
   wherein, in formula (3-2), X₂₂ represents a group represented by the following formula (B), R₂₁ and R₂₂ each independently represent a single bond or an alkylene group having 1 to 10 carbon atoms and * represents a bond, 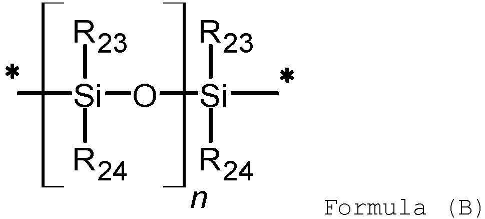
   wherein, in formula (B), R₂₃ and R₂₄ each independently represent a hydrogen atom, a hydroxy group, or a hydrocarbon group having 1 to 6 carbon atoms, n represents an integer of 0 or more, and * represents a bond, 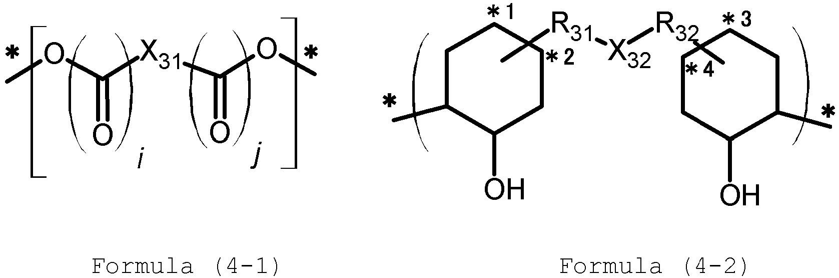
   wherein, in formula (4-1), X₃₁ represents a divalent group having 8 to 30 carbon atoms and having a styrylene structure represented by the formula (1), i and j each independently represent 0 or 1, and * represents a bond,
   wherein, in formula (4-2), X₃₂ represents a group represented by the formula (B), R₃₁ and R₃₂ each independently represent a single bond or an alkylene group having 1 to 10 carbon atoms, * represents a bond, R₃₁ is bonded to a *1 carbon atom or a *2 carbon atom, R₃₂ is bonded to a*3 carbon atom or a *4 carbon atom, and 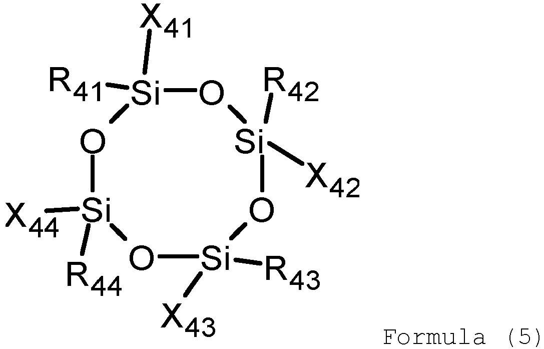
   wherein, in formula (5), R₄₁ to R₄₄ each independently represent a hydrogen atom, a hydroxy group, or a monovalent group having 1 to 30 carbon atoms, and X₄₁ to X₄₄ each independently represent a hydrogen atom, a hydroxy group, or a monovalent group having 1 to 30 carbon atoms, provided that at least one of X₄₁ to X₄₄ represents a monovalent group having 9 to 30 carbon atoms and having a styrylene structure represented by the formula (1), and, when two or more of X₄₁ to X₄₄ are monovalent groups each having 9 to 30 carbon atoms and each having a styrylene structure represented by the formula (1), they may be the same or different.
[2] A release agent composition comprising a compound as defined in [1].
[3] A laminate including:
   a semiconductor substrate;
   a light-transmissive support substrate; and
   an adhesive layer and a release layer disposed between the semiconductor substrate and the support substrate,
   the laminate being used for releasing the semiconductor substrate and the support substrate after the release layer absorbs light emitted from the support substrate side, in which
   the release layer is formed of a release agent composition as defined in [2].
[4] A method for manufacturing a processed semiconductor substrate, the method including:
   a first step of processing the semiconductor substrate of the laminate according to [3];
   a second step of separating the semiconductor substrate processed in the first step and the support substrate from each other; and
   a third step of cleaning the separated semiconductor substrate with a cleaning agent composition.

### Advantageous Effects of Invention

The present invention can provide a laminate in which a support substrate and a semiconductor substrate can be easily separated from each other when the support substrate and the semiconductor substrate are separated from each other and in which a release layer after light irradiation can be dissolved in a cleaning agent composition when the semiconductor substrate is cleaned, a release agent composition that provides a film suitable as such a release layer, a method for manufacturing a processed semiconductor substrate using such a laminate, and a compound that can be suitably used for the release agent composition.

### Brief Description of Drawings

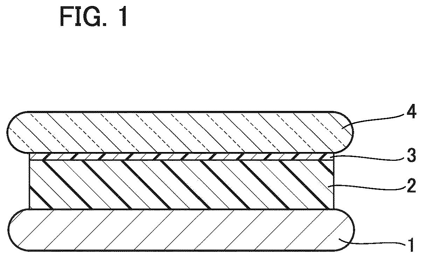

Fig. 1 is a schematic cross-sectional view of an example of a laminate.

### Description of Embodiments

### (Laminate)

A laminate of the present invention includes a semiconductor substrate, a support substrate, an adhesive layer, and a release layer.

The support substrate is light-transmissive.

The adhesive layer and the release layer are disposed between the semiconductor substrate and the support substrate.

The laminate is used for releasing the semiconductor substrate and the support substrate after the release layer absorbs light emitted from the support substrate side.

The release layer is formed of a release agent composition.

The release agent composition contains a compound having a first structure and a second structure. The first structure absorbs light and contributes to facilitating the semiconductor substrate and the support substrate to be released by absorbing the light. The second structure is a siloxane structure.

The laminate of the present invention can be suitably used for processing such as thinning of a semiconductor substrate.

In the laminate of the present invention, the semiconductor substrate is supported by the support substrate via the adhesive layer and the release layer while the semiconductor substrate is subjected to processing such as thinning.

Meanwhile, since the compound contained in the release agent composition for forming the release layer has the first structure, in the release layer formed of the release agent composition, the first structure absorbs light (for example, laser light) to alter (for example, separate or decompose) the release layer. As a result, after the release layer is irradiated with light, the semiconductor substrate and the support substrate are easily released. Furthermore, since the compound contained in the release agent composition for forming the release layer has the second structure, the release layer after light irradiation exhibits favorable solubility with respect to a cleaning agent composition described later. In a case where the release layer after light irradiation is soluble with respect to the cleaning agent composition, for example, even when a residue of the release layer remains on the semiconductor substrate side when the support substrate and the semiconductor substrate are separated from each other, the residue can be easily removed by cleaning with the cleaning agent composition.

A wavelength of the light used for release is not particularly limited as long as the light is absorbed by the first structure, but is usually light in a range of 100 to 600 nm, and for example, a suitable wavelength is 308 nm, 343 nm, 355 nm, or 365 nm. An irradiation amount of the light necessary for release is an irradiation amount that can cause suitable alteration of the first structure, for example, decomposition.

The light used for release may be laser light or nonlaser light emitted from a light source such as a lamp.

### <Semiconductor substrate>

A main material constituting the entire semiconductor substrate is not particularly limited as long as it is used for this type of application, but examples thereof include silicon, silicon carbide, and a compound semiconductor.

The shape of the semiconductor substrate is not particularly limited, but is, for example, a disk shape. Note that the disk-shaped semiconductor substrate does not need to have a completely circular surface, and for example, an outer periphery of the semiconductor substrate may have a straight portion called an orientation flat or may have a cut portion called a notch.

The thickness of the disk-shaped semiconductor substrate only needs to be appropriately determined depending on a purpose of use of the semiconductor substrate and the like, and is not particularly limited, but is, for example, 500 to 1,000 µm.

The diameter of the disk-shaped semiconductor substrate only needs to be appropriately determined depending on a purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to a surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from conditions that a bump height is about 1 to 200 µm, a bump radius is 1 to 200 µm, and a bump pitch is 1 to 500 µm.

Examples of the material of the bump include low melting point solder, high melting point solder, tin, indium, gold, silver, and copper. The bump may contain only a single component or may contain a plurality of components. More specific examples thereof include alloy plating mainly containing Sn, such as a SnAg bump, a SnBi bump, a Sn bump, or a AuSn bump.

In addition, the bump may have a laminated structure including a metal layer containing at least one of these components.

An example of the semiconductor substrate is a silicon wafer having a diameter of about 300 mm and a thickness of about 770 µm.

### <Support substrate>

The support substrate is not particularly limited as long as it is a member that is light transmissive to light emitted to the release layer and can support the semiconductor substrate when the semiconductor substrate is processed, but examples thereof include a glass support substrate.

The shape of the support substrate is not particularly limited, but examples thereof include a disk shape.

The thickness of the disk-shaped support substrate only needs to be appropriately determined depending on the size of the semiconductor substrate and the like, and is not particularly limited, but is, for example, 500 to 1,000 µm.

The diameter of the disk-shaped support substrate only needs to be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 µm.

### <Release layer>

The release layer is formed of a release agent composition.

The release layer is disposed between the semiconductor substrate and the support substrate.

The release layer may be in contact with the support substrate or may be in contact with the semiconductor substrate.

A method for forming the release layer from the release agent composition is not particularly limited, and examples thereof include a forming method described later.

### <<Release agent composition>>

The release agent composition contains at least a compound having a first structure and a second structure (hereinafter, also referred to as a "specific compound"), and further contains, as necessary, other components such as a crosslinking agent, an acid generator, an acid, a surfactant, and a solvent.

### <<<Compound having first structure and second structure>>>

The specific compound contained in the release agent composition has a first structure and a second structure.

The first structure absorbs light and contributes to facilitating the semiconductor substrate and the support substrate to be released by absorbing the light.

The second structure is a siloxane structure.

### -First structure-

The first structure absorbs light and contributes to facilitating the semiconductor substrate and the support substrate to be released by absorbing the light. The first structure absorbs light and alters to alter the release layer. As a result, after the release layer is irradiated with light, the semiconductor substrate and the support substrate are easily released.

The first structure has a styrylene structure represented by the following formula (1) from a viewpoint of being excellent in absorbing an ultraviolet ray (for example, 308 nm, 343 nm, or 355 nm). 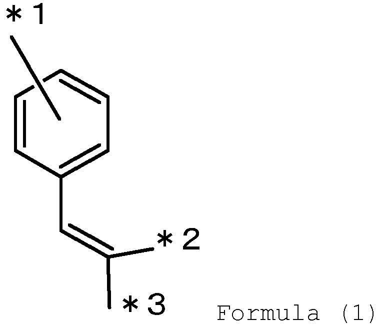 (In formula (1), *1 to *3 each represent a bond.)

The *1 bond to the *3 bond may be each bonded to a hydrogen atom or may be each bonded to an atom other than the hydrogen atom.

An atom bonded to each of the *1 bond to the *3 bond is not particularly limited, but examples thereof include a hydrogen atom, a halogen atom, a carbon atom, a nitrogen atom, and an oxygen atom.

A group bonded to each of the *1 bond to the *3 bond is not particularly limited, but examples thereof include a hydroxy group, a carbonyl group, an alkyl group, an alkoxy group, a nitro group, and a cyano group.

### -Second structure-

The second structure is a siloxane structure.

Examples of the siloxane structure include a dialkylsiloxane skeleton represented by -Si(Rₓ₁Rₓ₂)₂-O-(Rₓ₁ and Rₓ₂ each independently represent an alkyl group having 1 to 4 carbon atoms.) and a diphenylsiloxane skeleton represented by -Si(C₆H₅)₂-O-. Provided that an oxygen atom bonded to a silicon atom in these siloxane skeletons is bonded to a silicon atom of another siloxane skeleton.

The specific compound may have a siloxane skeleton represented by -Si(Rₓ₃Rₓ₄)₂-O-(Rₓ₃ represents an alkyl group having 1 to 4 carbon atoms, and Rₓ₄ represents a divalent group linked to the first structure.) as the siloxane structure. Provided that an oxygen atom bonded to a silicon atom in the siloxane skeleton is bonded to a silicon atom of another siloxane skeleton. The number of carbon atoms in the divalent group linked to the first structure is not particularly limited, but examples thereof include 1 to 50 carbon atoms.

The alkyl group having 1 to 4 carbon atoms for Rₓ₁, Rₓ₂, and Rₓ₃ is preferably a methyl group.

The specific compound is selected from the group consisting of the following compounds.
· A compound having a structure represented by the following formula (2-1) and a repeating unit represented by the following formula (2-2) (hereinafter, also referred to as a compound (2))
· A compound having a repeating unit represented by the following formula (3-1) and a repeating unit represented by the following formula (3-2) (hereinafter, also referred to as a compound (3))
· A compound having a repeating unit represented by the following formula (4-1) and a repeating unit represented by the following formula (4-2) (hereinafter, also referred to as a compound (4))
· A compound represented by the following formula (5) 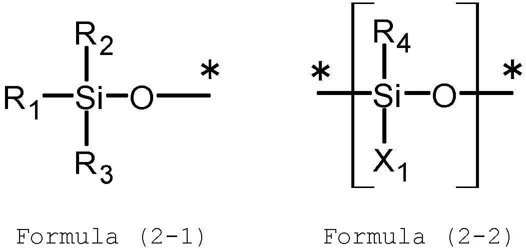 (In formula (2-1), R₁ to R₃ each independently represent a hydrogen atom, a hydroxy group, or a hydrocarbon group having 1 to 6 carbon atoms. * represents a bond.

In formula (2-2), R₄ represents a hydrogen atom, a hydroxy group, or a hydrocarbon group having 1 to 6 carbon atoms. X₁ represents a monovalent group having 9 to 30 carbon atoms and having a styrylene structure represented by formula (1). * represents a bond.)

Examples of the hydrocarbon group having 1 to 6 carbon atoms in R₁ to R₄ include a methyl group, an ethyl group, a propyl group, a butyl group, a pentyl group, a hexyl group, and a phenyl group. Among these groups, a methyl group is preferable.

X₁ is, for example, a monovalent group represented by any one of the following formulas (A-1) to (A-4). 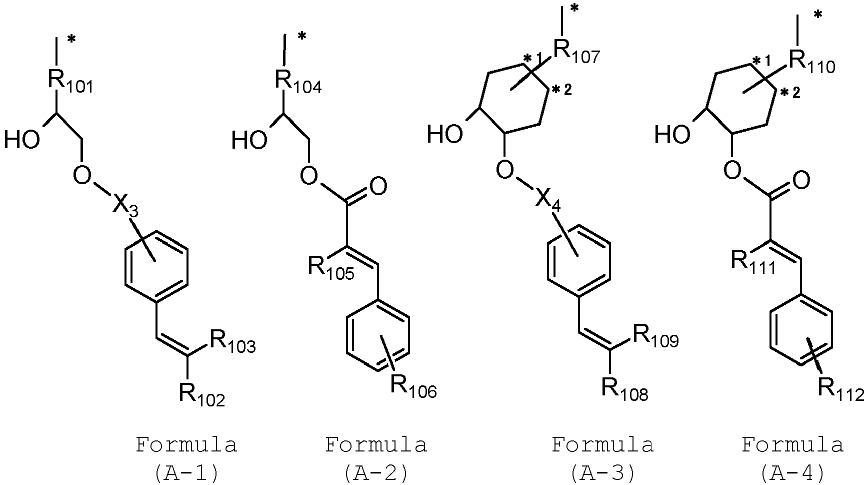 (In formula (A-1), R₁₀₁ represents a single bond or an alkylene group having 1 to 10 carbon atoms. X₃ represents a single bond or -CO-. R₁₀₂ and R₁₀₃ each independently represent a hydrogen atom or a cyano group. * represents a bond to Si in formula (2-2).

In formula (A-2), R₁₀₄ represents a single bond or an alkylene group having 1 to 10 carbon atoms. R₁₀₅ represents a hydrogen atom or a cyano group. R₁₀₆ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms. * represents a bond to Si in formula (2-2).

In formula (A-3), R₁₀₇ represents a single bond or an alkylene group having 1 to 10 carbon atoms. X₄ represents a single bond or -CO-. R₁₀₈ and R₁₀₉ each independently represent a hydrogen atom or a cyano group. * represents a bond to Si in formula (2-2). R₁₀₇ is bonded to a *1 carbon atom or a *2 carbon atom.

In formula (A-4), R₁₁₀ represents a single bond or an alkylene group having 1 to 10 carbon atoms. R₁₁₁ represents a hydrogen atom or a cyano group. R₁₁₂ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms. * represents a bond to Si in formula (2-2). R₁₁₀ is bonded to a *1 carbon atom or a *2 carbon atom.)

Examples of the alkylene group having 1 to 10 carbon atoms in R₁₀₁, R₁₀₄, R₁₀₇, and R₁₁₀ include a methylene group, an ethylene group, a propylene group (trimethylene group), and a butylene group (tetramethylene group).

Examples of the alkyl group having 1 to 10 carbon atoms in R₁₀₆ and R₁₁₂ include a methyl group, an ethyl group, a propyl group, a butyl group, a pentyl group, and a hexyl group.

Examples of the alkoxy group having 1 to 10 carbon atoms in R₁₀₆ and R₁₁₂ include a methoxy group, an ethoxy group, a propoxy group, a butoxy group, a pentyloxy group, and a hexyloxy group.

Examples of the halogenated alkyl group having 1 to 10 carbon atoms in R₁₀₆ and R₁₁₂ include a group in which at least one hydrogen atom in an alkyl group having 1 to 10 carbon atoms is replaced with a halogen atom, and examples thereof include a trifluoromethyl group, a 2,2,2-trifluoroethyl group, a 1,1,2,2,2-pentafluoroethyl group, a 3,3,3-trifluoropropyl group, a 2,2,3,3,3-pentafluoropropyl group, a 1,1,2,2,3,3,3-heptafluoropropyl group, a 4,4,4-trifluorobutyl group, a 3,3,4,4,4-pentafluorobutyl group, a 2,2,3,3,4,4,4-heptafluorobutyl group, and a 1,1,2,2,3,3,4,4,4-nonafluorobutyl group.

Examples of the halogenated alkoxy group having 1 to 10 carbon atoms in R₁₀₆ and R₁₁₂ include a group in which at least one hydrogen atom in an alkoxy group having 1 to 10 carbon atoms is replaced with a halogen atom.

Examples of the halogen atom in R₁₀₆ and R₁₁₂ include a fluorine atom, a chlorine atom, a bromine atom, and an iodine atom.

The compound having a structure represented by formula (2-1) and a repeating unit represented by formula (2-2) may further have another repeating unit. Examples of the other repeating unit include a repeating unit represented by the following formula (2-3) and a repeating unit represented by the following formula (2-4). 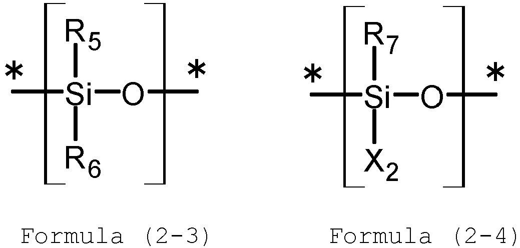 (In formula (2-3), R₅ and R₆ each independently represent a hydrogen atom, a hydroxy group, or a hydrocarbon group having 1 to 6 carbon atoms. * represents a bond.

In formula (2-4), R₇ represents a hydrogen atom, a hydroxy group, or a hydrocarbon group having 1 to 6 carbon atoms. X₂ represents a hydrogen atom, a hydroxy group, or a monovalent group having 1 to 30 carbon atoms (Provided that a hydrocarbon group having 1 to 6 carbon atoms, and a monovalent group having 9 to 30 carbon atoms and having a styrylene structure represented by formula (1) are excluded.). * represents a bond.)

Examples of the hydrocarbon group having 1 to 6 carbon atoms in R₅ to R₇ include a methyl group, an ethyl group, a propyl group, a butyl group, a pentyl group, a hexyl group, and a phenyl group. Among these groups, a methyl group is preferable.

The monovalent group having 1 to 30 carbon atoms in X₂ is, for example, a monovalent group represented by any one of the following (i) to (iv) (Note that a monovalent group having 9 to 30 carbon atoms and having a styrylene structure represented by formula (1) is excluded.).
(i) Hydrocarbon group having 7 to 30 carbon atoms
(ii) Monovalent hydrocarbon group having 2 to 30 carbon atoms, in which at least one of an ether bond, a thioether bond, an amide bond, a urethane bond, and an ester bond is inserted between a carbon-carbon bond of the hydrocarbon group
(iii) Monovalent hydrocarbon group having 1 to 30 carbon atoms, in which at least one hydrogen atom in the hydrocarbon group is replaced with a halogen atom, a hydroxy group, a nitro group, or a cyano group
(iv) Monovalent hydrocarbon group having 2 to 30 carbon atoms, in which at least one of an ether bond, a thioether bond, an amide bond, a urethane bond, and an ester bond is inserted between a carbon-carbon bond of the hydrocarbon group, and at least one hydrogen atom in the hydrocarbon group is replaced with a halogen atom, a hydroxy group, a nitro group, or a cyano group

Note that the "1 to 30 carbon atoms" in the "monovalent group having 1 to 30 carbon atoms" do not include carbon atoms in a cyano group, an amide bond, a urethane bond, and an ester bond.

In compound (2), the total of a structure represented by formula (2-1), a repeating unit represented by formula (2-2), a repeating unit represented by formula (2-3), and a repeating unit represented by formula (2-4) is preferably 80 to 100% by mass and more preferably 90 to 100% by mass of compound (2). In this case, a ratio of the repeating unit represented by formula (2-3) in compound (2) may be 0% by mass. A ratio of the repeating unit represented by formula (2-4) in compound (2) may be 0% by mass. 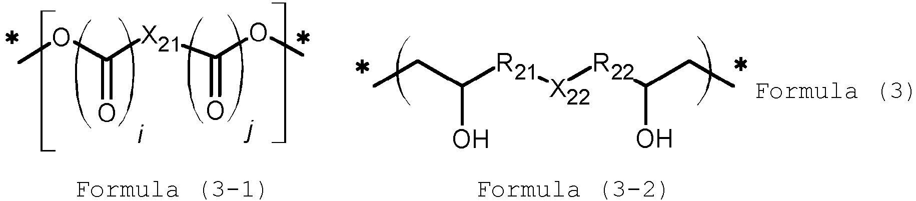 (In formula (3-1), X₂₁ represents a divalent group having 8 to 30 carbon atoms and having a styrylene structure represented by formula (1). i and j each independently represent 0 or 1. * represents a bond.

In formula (3-2), X₂₂ represents a group represented by the following formula (B). R₂₁ and R₂₂ each independently represent a single bond or an alkylene group having 1 to 10 carbon atoms. * represents a bond.) 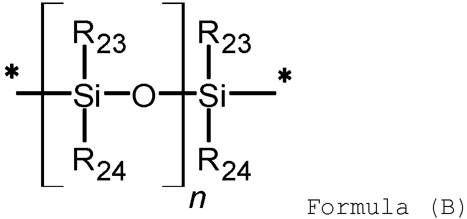 (In formula (B), R₂₃ and R₂₄ each independently represent a hydrogen atom, a hydroxy group, or a hydrocarbon group having 1 to 6 carbon atoms. n represents an integer of 0 or more. * represents a bond.)

Examples of the alkylene group having 1 to 10 carbon atoms in R₂₁ and R₂₂ include a methylene group, an ethylene group, a propylene group (trimethylene group), and a butylene group (tetramethylene group).

Examples of the hydrocarbon group having 1 to 6 carbon atoms in R₂₃ and R₂₄ include a methyl group, an ethyl group, a propyl group, a butyl group, a pentyl group, a hexyl group, and a phenyl group. Among these groups, a methyl group is preferable.

In compound (3), the total of a repeating unit represented by formula (3-1) and a repeating unit represented by formula (3-2) is preferably 80 to 100% by mass and more preferably 90 to 100% by mass of compound (3). 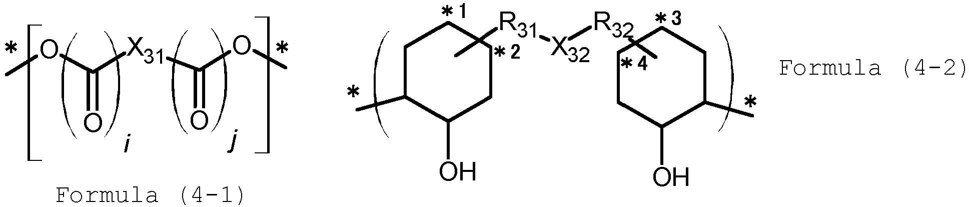 (In formula (4-1), X₃₁ represents a divalent group having 8 to 30 carbon atoms and having a styrylene structure represented by formula (1). i and j each independently represent 0 or 1. * represents a bond.

In formula (4-2), X₃₂ represents a group represented by formula (B). R₃₁ and R₃₂ each independently represent a single bond or an alkylene group having 1 to 10 carbon atoms. * represents a bond. R₃₁ is bonded to a *1 carbon atom or a *2 carbon atom. R₃₂ is bonded to a *3 carbon atom or a *4 carbon atom.)

Examples of the alkylene group having 1 to 10 carbon atoms in R₃₁ and R₃₂ include a methylene group, an ethylene group, a propylene group (trimethylene group), and a butylene group (tetramethylene group).

Examples of the divalent group having 8 to 30 carbon atoms and having a styrylene structure represented by formula (1) in X₂₁ and X₃₁ include a divalent group represented by the following formula (C). 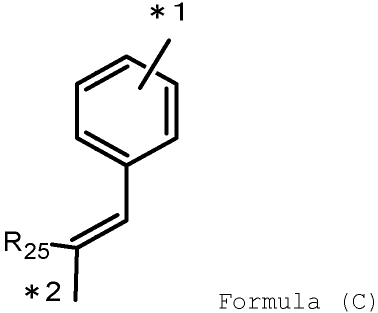 (In formula (C), R₂₅ represents a hydrogen atom or a cyano group. *1 and *2 each represent a bond.)

In compound (4), the total of a repeating unit represented by formula (4-1) and a repeating unit represented by formula (4-2) is preferably 80 to 100% by mass and more preferably 90 to 100% by mass of compound (4) . 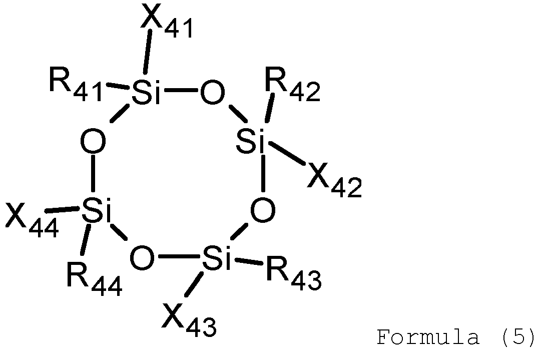 (In formula (5), R₄₁ to R₄₄ each independently represent a hydrogen atom, a hydroxy group, or a monovalent group having 1 to 30 carbon atoms. X₄₁ to X₄₄ each independently represent a hydrogen atom, a hydroxy group, or a monovalent group having 1 to 30 carbon atoms. Provided that at least one of X₄₁ to X₄₄ represents a monovalent group having 9 to 30 carbon atoms and having a styrylene structure represented by formula (1). Note that when two or more of X₄₁ to X₄₄ are monovalent groups each having 9 to 30 carbon atoms and each having a styrylene structure represented by formula (1), they may be the same or different.)

The monovalent group having 9 to 30 carbon atoms and having a styrylene structure represented by formula (1) is, for example, a group represented by either one of the following formulas (D-1) and (D-2). 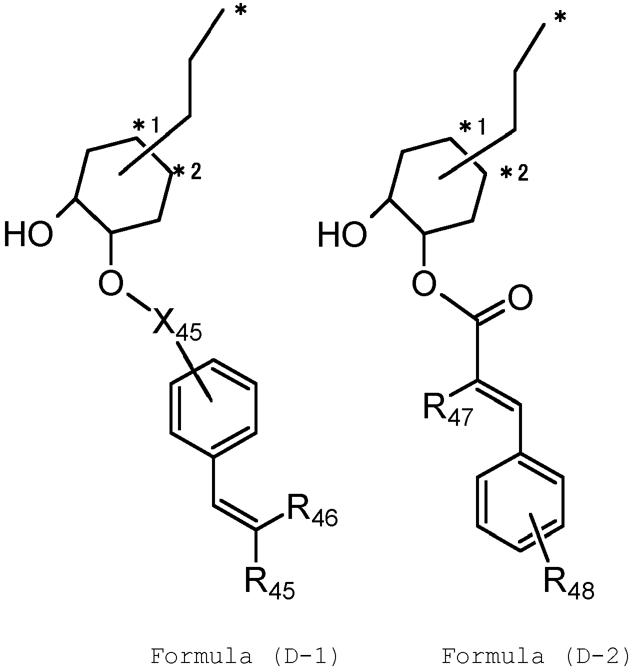 (In formula (D-1), X₄₅ represents a single bond or - CO-. R₄₅ and R₄₆ each independently represent a hydrogen atom or a cyano group. * represents a bond to Si in formula (5). An ethylene group bonded to Si is bonded to a *1 carbon atom or a *2 carbon atom of a cyclohexane ring. In formula (D-2), R₄₇ represents a hydrogen atom or a cyano group. R₄₈ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms. * represents a bond to Si in formula (5). An ethylene group bonded to Si is bonded to a *1 carbon atom or a *2 carbon atom of a cyclohexane ring.)

The monovalent group having 1 to 30 carbon atoms in R₄₁ to R₄₄ and X₄₁ to X₄₄ is, for example, a monovalent group represented by any one of the following (i) to (iv).
(i) Hydrocarbon group having 1 to 30 carbon atoms
(ii) Monovalent hydrocarbon group having 2 to 30 carbon atoms, in which at least one of an ether bond, a thioether bond, an amide bond, a urethane bond, and an ester bond is inserted between a carbon-carbon bond of the hydrocarbon group
(iii) Monovalent hydrocarbon group having 1 to 30 carbon atoms, in which at least one hydrogen atom in the hydrocarbon group is replaced with a halogen atom, a hydroxy group, a nitro group, or a cyano group
(iv) Monovalent hydrocarbon group having 2 to 30 carbon atoms, in which at least one of an ether bond, a thioether bond, an amide bond, a urethane bond, and an ester bond is inserted between a carbon-carbon bond of the hydrocarbon group, and at least one hydrogen atom in the hydrocarbon group is replaced with a halogen atom, a hydroxy group, a nitro group, or a cyano group

Note that the "1 to 30 carbon atoms" in the "monovalent group having 1 to 30 carbon atoms" do not include carbon atoms in a cyano group, an amide bond, a urethane bond, and an ester bond.

The monovalent group having 1 to 30 carbon atoms in R₄₁ to R₄₄ is preferably a hydrocarbon group having 1 to 6 carbon atoms, and more preferably a methyl group.

Examples of the alkyl group having 1 to 10 carbon atoms in R₄₈ include a methyl group, an ethyl group, a propyl group, a butyl group, a pentyl group, and a hexyl group.

Examples of the alkoxy group having 1 to 10 carbon atoms in R₄₈ include a methoxy group, an ethoxy group, a propoxy group, a butoxy group, a pentyloxy group, and a hexyloxy group.

Examples of the halogenated alkyl group having 1 to 10 carbon atoms in R₄₈ include a group in which at least one hydrogen atom in an alkyl group having 1 to 10 carbon atoms is replaced with a halogen atom, and examples thereof include a trifluoromethyl group, a 2,2,2-trifluoroethyl group, a 1,1,2,2,2-pentafluoroethyl group, a 3,3,3-trifluoropropyl group, a 2,2,3,3,3-pentafluoropropyl group, a 1,1,2,2,3,3,3-heptafluoropropyl group, a 4,4,4-trifluorobutyl group, a 3,3,4,4,4-pentafluorobutyl group, a 2,2,3,3,4,4,4-heptafluorobutyl group, and a 1,1,2,2,3,3,4,4,4-nonafluorobutyl group.

Examples of the halogenated alkoxy group having 1 to 10 carbon atoms in R₄₈ include a group in which at least one hydrogen atom in an alkoxy group having 1 to 10 carbon atoms is replaced with a halogen atom.

Examples of the halogen atom in R₄₈ include a fluorine atom, a chlorine atom, a bromine atom, and an iodine atom.

In formula (5), two or four of X₄₁ to X₄₄ are preferably monovalent groups each having 9 to 30 carbon atoms and each having a styrylene structure represented by formula (1).

Note that the alkyl group and the alkylene group in the present specification may each have any structure unless otherwise specified, and for example, may be linear, branched, or cyclic.

Examples of the specific compound will be described below. 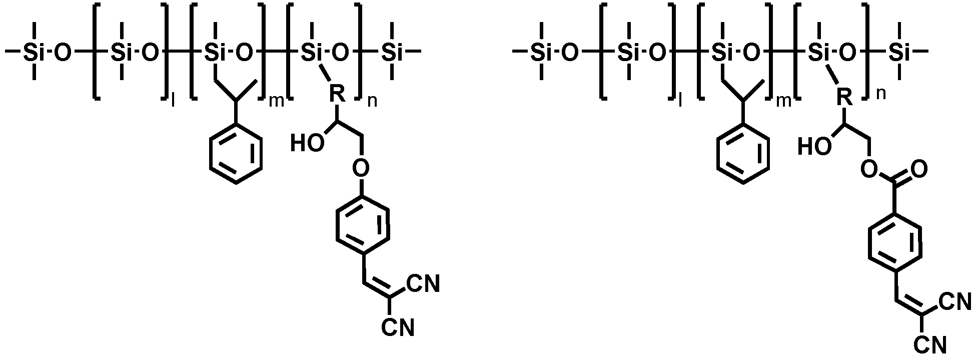 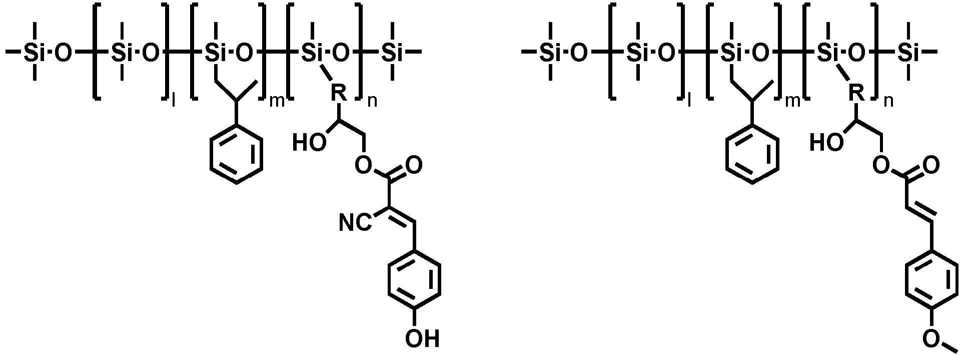 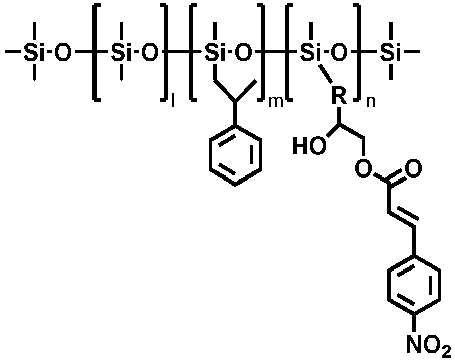 in which, l, m, and n each represent an integer of 1 or more. R represents a single bond or an alkylene group having 1 to 10 carbon atoms. 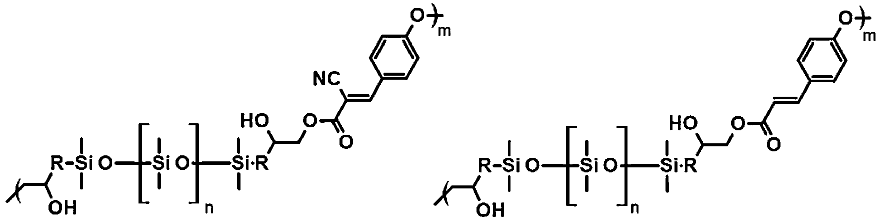 in which, m and n each represent an integer of 1 or more. R represents a single bond or an alkylene group having 1 to 10 carbon atoms.

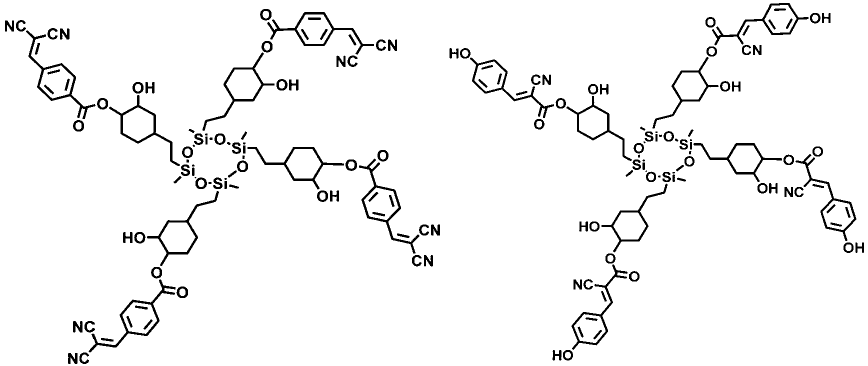

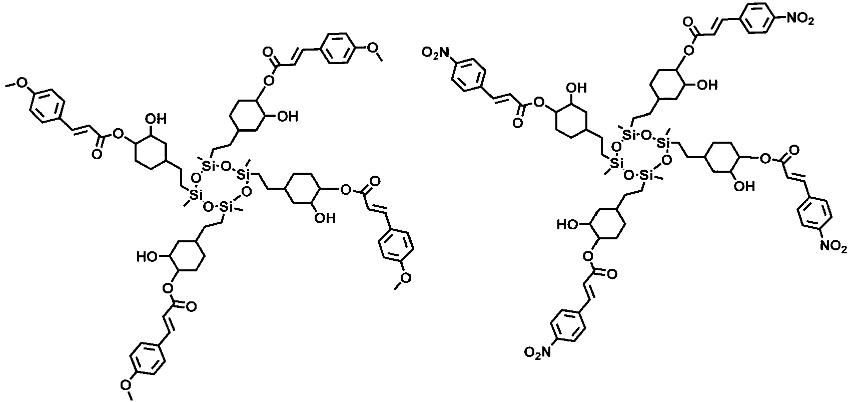

A weight average molecular weight of the specific compound is not particularly limited, but is usually 400 to 100,000, an upper limit thereof is preferably 50,000 and more preferably 30,000 from a viewpoint of suppressing precipitation of a polymer, preparing a release agent composition excellent in storage stability with good reproducibility, or the like, and a lower limit thereof is preferably 500 and more preferably 1,000 from a viewpoint of preparing a release agent composition that provides a release layer excellent in heat resistance with good reproducibility or the like.

The weight average molecular weight of the specific compound can be measured, for example, by the following method.

The weight average molecular weight of the specific compound is measured using a GPC apparatus (HLC-8320GPC manufactured by Tosoh Corporation) and GPC columns (Asahipak [registered trademark] GF-310HQ, GF-510HQ, and GF-710HQ), at a column temperature of 40°C, using dimethylformamide (DMF) as an eluent (elution solvent), at a flow rate of 0.6 mL/min, and using polystyrene (Shodex manufactured by Showa Denko K.K.) as a standard sample.

The amount of the specific compound contained in the release agent composition varies depending on an application method to be adopted, a desired film thickness, and the like, and thus cannot be generally specified, but is usually 1 to 100% by mass with respect to film constituent components, and is preferably 20% by mass or more, more preferably 30% by mass or more, still more preferably 40% by mass or more, and further still more preferably 50% by mass or more from a viewpoint of obtaining a laminate in which a semiconductor substrate and a support substrate can be favorably separated from each other with good reproducibility. Note that, in the present invention, the film constituent components mean components other than a solvent contained in the composition.

The specific compound can be obtained, for example, by bonding a compound having an epoxy group and a siloxane structure and a compound having a styrylene structure represented by formula (1) directly or via another compound using a ring-opening reaction of the epoxy group.

Examples of the usable compound having an epoxy group and a siloxane structure include product numbers KF-1005, X-22-343, KF-101, KF-1001, X-22-2000, X-22-2046, KF-102, X-22-163, KF-105, X-22-163A, X-22-163B, X-22-163C, KR-470, and X-40-2678 manufactured by Shin-Etsu Chemical Co., Ltd.

### <<<Crosslinking agent>>>

The release agent composition may contain a crosslinking agent. When the crosslinking agent is contained, crosslinking between molecules of the specific compound suitably proceeds, and suitable curing can be achieved. As a result, a film that cannot be suitably removed with an organic solvent, an acid, and a chemical solution (an alkali developer, hydrogen peroxide water, or the like) used in manufacture of a semiconductor element but can be suitably removed with a cleaning agent composition can be obtained with good reproducibility.

Specific examples of such a crosslinking agent are not particularly limited, but typically include a phenol-based crosslinking agent, a melamine-based crosslinking agent, a urea-based crosslinking agent, and a thiourea-based crosslinking agent each having a crosslinking forming group such as a hydroxymethyl group and an alkoxymethyl group such as a methoxymethyl group, or a butoxymethyl group in a molecule, and these may be low molecular weight compounds or polymer compounds.

The crosslinking agent contained in the release agent composition usually has two or more crosslinking forming groups, but the number of crosslinking forming groups contained in a compound as the crosslinking agent is preferably 2 to 10, and more preferably 2 to 6 from a viewpoint of achieving more suitable curing with good reproducibility.

The crosslinking agent contained in the release agent composition preferably has an aromatic ring (for example, a benzene ring or a naphthalene ring) in a molecule from a viewpoint of achieving higher heat resistance, and typical examples of such a crosslinking agent include, but are not limited to, a phenol-based crosslinking agent.

The phenol-based crosslinking agent having a crosslinking forming group is a compound having a crosslinking forming group bonded to an aromatic ring and having at least one of a phenolic hydroxy group and an alkoxy group derived from a phenolic hydroxy group, and examples of such an alkoxy group derived from a phenolic hydroxy group include a methoxy group and a butoxy group, but are not limited thereto.

The aromatic ring to which the crosslinking forming group is bonded and the aromatic ring to which a phenolic hydroxy group and/or an alkoxy group derived from a phenolic hydroxy group are/is bonded are not limited to a non-condensed aromatic ring such as a benzene ring, and may be a condensed aromatic ring such as a naphthalene ring or anthracene.

When a plurality of aromatic rings is present in a molecule of the phenol-based crosslinking agent, the crosslinking forming group, the phenolic hydroxy group, and the alkoxy group derived from a phenolic hydroxy group may be bonded to the same aromatic ring in the molecule or may be bonded to different aromatic rings.

The aromatic ring to which the crosslinking forming group, the phenolic hydroxy group, or the alkoxy group derived from a phenolic hydroxy group is bonded may further have a substituent of an alkyl group such as a methyl group, an ethyl group, or a butyl group, a hydrocarbon group such as an aryl group such as a phenyl group, a halogen atom such as a fluorine atom, or the like.

Specifically, the phenol-based crosslinking agent having the crosslinking forming group is, for example, a compound represented by any one of formulas (L1) to (L4).

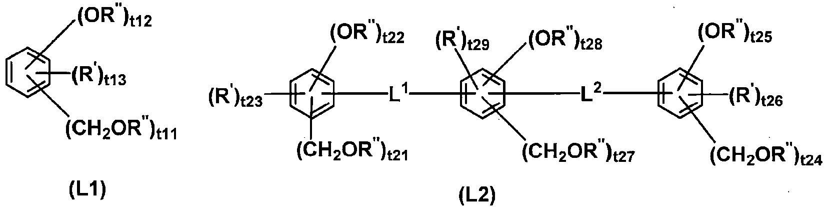

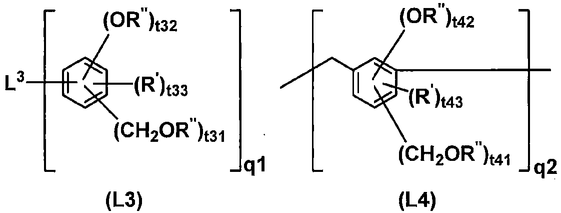

in which R's each independently represent a fluorine atom, an aryl group, or an alkyl group, R"s each independently represent a hydrogen atom or an alkyl group, L¹ and L² each independently represent a single bond, a methylene group, or a propane-2,2-diyl group, L³ is determined depending on q1 and represents a single bond, a methylene group, a propane-2,2-diyl group, a methantriyl group, or an ethane-1,1,1-triyl group, t11, t12, and t13 are integers satisfying 2 ≤ t11 ≤ 5, 1 ≤ t12 ≤ 4, 0 ≤ t13 ≤ 3, and t11 + t12 + t13 ≤ 6, t21, t22, and t23 are integers satisfying 2 ≤ t21 ≤ 4, 1 ≤ t22 ≤ 3, 0 ≤ t23≤ 2, and t21 + t22 + t23 ≤ 5, t24, t25, and t26 are integers satisfying 2 ≤ t24 ≤ 4, 1 ≤ t25 ≤ 3, 0 ≤ t26 ≤ 2, and t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, specific examples of the aryl group and the alkyl group include those same as the following specific examples, but the aryl group is preferably a phenyl group, and the alkyl group is preferably a methyl group or a t-butyl group.

Specific examples of the compounds represented by formulas (L1) to (L4) are described below, but the compounds are not limited thereto. Note that these compounds may be synthesized by a known method, and can also be obtained, for example, as products of Asahi Yukizai Corporation or Honshu Chemical Industry Co., Ltd.

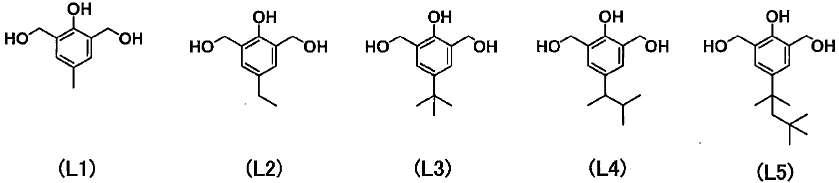

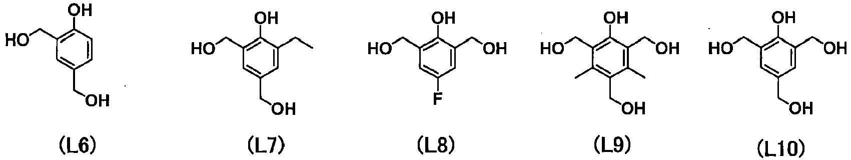

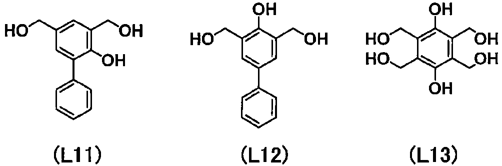

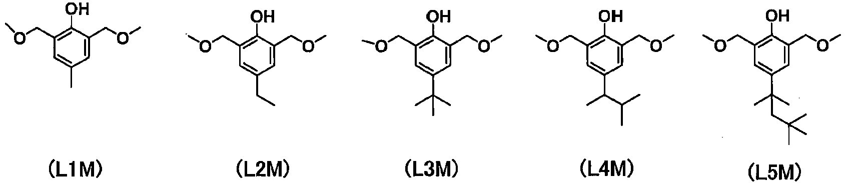

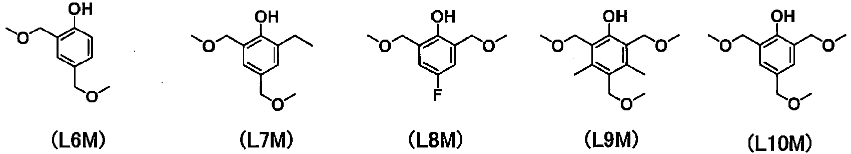

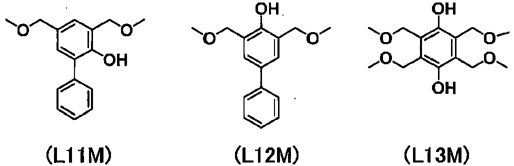

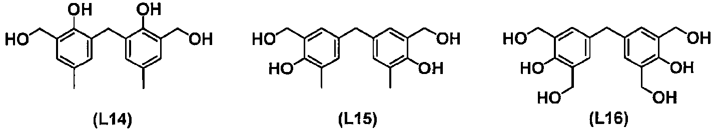

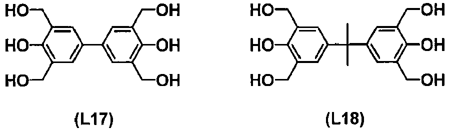

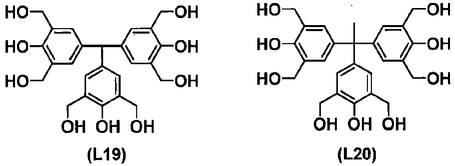

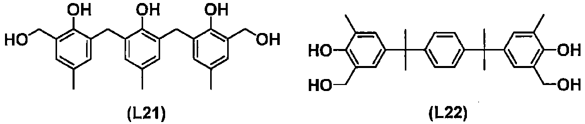

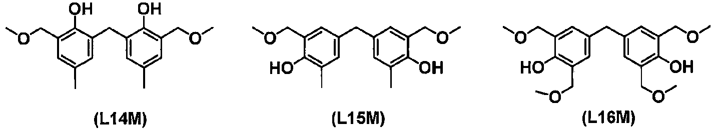

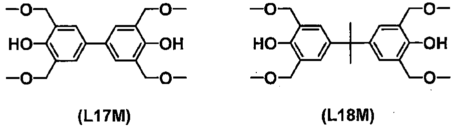

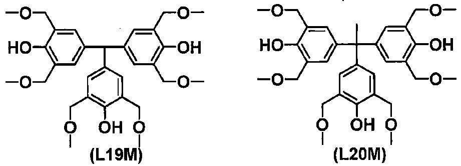

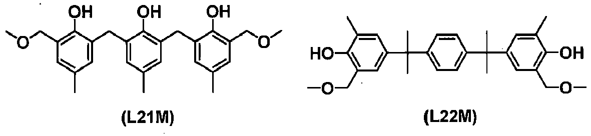

The melamine-based crosslinking agent having a crosslinking forming group is a melamine derivative, a 2,4-diamino-1,3,5-triazine derivative, or a 2-amino-1,3,5-triazine derivative in which at least one of hydrogen atoms of an amino group bonded to a triazine ring thereof is replaced with a crosslinking forming group, and the triazine ring may further have a substituent such as an aryl group such as a phenyl group.

Specific examples of the melamine-based crosslinking agent having a crosslinking forming group include: a mono-, bis-, tris-, tetrakis-, pentakis-, or hexakisalkoxymethylmelamine such as N,N,N',N',N",N"-hexakis(methoxymethyl) melamine or N,N,N',N',N",N"-hexakis(butoxymethyl) melamine; and a mono-, bis-, tris-, or tetrakis- alkoxymethylbenzoguanamine such as N,N,N',N'-tetrakis(methoxymethyl) benzoguanamine or N,N,N',N'-tetrakis(butoxymethyl) benzoguanamine, but are not limited thereto.

The urea-based crosslinking agent having a crosslinking forming group is a derivative of a urea bond-containing compound, and has a structure in which at least one of hydrogen atoms of an NH group constituting a urea bond is replaced with a crosslinking forming group.

Specific examples of the urea-based crosslinking agent having a crosslinking forming group include: a mono-, bis-, tris-, or tetrakis- alkoxymethylglycoluril such as 1,3,4,6- (methoxymethyl) glycoluril or 1,3,4,6-tetrakis(butoxymethyl) glycoluril; and mono-, bis-, tris-, or tetrakis- alkoxymethylurea such as 1,3-bis(methoxymethyl) urea or 1,1,3,3-tetrakismethoxymethylurea, but are not limited thereto.

The thiourea-based crosslinking agent having a crosslinking forming group is a derivative of a thiourea bond-containing compound, and has a structure in which at least one of hydrogen atoms of an NH group constituting a thiourea bond is replaced with a crosslinking forming group.

Specific examples of the thiourea-based crosslinking agent having a crosslinking forming group include a mono-, bis-, tris-, or tetrakis- alkoxymethylthiourea such as 1,3-bis(methoxymethyl) thiourea or 1,1,3,3-tetrakismethoxymethylthiourea, but are not limited thereto.

The amount of the crosslinking agent contained in the release agent composition varies depending on a coating method to be adopted, a desired film thickness, and the like, and thus cannot be generally specified, but is usually 0.01 to 50% by mass with respect to the specific compound, and is preferably 0.1% by mass or more, more preferably 1% by mass or more, still more preferably 3% by mass or more, further still more preferably 5% by mass or more, and preferably 45% by mass or less, more preferably 40% by mass or less, still more preferably 35% by mass or less, and further still more preferably 30% by mass or less from a viewpoint of achieving suitable curing and obtaining a laminate in which a semiconductor substrate and a support substrate can be favorably separated from each other with good reproducibility.

### <<<Acid generator and acid>>>

The release agent composition may contain an acid generator or an acid for the purpose of, for example, promoting a crosslinking reaction. Provided that the release agent composition usually does not contain an acid generator or an acid from a viewpoint of obtaining, with good reproducibility, a film suitable as a release layer, having a characteristic that the film cannot be suitably removed with an organic solvent, an acid, or a chemical solution (an alkali developer, hydrogen peroxide water, or the like) used in manufacture of a semiconductor element but can be suitably removed with a cleaning agent composition.

Examples of the acid generator include a thermal acid generator and a photoacid generator.

The thermal acid generator is not particularly limited as long as it generates an acid by heat, and specific examples thereof include 2,4,4,6-tetrabromocyclohexadienone, benzoin tosylate, 2-nitrobenzyl tosylate, K-PURE [registered trademark] CXC-1612, K-PURE CXC-1614, K-PURE TAG-2172, K-PURE TAG-2179, K-PURE TAG-2678, K-PURE TAG2689, and K-PURE TAG2700 (manufactured by King Industries, Inc.), SI-45, SI-60, SI-80, SI-100, SI-110, and SI-150 (manufactured by Sanshin Chemical Industry Co., Ltd.), and other organic sulfonic acid alkyl esters, but are not limited thereto.

Examples of the photoacid generator include an onium salt compound, a sulfonimide compound, and a disulfonyldiazomethane compound.

Specific examples of the onium salt compound include: an iodonium salt compound such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl) iodonium camphor sulfonate, or bis(4-tert-butylphenyl) iodonium trifluoromethanesulfonate; and a sulfonium salt compound such as triphenylsulfonium hexafluoroantimonate, triphenylsulfonium nonafluoronormal butanesulfonate, triphenylsulfonium camphor sulfonate, or triphenylsulfonium trifluoromethanesulfonate, but are not limited thereto.

Specific examples of the sulfonimide compound include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide, but are not limited thereto.

Specific examples of the disulfonyl diazomethane compound include bis(trifluoromethylsulfonyl) diazomethane, bis(cyclohexylsulfonyl) diazomethane, bis(phenylsulfonyl) diazomethane, bis(p-toluenesulfonyl) diazomethane, bis(2,4-dimethylbenzenesulfonyl) diazomethane, and methylsulfonyl-p-toluenesulfonyl diazomethane, but are not limited thereto.

Specific examples of the acid include: an arylsulfonic acid and a salt thereof such as a pyridinium salt, such as p-toluenesulfonic acid, pyridinium p-toluenesulfonate, pyridinium trifluoromethanesulfonate, pyridinium phenolsulfonate, 5-sulfosalicylic acid, 4-phenolsulfonic acid, 4-chlorobenzenesulfonic acid, benzenedisulfonic acid, or 1-naphthalenesulfonic acid; an arylcarboxylic acid such as salicylic acid, benzoic acid, hydroxybenzoic acid, or naphthalenecarboxylic acid, and a salt thereof; a chain or cyclic alkylsulfonic acid such as trifluoromethanesulfonic acid or camphorsulfonic acid, and a salt thereof; and a chain or cyclic alkylcarboxylic acid such as citric acid, and a salt thereof, but are not limited thereto.

The amount of each of the acid generator and the acid contained in the release agent composition varies depending on the type of a crosslinking agent to be used, a heating temperature at the time of forming the film, and the like, and thus cannot be generally specified, but is usually 0.01 to 5% by mass with respect to the film constituent components.

### <<<Surfactant>>>

The release agent composition may contain a surfactant for the purpose of, for example, adjusting liquid physical properties of the composition itself or film physical properties of a film to be obtained, or preparing a highly uniform release agent composition with good reproducibility.

Examples of the surfactant include: a polyoxyethylene alkyl ether such as polyoxyethylene lauryl ether, polyoxyethylene stearyl ether, polyoxyethylene cetyl ether, or polyoxyethylene oleyl ether; a polyoxyethylene alkyl allyl ether such as polyoxyethylene octyl phenol ether or polyoxyethylene nonyl phenol ether; a polyoxyethylene/polyoxypropylene block copolymer; a sorbitan fatty acid ester such as sorbitan monolaurate, sorbitan monopalmitate, sorbitan monostearate, sorbitan monooleate, sorbitan trioleate, or sorbitan tristearate; a nonionic surfactant such as a polyoxyethylene sorbitan fatty acid ester such as polyoxyethylene sorbitan monolaurate, polyoxyethylene sorbitan monopalmitate, polyoxyethylene sorbitan monostearate, polyoxyethylene sorbitan trioleate, or polyoxyethylene sorbitan tristearate; a fluorine-based surfactant such as F-top EF301, EF303, and EF352 (trade names, manufactured by TOCHEM PRODUCTS CO., LTD.), Megafac F171, F173, R-30, and R-30N (trade names, manufactured by DIC Corporation), Fluorad FC430 and FC431 (trade names, manufactured by Sumitomo 3M Limited), or AsahiGuard AG710, Surflon S-382, SC101, SC102, SC103, SC104, SC105, and SC106 (trade names, manufactured by Asahi Glass Co., Ltd.); and organosiloxane polymer KP341 (manufactured by Shin-Etsu Chemical Co., Ltd.) .

The surfactant can be used singly or in combination of two or more types thereof.

The amount of the surfactant is usually 2% by mass or less with respect to the film constituent components of the release agent composition.

### <<<Solvent>>>

The release agent composition preferably contains a solvent.

As such a solvent, for example, a high-polarity solvent capable of satisfactorily dissolving the film constituent components such as the above-described specific compound and the above-described crosslinking agent can be used, and as necessary, a low-polarity solvent may be used for the purpose of adjusting viscosity, surface tension, and the like. Note that, in the present invention, the low-polarity solvent is defined as a solvent having a relative permittivity of less than 7 at a frequency of 100 kHz, and the high-polarity solvent is defined as a solvent having a relative permittivity of 7 or more at a frequency of 100 kHz. The solvent can be used singly or in combination of two or more types thereof.

Examples of the high-polarity solvent include: an amide-based solvent such as N,N-dimethylformamide, N,N-dimethylacetamide, N,N-dimethylisobutyramide, N-methylpyrrolidone, or 1,3-dimethyl-2-imidazolidinone; a ketone-based solvent such as ethyl methyl ketone, isophorone, or cyclohexanone; a cyano-based solvent such as acetonitrile or 3-methoxypropionitrile; a polyhydric alcohol-based solvent such as ethylene glycol, diethylene glycol, triethylene glycol, dipropylene glycol, 1,3-butanediol, or 2,3-butanediol;
propylene glycol monomethyl ether; diethylene glycol monomethyl ether; diethylene glycol monophenyl ether; triethylene glycol monomethyl ether; dipropylene glycol monomethyl ether; a monohydric alcohol-based solvent other than an aliphatic alcohol, such as benzyl alcohol, 2-phenoxyethanol, 2-benzyloxyethanol, 3-phenoxybenzyl alcohol, or tetrahydrofurfuryl alcohol; and a sulfoxide-based solvent such as dimethyl sulfoxide.

Examples of the low-polarity solvent include: a chlorine-based solvent such as chloroform or chlorobenzene; an aromatic hydrocarbon-based solvent such as an alkylbenzene such as toluene, xylene, tetralin, cyclohexylbenzene, or decylbenzene; an aliphatic alcohol-based solvent such as 1-octanol, 1-nonanol, or 1-decanol; an ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and an ester-based solvent such as methyl benzoate, ethyl benzoate, butyl benzoate, isoamyl benzoate, bis(2-ethylhexyl) phthalate, dibutyl maleate, dibutyl oxalate, hexyl acetate, propylene glycol monomethyl ether acetate, diethylene glycol monoethyl ether acetate, or diethylene glycol monobutyl ether acetate.

The content of the solvent is appropriately determined in consideration of a desired viscosity of the composition, a coating method to be adopted, the thickness of a film to be prepared, and the like, but is 99% by mass or less with respect to the entire composition, and preferably 70 to 99% by mass with respect to the entire composition, that is, the amount of the film constituent components in this case is 1 to 30% by mass with respect to the entire composition.

The viscosity and surface tension of the release agent composition are appropriately adjusted by changing the type of a solvent to be used, a ratio thereof, the concentrations of the film constituent components, and the like in consideration of various factors such as a coating method to be used and a desired film thickness.

In an aspect of the present invention, the release agent composition contains a glycol-based solvent from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like. Note that the "glycol-based solvent" as used herein is a generic term for a glycol, a glycol monoether, a glycol diether, a glycol monoester, a glycol diester, and a glycol ester ether.

A preferable example of the glycol-based solvent is represented by formula (G).

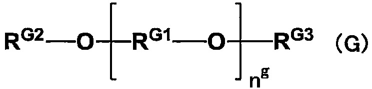

In formula (G), R^{G1}s each independently represent a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which an alkyl moiety is a linear or branched alkyl group having 1 to 8 carbon atoms, and n^{g} is an integer of 1 to 6.

Specific examples of the linear or branched alkylene group having 2 to 4 carbon atoms include an ethylene group, a trimethylene group, a 1-methylethylene group, a tetramethylene group, a 2-methylpropane 1,3-diyl group, a pentamethylene group, and a hexamethylene group, but are not limited thereto.

Among these groups, a linear or branched alkylene group having 2 to 3 carbon atoms is preferable, and a linear or branched alkylene group having 3 carbon atoms is more preferable from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

Specific examples of the linear or branched alkyl group having 1 to 8 carbon atoms include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Among these groups, a methyl group and an ethyl group are preferable, and a methyl group is more preferable from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

Specific examples of the linear or branched alkyl group having 1 to 8 carbon atoms in the alkylacyl group in which an alkyl moiety is the linear or branched alkyl group having 1 to 8 carbon atoms include the same as the specific examples described above.

Among these groups, a methylcarbonyl group and an ethylcarbonyl group are preferable, and a methylcarbonyl group is more preferable from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

n^{g} is preferably 4 or less, more preferably 3 or less, still more preferably 2 or less, and most preferably 1 from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

In formula (G), preferably, at least one of R^{G2} and R^{G3} is a linear or branched alkyl group having 1 to 8 carbon atoms, and more preferably, one of R^{G2} and R^{G3} is a linear or branched alkyl group having 1 to 8 carbon atoms, and the other is a hydrogen atom or an alkylacyl group in which an alkyl moiety is a linear or branched alkyl group having 1 to 8 carbon atoms from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

The content of the glycol-based solvent is preferably 50% by mass or more, more preferably 70% by mass or more, still more preferably 80% by mass or more, further still more preferably 90% by mass or more, and further still more preferably 95% by mass or more with respect to a solvent contained in the release agent composition from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

In the release agent composition, the film constituent components are uniformly dispersed or dissolved and preferably dissolved in a solvent from a viewpoint of obtaining a highly uniform composition with good reproducibility, from a viewpoint of obtaining a composition having high storage stability with good reproducibility, from a viewpoint of obtaining a composition that provides a highly uniform film with good reproducibility, and the like.

The release agent composition can be manufactured, for example, by mixing the above-described specific compound, a solvent, and as necessary, a crosslinking agent.

A mixing order therefor is not particularly limited, but examples of a method by which the release agent composition can be easily manufactured with good reproducibility include: a method for dissolving the above-described specific compound and a crosslinking agent in a solvent at a time; and a method for dissolving a part of the above-described specific compound and a crosslinking agent in a solvent, separately dissolving the rest in a solvent, and mixing the obtained solutions, but are not limited thereto. Note that, at this time, as a solution of the above-described specific compound, the reaction solution obtained by the synthesis of the above-described specific compound can be used as it is or in a concentrated or diluted state. When the release agent composition is prepared, heating may be appropriately performed as long as the components are not decomposed or altered.

In the present invention, for the purpose of removing foreign substances, a solvent, a solution, and the like to be used may be filtered using a filter or the like during manufacture of the release agent composition or after all the components are mixed.

The thickness of the release layer included in the laminate of the present invention is not particularly limited, but is usually 5 nm to 100 µm, 10 nm to 1 µm in an aspect, and 50 nm to 500 nm in another aspect.

The above-described release agent composition is also a subject of the present invention, and related conditions (suitable conditions, manufacturing conditions, and the like) are as described above. By using the release agent composition of the present invention, for example, a film suitable as a release layer that can be used for manufacture of a semiconductor element can be manufactured with good reproducibility.

The above-described specific compound is also a subject of the present invention. The above-described specific compound can be suitably used for the above-described release agent composition, but an application thereof is not limited thereto.

The release agent composition of the present invention can be suitably used for forming a release layer of a laminate including a semiconductor substrate, a support substrate, and an adhesive layer and a release layer disposed between the semiconductor substrate and the support substrate. The laminate is used for releasing the semiconductor substrate and the support substrate after the release layer absorbs light emitted from the support substrate side.

One of characteristics of the release layer obtained from the release agent composition of the present invention is that the release layer cannot be suitably removed with an organic solvent, an acid, or a chemical solution (an alkali developer, hydrogen peroxide water, or the like) used in manufacture of a semiconductor element but can be suitably removed with a cleaning agent composition even after irradiation with light. Such specific and selective removability is contributed by the specific compound contained in the release agent composition of the present invention, and the specific compound can function as a solubility improving agent or a removability improving agent for the release layer with respect to the cleaning agent composition, and can function as a solubility lowering agent or a removability lowering agent for the release layer with respect to an organic solvent, an acid, or a chemical solution (an alkali developer, hydrogen peroxide water, or the like) used in manufacture of a semiconductor element.

As described above, preferably, the release layer obtained from the release agent composition of the present invention cannot be suitably removed with an organic solvent, an acid, or a chemical solution (an alkali developer, hydrogen peroxide water, or the like) used in manufacture of a semiconductor element.

Specific examples of such an organic solvent typically include: a linear or branched aliphatic hydrocarbon such as a linear or branched aliphatic saturated hydrocarbon such as hexane, heptane, octane, nonane, decane, undecane, dodecane, or isododecane; a cycloaliphatic hydrocarbon such as a cycloaliphatic saturated hydrocarbon such as cyclohexane, cycloheptane, cyclooctane, isopropylcyclohexane, or p-menthane, or a cycloaliphatic unsaturated hydrocarbon such as limonene; an aromatic hydrocarbon such as benzene, toluene, o-xylene, m-xylene, p-xylene, mesitylene, 1,2,4-trimethylbenzene, cumene, 1,4-diisopropylbenzene, or p-cymene; an aliphatic hydrocarbon ketone such as an aliphatic saturated hydrocarbon ketone such as a dialkyl ketone such as methyl isobutyl ketone (MIBK), ethyl methyl ketone, acetone, diisobutyl ketone, 2-octanone, 2-nonanone, or 5-nonanone, or a cycloalkyl ketone such as cyclohexanone, or an aliphatic unsaturated hydrocarbon ketone such as an alkenyl ketone such as isophorone; an aliphatic hydrocarbon ether such as a dialkyl ether such as a diethyl ether, di(n-propyl) ether, di(n-butyl) ether, or di(n-pentyl) ether, or a cyclic alkyl ether such as tetrahydrofuran or dioxane; an aliphatic hydrocarbon sulfide such as a dialkyl sulfide such as diethyl sulfide, di(n-propyl) sulfide, or di(n-butyl) sulfide; an amide such as N,N-dimethylformamide, N,N-dimethylacetamide, N,N-dimethylisobutyramide, N-methylpyrrolidone, or 1,3-dimethyl-2-imidazolidinone; a nitrile such as acetonitrile or 3-methoxypropionitrile; an alkyl monoalcohol such as a linear or branched alkyl monoalcohol such as methanol, ethanol, or propanol, or a cyclic alkyl monoalcohol such as cyclohexanol; a monoalcohol other than an alkyl monoalcohol, such as diacetone alcohol, benzyl alcohol, 2-phenoxyethanol, 2-benzyloxyethanol, 3-phenoxybenzyl alcohol, or tetrahydrofurfuryl alcohol; a glycol such as ethylene glycol, propylene glycol, diethylene glycol, dipropylene glycol, tripropylene glycol, hexylene glycol, triethylene glycol, 1,2-butanediol, 2,3-butanediol, 1,3-butanediol, 1,4-butanediol, or 1,5-pentanediol; a glycol monohydrocarbon ether such as a glycol monoalkyl ether such as ethylene glycol monohexyl ether, propylene glycol monobutyl ether, diethylene glycol monoethyl ether, dipropylene glycol monobutyl ether, ethylene glycol monobutyl ether, diethylene glycol monobutyl ether, diethylene glycol monoisobutyl ether, triethylene glycol monomethyl ether, dipropylene glycol monomethyl ether, diethylene glycol monopropyl ether (propyl carbitol), diethylene glycol monohexyl ether, 2-ethylhexyl carbitol, dipropylene glycol monopropyl ether, tripropylene glycol monomethyl ether, diethylene glycol monomethyl ether, or tripropylene glycol monobutyl ether, or a glycol monoaryl ether such as diethylene glycol monophenyl ether; a glycol monoether such as a glycol monoaryl ether such as 2-phenoxyethanol; a glycol diether such as a glycol dialkyl ether such as ethylene glycol dibutyl ether, diethylene glycol dimethyl ether, diethylene glycol diethyl ether, propylene glycol dibutyl ether, dipropylene glycol methyl-n-propyl ether, dipropylene glycol dimethyl ether, dipropylene glycol diethyl ether, dipropylene glycol dibutyl ether, triethylene glycol dimethyl ether, triethylene glycol butyl methyl ether, or tetraethylene glycol dimethyl ether; a glycol ether acetate such as a glycol monoalkyl ether acetate such as dipropylene glycol monomethyl ether acetate, diethylene glycol monoethyl ether acetate, diethylene glycol monobutyl ether acetate, or propylene glycol monomethyl ether acetate; a cyclic carbonate such as ethylene carbonate, propylene carbonate, or vinylene carbonate; and an ester such as butyl acetate or pentyl acetate.

Specific examples of such an acid include: a mineral acid such as phosphoric acid, hydrochloric acid, perchloric acid, nitric acid, or sulfuric acid and a salt thereof; an arylsulfonic acid and a salt thereof such as a pyridinium salt, such as p-toluenesulfonic acid, pyridinium p-toluenesulfonate, pyridinium phenolsulfonate, 5-sulfosalicylic acid, 4-phenolsulfonic acid, 4-chlorobenzenesulfonic acid, benzenedisulfonic acid, or 1-naphthalenesulfonic acid; an arylcarboxylic acid such as salicylic acid, benzoic acid, hydroxybenzoic acid, or naphthalenecarboxylic acid, and a salt thereof; a chain or cyclic alkylsulfonic acid such as trifluoromethanesulfonic acid or camphorsulfonic acid, and a salt thereof; and a chain or cyclic alkylcarboxylic acid such as citric acid, and a salt thereof, but are not limited thereto.

Examples of such an alkali developer include: an aqueous solution of an alkali metal hydroxide such as potassium hydroxide or sodium hydroxide; an aqueous solution of a quaternary ammonium hydroxide such as tetramethylammonium hydroxide, tetraethylammonium hydroxide, or choline; and an alkaline aqueous solution such as an amine aqueous solution of ethanolamine, propylamine, or ethylenediamine, but are not limited thereto.

The characteristic that the release layer obtained from the release agent composition of the present invention is not suitably removed with an organic solvent, an acid, or a chemical solution (an alkali developer, hydrogen peroxide water, or the like) used in manufacture of a semiconductor element can be evaluated by the following method.

That is, the characteristic can be evaluated by immersing a film having a thickness of 200 nm and formed on a silicon wafer of 4 cm square in 7 mL of an evaluation liquid together with the silicon wafer, and calculating a film reduction ratio (%) of a film thickness after immersion with respect to a film thickness before immersion in a case where the film thicknesses before and after immersion are compared.

Even after the release layer obtained from the release agent composition of the present invention is immersed in an organic solvent, an acid, or a chemical solution (an alkali developer, hydrogen peroxide water, or the like) used in manufacture of a semiconductor element according to such a method, the film reduction ratio is usually 10% or less, is 6% or less in a preferable aspect, 5% or less in a more preferable aspect, 4% or less in a still more preferable aspect, 3% or less in a further still more preferable aspect, 2% or less in a further still more preferable aspect, 1% or less in a further still more preferable aspect, and 0% in a most preferable aspect. Note that the film reduction ratio can be calculated by the following formula.

Film reduction ratio (%) = [1 - [film thickness (nm) after immersion/film thickness (nm) before immersion]] × 100

Note that, according to the above formula, for example, when the film swells and the film thickness increases, the film thickness after immersion increases as compared with the film thickness before immersion, and thus the film reduction ratio is a negative value. However, the above formula does not exclude such a case from the present invention by denying the case.

### <<<Cleaning agent composition>>>

The release layer obtained from the release agent composition of the present invention can be suitably removed with a cleaning agent composition, and such a cleaning agent composition usually contains a salt and a solvent.

Suitable examples of the cleaning agent composition include a cleaning agent composition containing a quaternary ammonium salt and a solvent.

The quaternary ammonium salt is not particularly limited as long as it is composed of a quaternary ammonium cation and an anion and is used for this type of application.

Examples of such a quaternary ammonium cation typically include a tetra(hydrocarbon) ammonium cation. Meanwhile, examples of an anion paired with the quaternary ammonium cation include a hydroxide ion (OH⁻); a halogen ion such as a fluorine ion (F⁻), a chlorine ion (Cl⁻), a bromine ion (Br⁻), or an iodine ion (I⁻); a tetrafluoroborate ion (BF₄⁻); and a hexafluorophosphate ions (PF₆⁻), but are not limited thereto.

In the present invention, the quaternary ammonium salt is preferably a halogen-containing quaternary ammonium salt, and more preferably a fluorine-containing quaternary ammonium salt.

In the quaternary ammonium salt, a halogen atom may be contained in the cation or the anion, but is preferably contained in the anion.

In a preferable aspect, the fluorine-containing quaternary ammonium salt is a tetra(hydrocarbon) ammonium fluoride.

Specific examples of a hydrocarbon group in the tetra(hydrocarbon) ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferable aspect, the tetra(hydrocarbon) ammonium fluoride contains a tetraalkylammonium fluoride.

Specific examples of the tetraalkylammonium fluoride include tetramethylammonium fluoride, tetraethylammonium fluoride, tetrapropylammonium fluoride, and tetrabutylammonium fluoride, but are not limited thereto. Among these compounds, tetrabutylammonium fluoride is preferable.

As the quaternary ammonium salt such as a tetra(hydrocarbon) ammonium fluoride, a hydrate may be used. The quaternary ammonium salt such as a tetra(hydrocarbon) ammonium fluoride may be used singly or in combination of two or more types thereof.

The amount of the quaternary ammonium salt is not particularly limited as long as the quaternary ammonium salt is dissolved in ae solvent contained in the cleaning agent composition, but is usually 0.1 to 30% by mass with respect to the cleaning agent composition.

The solvent contained in the cleaning agent composition used in the present invention is not particularly limited as long as it is used for this type of application and dissolves a salt such as a quaternary ammonium salt, but the cleaning agent composition used in the present invention preferably contains one or more amide-based solvents from a viewpoint of obtaining a cleaning agent composition having an excellent cleaning property with good reproducibility, a viewpoint of obtaining a cleaning agent composition having excellent uniformity by dissolving a salt such as a quaternary ammonium salt favorably, and the like,

Suitable examples of the amide-based solvent include an acid amide derivative represented by formula (Z). 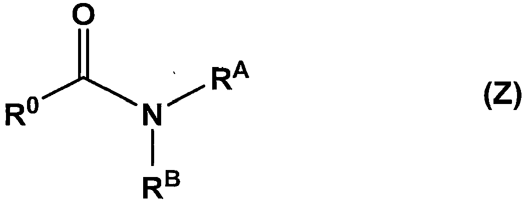 in which, R⁰ represents an ethyl group, a propyl group, or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, a n-butyl group, an isobutyl group, a s-butyl group, a t-butyl group, and a cyclobutyl group. Among these groups, each of R^{A} and R^{B} is preferably a methyl group or an ethyl group. More preferably, both of R^{A} and R^{B} are methyl groups or ethyl groups. Still more preferably, both of R^{A} and R^{B} are methyl groups.

Examples of the acid amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among these compounds, particularly, N,N-dimethylpropionamide and N,N-dimethylisobutyramide are preferable, and N,N-dimethylpropionamide is more preferable.

The acid amide derivative represented by formula (Z) may be synthesized by a substitution reaction between a carboxylic acid ester corresponding thereto and an amine, or a commercially available product may be used.

Other preferable example of the amide-based solvent include a lactam compound represented by formula (Y).

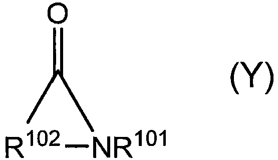

In formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, a n-propyl group, and a n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

Specific examples of the lactam compound represented by formula (Y) include an α-lactam compound, a β-lactam compound, a γ-lactam compound, and a δ-lactam compound, and these compounds can be used singly or in combination of two or more types thereof.

The lactam compound represented by formula (Y) includes 1-alkyl-2-pyrrolidone (N-alkyl-γ-butyrolactam) in a preferable aspect of the present invention, includes N-methylpyrrolidone (NMP) or N-ethylpyrrolidone (NEP) in a more preferable aspect, and includes N-methylpyrrolidone (NMP) in a still more preferable aspect.

The cleaning agent composition used in the present invention may contain one or more other organic solvents different from the above-described amide compound.

Such another organic solvent is not particularly limited as long as it is used for this type of application and is an organic solvent compatible with the above-described amide compound.

Preferable examples of the other solvent include an alkylene glycol dialkyl ether, an aromatic hydrocarbon compound, and a cyclic structure-containing ether compound, but are not limited thereto.

The amount of the other organic solvent different from the above-described amide compound is usually determined appropriately to be 95% by mass or less in a solvent contained in the cleaning agent composition as long as a quaternary ammonium salt contained in the cleaning agent composition is not precipitated or separated, and is uniformly mixed with the above-described amide compound.

Note that the cleaning agent composition used in the present invention may contain water as a solvent, but usually, only an organic solvent is intentionally used as a solvent from a viewpoint of avoiding corrosion of a substrate or the like. Note that, in this case, it is not denied that hydration water of a salt or water contained in a trace amount in the organic solvent is contained in the cleaning agent composition. The water content of the cleaning agent composition used in the present invention is usually 5% by mass or less.

A characteristic that the release layer obtained from the release agent composition of the present invention is suitably removed with the cleaning agent composition can be similarly evaluated using a film reduction ratio (%) according to the above-described method.

The release layer obtained from the release agent composition of the present invention exhibits a high film reduction ratio of usually 90% or more, 94% or more in a preferable aspect, 95% or more in a more preferable aspect, 96% or more in a still more preferable aspect, 97% or more in a further still more preferable aspect, 98% or more in a further still more preferable aspect, 99% or more in a further still more preferable aspect, and 100% in a most preferable aspect after being immersed in the cleaning agent composition according to the above-described method.

### <Adhesive layer>

The adhesive layer is disposed between the support substrate and the semiconductor substrate.

The adhesive layer is in contact with, for example, the semiconductor substrate. The adhesive layer may be in contact with, for example, the support substrate.

The adhesive layer is not particularly limited, but is preferably formed of an adhesive composition.

### <<Adhesive composition>>

Examples of the adhesive composition include a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive, but are not limited thereto.

Among these adhesives, a polysiloxane-based adhesive is preferable as the adhesive composition because the polysiloxane-based adhesive exhibits suitable adhesive ability during processing of a semiconductor substrate or the like, can be suitably released after processing, is further excellent in heat resistance, and can be suitably removed with a cleaning agent composition.

The adhesive composition may be a thermosetting adhesive composition or a thermoplastic adhesive composition.

In a preferable aspect, the adhesive composition contains a polyorganosiloxane.

In another preferable aspect, the adhesive composition contains a component that is curable by a hydrosilylation reaction.

Examples of a more specific embodiment of the thermosetting adhesive composition used in the present invention include the following <<First Embodiment>> to <<Third Embodiment>>.

Examples of a more specific embodiment of the thermoplastic adhesive composition used in the present invention include <<Fourth Embodiment>>.

### <<First Embodiment>>

As a preferable embodiment, the adhesive composition used in the present invention contains a polyorganosiloxane.

For example, the adhesive composition used in the present invention contains a curable component (A) servings as an adhesive component. The adhesive composition used in the present invention may contain the curable component (A) serving as an adhesive component and a component (B) that does not cause a curing reaction. Here, examples of the component (B) that does not cause a curing reaction include a polyorganosiloxane. Note that, in the present invention, "not causing a curing reaction" does not mean not causing any curing reaction, but means not causing a curing reaction that occurs in the curable component (A).

In another preferable aspect, the component (A) may be a component that is curable by a hydrosilylation reaction, or may be a polyorganosiloxane component (A') that is cured by a hydrosilylation reaction.

In another preferable aspect, the component (A) contains, for example, a polyorganosiloxane (a1) having an alkenyl group having 2 to 40 carbon atoms and bonded to a silicon atom, a polyorganosiloxane (a2) having a Si-H group, and a platinum group metal-based catalyst (A2) as an example of the component (A'). Here, the alkenyl group having 2 to 40 carbon atoms may have a substituent. Examples of the substituent include a halogen atom, a nitro group, a cyano group, an amino group, a hydroxy group, a carboxyl group, an aryl group, and a heteroaryl group.

In another preferable aspect, the polyorganosiloxane component (A') cured by a hydrosilylation reaction contains: a polysiloxane (A1) containing one or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}; and a platinum group metal-based catalyst (A2). The polysiloxane (A1) contains: a polyorganosiloxane (a1') containing one or more units selected from the group consisting of a siloxane unit (Q' unit) represented by SiO₂, a siloxane unit (M' unit) represented by R^{1'}R^{2'}R^{3'}SiO_{1/2}, a siloxane unit (D' unit) represented by R^{4'}R^{5'}SiO_{2/2}, and a siloxane unit (T' unit) represented by R^{6'}SiO_{3/2}, and containing at least one selected from the group consisting of the M' unit, the D' unit, and the T' unit; and a polyorganosiloxane (a2') containing one or more units selected from the group consisting of a siloxane unit (Q" unit) represented by SiO₂, a siloxane unit (M" unit) represented by R^{1"}R^{2"}R^{3"}SiO_{1/2}, a siloxane unit (D" unit) represented by R^{4"}R^{5"}SiO_{2/2}, and a siloxane unit (T" unit) represented by R^{6"}SiO_{3/2}, and containing at least one selected from the group consisting of the M" unit, the D" unit, and the T" unit.

Note that (a1') is an example of (a1), and (a2') is an example of (a2).

R¹ to R⁶ each represent a group or an atom bonded to a silicon atom, and each independently represent an alkyl group that may have a substituent, an alkenyl group that may have a substituent, or a hydrogen atom. Examples of the substituent include a halogen atom, a nitro group, a cyano group, an amino group, a hydroxy group, a carboxyl group, an aryl group, and a heteroaryl group.

R^{1'} to R^{6'} each represent a group bonded to a silicon atom, and each independently represent an alkyl group that may have a substituent or an alkenyl group that may have a substituent, but at least one of R^{1'} to R^{6'} is an alkenyl group that may have a substituent. Examples of the substituent include a halogen atom, a nitro group, a cyano group, an amino group, a hydroxy group, a carboxyl group, an aryl group, and a heteroaryl group.

R^{1"} to R^{6"} each represent a group or an atom bonded to a silicon atom, and each independently represent an alkyl group that may have a substituent or a hydrogen atom, but at least one of R^{1"} to R^{6"} is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the linear or branched alkyl group that may have a substituent include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto. The number of carbon atoms thereof is usually 1 to 14, preferably 1 to 10, and more preferably 1 to 6. Among these groups, a methyl group is particularly preferable.

Specific examples of the cyclic alkyl group that may have a substituent include: a cycloalkyl group such as a cicyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, or a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, or a bicyclodecyl group, but are not limited thereto. The number of carbon atoms thereof is usually 3 to 14, preferably 4 to 10, and more preferably 5 or 6.

The alkenyl group may be linear or branched, and the number of carbon atoms thereof is not particularly limited, but is usually 2 to 40, preferably 30 or less, more preferably 20 or less, and still more preferably 10 or less.

Specific examples of the linear or branched alkenyl group that may have a substituent include a vinyl group, an allyl group, a butenyl group, and a pentenyl group, but are not limited thereto, and the number of carbon atoms thereof is usually 2 to 14, preferably 2 to 10, and more preferably 1 to 6. Among these groups, an ethenyl group and a 2-propenyl group are particularly preferable.

Specific examples of the cyclic alkenyl group that may have a substituent include cyclopentenyl and cyclohexenyl, but are not limited thereto. The number of carbon atoms thereof is usually 4 to 14, preferably 5 to 10, and more preferably 5 or 6.

As described above, the polysiloxane (A1) contains the polyorganosiloxane (a1') and the polyorganosiloxane (a2'). An alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) to cause curing. As a result, a cured film is formed.

The polyorganosiloxane (a1') contains one or more units selected from the group consisting of the Q' unit, the M' unit, the D' unit, and the T' unit, and contains at least one selected from the group consisting of the M' unit, the D' unit, and the T' unit. As the polyorganosiloxane (a1'), two or more polyorganosiloxanes satisfying such a condition may be used in combination.

Preferable examples of the combination of two or more selected from the group consisting of the Q' unit, the M' unit, the D' unit, and the T' unit include (Q' unit and M' unit), (D' unit and M' unit), (T' unit and M' unit), and (Q' unit, T' unit, and M' unit), but are not limited thereto.

When the polyorganosiloxane (a1') contains two or more polyorganosiloxanes, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combination is not limited thereto.

The polyorganosiloxane (a2') contains one or more units selected from the group consisting of the Q" unit, the M" unit, the D" unit, and the T" unit, and contains at least one selected from the group consisting of the M" unit, the D" unit, and the T" unit. As the polyorganosiloxane (a2'), two or more polyorganosiloxanes satisfying such a condition may be used in combination.

Preferable examples of the combination of two or more selected from the group consisting of the Q" unit, the M" unit, the D" unit, and the T" unit include (M" unit and D" unit), (Q" unit and M" unit), and (Q" unit, T" unit, and M" unit), but are not limited thereto.

The polyorganosiloxane (a1') is constituted by a siloxane unit in which an alkyl group and/or an alkenyl group are/is bonded to a silicon atom thereof, and a ratio of the alkenyl group in all the substituents represented by R^{1'} to R^{6'} is preferably 0.1 to 50.0 mol%, and more preferably 0.5 to 30.0 mol%, and the remaining R^{1'} to R^{6'} can be alkyl groups.

The polyorganosiloxane (a2') is constituted by a siloxane unit in which an alkyl group and/or a hydrogen atom are/is bonded to a silicon atom thereof, and a ratio of the hydrogen atom in all the substituents and substitution atoms represented by R^{1"} to R^{6"} is preferably 0.1 to 50.0 mol%, and more preferably 10.0 to 40.0 mol%, and the remaining R^{1"} to R^{6"} can be alkyl groups.

When the component (A) contains (a1) and (a2), in a preferable aspect of the present invention, a molar ratio between an alkenyl group contained in the polyorganosiloxane (a1) and a hydrogen atom constituting a Si-H bond contained in the polyorganosiloxane (a2) is in a range of 1.0 : 0.5 to 1.0 : 0.66.

A weight average molecular weight of a polysiloxane such as the polyorganosiloxane (a1) or the polyorganosiloxane (a2) is not particularly limited, but is usually 500 to 1,000,000, and is preferably 5,000 to 50,000 from a viewpoint of achieving the effects of the present invention with good reproducibility.

Note that, in the present invention, a weight average molecular weight, a number average molecular weight, and a dispersion degree of a polyorganosiloxane (excluding the specific compound) can be measured, for example, using a GPC apparatus (EcoSEC, HLC-8320 GPC manufactured by Tosoh Corporation) and GPC columns (TSKgel SuperMultipore HZ-N and TSKgel SuperMultipore HZ-H manufactured by Tosoh Corporation), at a column temperature of 40°C, using tetrahydrofuran as an eluent (elution solvent), at a flow rate of 0.35 mL/min, and using polystyrene (Shodex manufactured by Showa Denko K.K.) as a standard sample.

A viscosity of each of the polyorganosiloxane (a1) and the polyorganosiloxane (a2) is not particularly limited, but is usually 10 to 1000000 (mPa•s), and is preferably 50 to 10000 (mPa•s) from a viewpoint of achieving the effects of the present invention with good reproducibility. Note that the viscosity of each of the polyorganosiloxane (a1) and the polyorganosiloxane (a2) is a value measured with an E-type rotational viscometer at 25°C.

The polyorganosiloxane (a1) and the polyorganosiloxane (a2) react with each other by a hydrosilylation reaction to form a film. Therefore, a mechanism of the curing is different from that via, for example, a silanol group, and therefore, any siloxane does not need to contain a functional group that forms a silanol group by hydrolysis, such as a silanol group or an alkyloxy group.

In a preferable aspect of the present invention, the adhesive composition contains the platinum group metal-based catalyst (A2) together with the polyorganosiloxane component (A').

Such a platinum-based metal catalyst is a catalyst for promoting a hydrosilylation reaction between an alkenyl group of the polyorganosiloxane (a1) and a Si-H group of the polyorganosiloxane (a2).

Specific examples of the platinum-based metal catalyst include a platinum-based catalyst such as platinum black, second platinum chloride, chloroplatinic acid, a reaction product of chloroplatinic acid and a monohydric alcohol, a complex of chloroplatinic acid and an olefin, or platinum bisacetoacetate, but are not limited thereto.

Examples of the complex of platinum and an olefin include a complex of divinyltetramethyldisiloxane and platinum, but are not limited thereto.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing progress of a hydrosilylation reaction.

The polymerization inhibitor is not particularly limited as long as it can suppress progress of the hydrosilylation reaction, and specific examples thereof include an alkynyl alcohol such as 1-ethynyl-1-cyclohexanol or 1,1-diphenyl-2-propion-1-ol.

The amount of the polymerization inhibitor is not particularly limited, but is usually 1000.0 ppm or more with respect to the total amount of the polyorganosiloxane (a1) and the polyorganosiloxane (a2) from a viewpoint of obtaining an effect thereof, and is 10,000.0 ppm or less from a viewpoint of preventing excessive suppression of the hydrosilylation reaction.

An example of the adhesive composition used in the present invention may contain the component (B) that does not cause a curing reaction and serves as a release agent component together with the curable component (A). By inclusion of such a component (B) in the adhesive composition, an adhesive layer to be obtained can be suitably released with good reproducibility.

Examples of such a component (B) typically include a non-curable polyorganosiloxanes, and specific examples thereof include an epoxy group-containing polyorganosiloxane, a methyl group-containing polyorganosiloxane, and a phenyl group-containing polyorganosiloxane, but are not limited thereto.

Examples of the component (B) include a polydimethylsiloxane. The polydimethylsiloxane may be modified. Examples of the polydimethylsiloxane that may be modified include an epoxy group-containing polydimethylsiloxane, an unmodified polydimethylsiloxane, and a phenyl group-containing polydimethylsiloxane, but are not limited thereto.

Preferable examples of the polyorganosiloxane as the component (B) include an epoxy group-containing polyorganosiloxane, a methyl group-containing polyorganosiloxane, and a phenyl group-containing polyorganosiloxane, but are not limited thereto.

A weight average molecular weight of the polyorganosiloxane as the component (B) is not particularly limited, but is usually 100,000 to 2,000,000, and is preferably 200,000 to 1,200,000, and more preferably 300,000 to 900,000 from a viewpoint of achieving the effects of the present invention with good reproducibility. A dispersion degree thereof is not particularly limited, but is usually 1.0 to 10.0, and preferably 1.5 to 5.0, and more preferably 2.0 to 3.0 from a viewpoint of achieving suitable release with good reproducibility. Note that the weight average molecular weight and the dispersion degree can be measured by the above-described method for the polysiloxane as the component (A).

A viscosity of the polyorganosiloxane as the component (B) is not particularly limited, but is usually 1,000 to 2,000,000 mm²/s. Note that a value of the viscosity of the polyorganosiloxane as the component (B) is expressed by kinematic viscosity, and is centistokes (cSt) = mm²/s. The value can also be determined by dividing a viscosity (mPa•s) by a density (g/cm³). That is, the value can be determined from a viscosity and a density measured with an E-type rotational viscometer at 25°C, and can be calculated from a formula: kinematic viscosity (mm²/s) = viscosity (mPa•s)/density (g/cm³).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group. R¹² is a group bonded to a silicon atom and represents an epoxy group or an organic group containing an epoxy group. Specific examples of the alkyl group include those exemplified above.

The epoxy group in the organic group containing the epoxy group may be an independent epoxy group without being fused with another ring, or may be an epoxy group forming a fused ring with another ring, such as a 1,2-epoxycyclohexyl group.

Specific examples of the organic group containing an epoxy group include 3-glycidoxypropyl and 2-(3,4-epoxycyclohexyl) ethyl, but are not limited thereto.

In the present invention, preferable examples of the epoxy group-containing polyorganosiloxane include epoxy group-containing polydimethylsiloxane, but are not limited thereto.

The epoxy group-containing polyorganosiloxane contains the above-described siloxane unit (D¹⁰ unit), but may contain the Q unit, the M unit, and/or the T unit in addition to the D¹⁰ unit.

In a preferable aspect of the present invention, specific examples of the epoxy group-containing polyorganosiloxane include a polyorganosiloxane containing only the D¹⁰ unit, a polyorganosiloxane containing the D¹⁰ unit and the Q unit, a polyorganosiloxane containing the D¹⁰ unit and the M unit, a polyorganosiloxane containing the D¹⁰ unit and the T unit, a polyorganosiloxane containing the D¹⁰ unit, the Q unit, and the M unit, a polyorganosiloxane containing the D¹⁰ unit, the M unit, and the T unit, and a polyorganosiloxane containing the D¹⁰ unit, the Q unit, the M unit, and the T unit.

The epoxy group-containing polyorganosiloxane is preferably an epoxy group-containing polydimethylsiloxane having an epoxy value of 0.1 to 5. A weight average molecular weight thereof is not particularly limited, but is usually 1,500 to 500,000, and preferably 100,000 or less from a viewpoint of suppressing precipitation in the adhesive.

Specific examples of the epoxy group-containing polyorganosiloxane include those represented by formulas (E1) to (E3), but are not limited thereto. 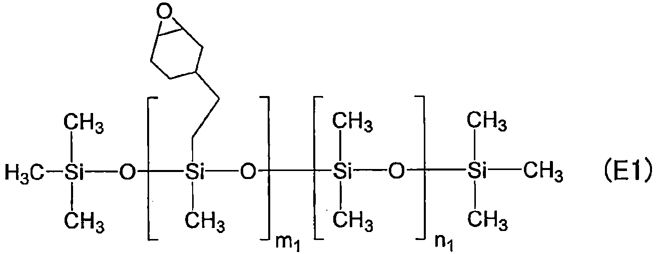 (Each of m₁ and n₁ represents the number of repeating units, and is a positive integer.) 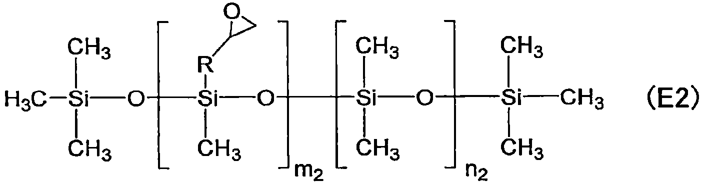 (Each of m₂ and n₂ represents the number of repeating units, and is a positive integer. R is an alkylene group having 1 to 10 carbon atoms.) 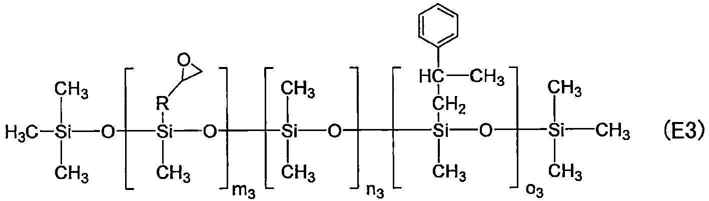 (Each of m₃, n₃, and o₃ represents the number of repeating units, and is a positive integer. R is an alkylene group having 1 to 10 carbon atoms.)

Examples of the methyl group-containing polyorganosiloxane include those containing a siloxane unit (D²⁰⁰ unit) represented by R²¹⁰R²²⁰SiO_{2/2}, and preferable examples thereof include those containing a siloxane unit (D²⁰ unit) represented by R²¹R²¹SiO_{2/2}.

R²¹⁰ and R²²⁰ are each a group bonded to a silicon atom, and each independently represent an alkyl group, but at least one of R²¹⁰ and R²²⁰ is a methyl group, and specific examples of the alkyl group include those exemplified above.

R²¹ is a group bonded to a silicon atom and represents an alkyl group, and specific examples of the alkyl group include those exemplified above. Among these groups, a methyl group is preferable as R²¹.

In the present invention, preferable examples of the methyl group-containing polyorganosiloxane include polydimethylsiloxane, but are not limited thereto.

The methyl group-containing polyorganosiloxane contains the above-described siloxane unit (D²⁰⁰ unit or D²⁰ unit), but may contain the Q unit, the M unit, and/or the T unit in addition to the D²⁰⁰ unit and the D²⁰ unit.

In an aspect of the present invention, specific examples of the methyl group-containing polyorganosiloxane include a polyorganosiloxane containing only the D²⁰⁰ unit, a polyorganosiloxane containing the D²⁰⁰ unit and the Q unit, a polyorganosiloxane containing the D²⁰⁰ unit and the M unit, a polyorganosiloxane containing the D²⁰⁰ unit and the T unit, a polyorganosiloxane containing the D²⁰⁰ unit, the Q unit, and the M unit, a polyorganosiloxane containing the D²⁰⁰ unit, the M unit, and the T unit, and a polyorganosiloxane containing the D²⁰⁰ unit, the Q unit, the M unit, and the T unit.

In a preferable aspect of the present invention, specific examples of the methyl group-containing polyorganosiloxane include a polyorganosiloxane containing only the D²⁰ unit, a polyorganosiloxane containing the D²⁰ unit and the Q unit, a polyorganosiloxane containing the D²⁰ unit and the M unit, a polyorganosiloxane containing the D²⁰ unit and the T unit, a polyorganosiloxane containing the D²⁰ unit, the Q unit, and the M unit, a polyorganosiloxane containing the D²⁰ unit, the M unit, and the T unit, and a polyorganosiloxane containing the D²⁰ unit, the Q unit, the M unit, and the T unit.

Specific examples of the methyl group-containing polyorganosiloxane include those represented by formula (M1), but are not limited thereto. 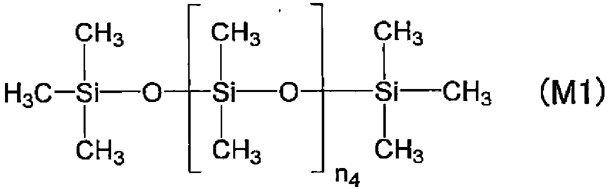 (n₄ represents the number of repeating units and is a positive integer.)

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group. R³² is a group bonded to a silicon atom and represents a phenyl group. Specific examples of the alkyl group include those exemplified above, but a methyl groups is preferable.

The phenyl group-containing polyorganosiloxane contains the above-described siloxane unit (D³⁰ unit), but may contain the Q unit, the M unit, and/or the T unit in addition to the D³⁰ unit.

In a preferable aspect of the present invention, specific examples of the phenyl group-containing polyorganosiloxane include a polyorganosiloxane containing only the D³⁰ unit, a polyorganosiloxane containing the D³⁰ unit and the Q unit, a polyorganosiloxane containing the D³⁰ unit and the M unit, a polyorganosiloxane containing the D³⁰ unit and the T unit, a polyorganosiloxane containing the D³⁰ unit, the Q unit, and the M unit, a polyorganosiloxane containing the D³⁰ unit, the M unit, and the T unit, and a polyorganosiloxane containing the D³⁰ unit, the Q unit, the M unit, and the T unit.

Specific examples of the phenyl group-containing polyorganosiloxane include those represented by formula (P1) and those represented by formula (P2), but are not limited thereto. 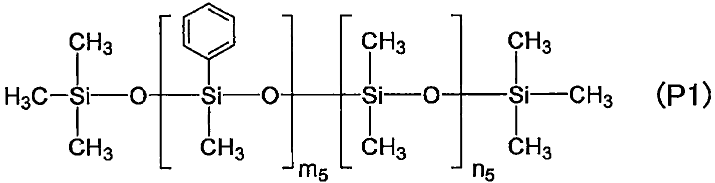 (Each of m₅ and n₅ represents the number of repeating units, and is a positive integer.) 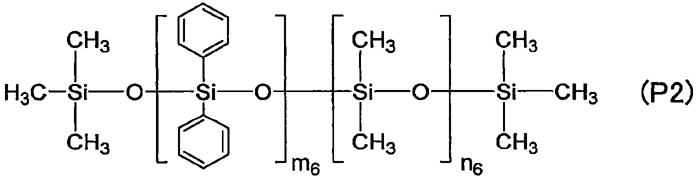 (Each of m₆ and n₆ represents the number of repeating units, and is a positive integer.)

The polyorganosiloxane as the release agent component (B) may be a commercially available product or a synthetic product.

Examples of the commercially available product of the polyorganosiloxane include: WACKERSILICONE FLUID AK series (AK 50, AK 350, AK 1000, AK 10,000, and AK 1000000) and GENIOPLAST GUM, which are products manufactured by Wacker Chemie GmbH; dimethyl silicone oil (KF-96L, KF-96A, KF-96, KF-96H, KF-69, KF-965, and KF-968) and cyclic dimethyl silicone oil (KF-995) manufactured by Shin-Etsu Chemical Co., Ltd.; an epoxy group-containing polyorganosiloxane (trade names: CMS-227 and ECMS-327) manufactured by Gelest, an epoxy group-containing polyorganosiloxane (KF-101, KF-1001, KF-1005, and X-22-343) manufactured by Shin-Etsu Chemical Co., Ltd.; an epoxy group-containing polyorganosiloxane (BY16-839) manufactured by Dow Corning; a phenyl group-containing polyorganosiloxane (PMM-1043, PMM-1025, PDM-0421, and PDM-0821) manufactured by Gelest, a phenyl group-containing polyorganosiloxane (KF50-3000CS) manufactured by Shin-Etsu Chemical Co., Ltd.; and a phenyl group-containing polyorganosiloxane (TSF431 and TSF433) manufactured by MOMENTIVE, but are not limited thereto.

In an aspect, the adhesive composition used in the present invention contains the component (B) that does not cause a curing reaction together with the curable component (A), and in another aspect, the adhesive composition contains a polyorganosiloxane as the component (B).

An example of the adhesive composition used in the present invention can contain the component (A) and the component (B) in any ratio, but the ratio between the component (A) and the component (B) is preferably 99.995 : 0.005 to 30 : 70, and more preferably 99.9 : 0.1 to 75 : 25 in mass ratio [(A) : (B)] in consideration of a balance between adhesiveness and releasability.

That is, when the polyorganosiloxane component (A') to be cured by a hydrosilylation reaction is contained, the ratio between the component (A') and the component (B) is preferably 99.995 : 0.005 to 30 : 70, and more preferably 99.9 : 0.1 to 75 : 25 in mass ratio [(A') : (B)].

A viscosity of the adhesive composition used in the present invention is not particularly limited, but is usually 500 to 20,000 mPa•s and preferably 1,000 to 1,0000 mPa•s at 25°C.

### <<Second Embodiment>>

As a preferable embodiment, the adhesive composition used in the present invention contains, for example, a curable adhesive material described below, or the curable adhesive material and a release additive.

The curable adhesive material is selected from, for example, a polyarylene oligomer, a cyclic olefin oligomer, an aryl cyclobutene oligomer, a vinyl aromatic oligomer, and a mixture thereof.

Examples of the release additive include a polyether compound.

The polyether compound preferably contains an end group selected from the group consisting of hydroxy, alkoxy, aryloxy, and a mixture thereof.

The polyether compound is preferably selected from polyethylene glycol, polypropylene glycol, poly(1,3-propanediol), polybutylene glycol, poly(tetrahydrofuran), an ethylene glycol-propylene glycol copolymer, and a mixture thereof.

The release additive is preferably selected from the group consisting of a polyalkylene oxide homopolymer and a polyalkylene oxide copolymer.

As the adhesive composition of the second embodiment, for example, a temporary bonding composition described in JP 2014-150239 A can be used.

The adhesive composition of the second embodiment will be described in more detail below.

The adhesive composition used in the present invention contains a curable adhesive material and a release additive. Usually, the curable adhesive material has a modulus of > 1 GPa when cured. Examples of the curable adhesive material include, but are not limited to, a polyarylene oligomer, a cyclic olefin oligomer, an aryl cyclobutene oligomer, a vinyl aromatic oligomer, and a mixture thereof. The curable adhesive material may have a substituent of any suitable moiety, for example, a fluorine-containing group in order to provide additional hydrophobicity as long as such a moiety does not adversely affect a mechanical characteristic of a cured adhesive material. The curable adhesive material is preferably selected from a polyarylene oligomer, a cyclic olefin oligomer, an aryl cyclobutene oligomer, a vinyl aromatic oligomer, and a mixture thereof, and more preferably selected from one or more of an aryl cyclobutene oligomer, a vinyl aromatic oligomer, and a mixture thereof. When a mixture of different curable adhesive materials is used in the present invention, the materials are selected so as to be cured with each other during a curing step. When a mixture of different curable materials is used, these curable materials are used in a mass ratio of 99 : 1 to 1 : 99, preferably 95 : 5 to 5 : 95, more preferably 90 : 10 to 10 : 90, still more preferably 75 : 25 to 25 : 75.

A wide variety of polyarylene oligomers can be used in the present invention. In a case of use in the present specification, the term "polyarylene" includes a polyarylene ether. A suitable polyarylene oligomer may be synthesized from a precursor such as an ethynyl aromatic compound of the following formula: 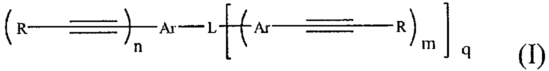 in which Ars each represent an aromatic group or an aromatic group that has been subjected to inert substitution, Rs each independently represent hydrogen, alkyl, aryl, or an alkyl or aryl group that has been subjected to inert substitution, L represents a covalent bond or a group linking one Ar to at least one other Ar, n and m are integers of at least 2, and q is an integer of at least 1. As such, the ethynyl aromatic compound usually has four or more ethynyl groups (for example, tetraethynyl aromatic compound).

A suitable polyarylene oligomer used in the temporary bonding composition as the adhesive composition of the second embodiment may contain a polymer containing the following as a polymerization unit: 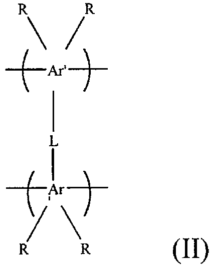 in which Ar' represents a residue of a (C≡C)n-Ar or Ar-(C≡C)m moiety of a reaction product, and R, L, n, and m are as defined above. A polyarylene copolymer useful in the present invention contains a monomer having the following formula as a polymerization unit: 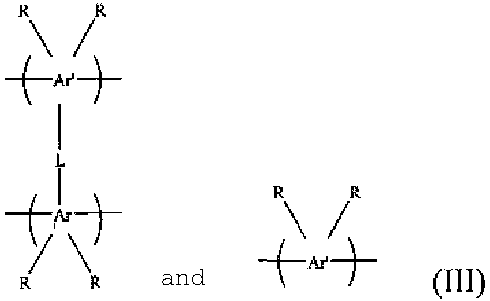 in which Ar' and R are as defined above.

Examples of the polyarylene include a polyarylene in which Ar-L-Ar is biphenyl, 2,2-diphenylpropane, 9,9'-diphenylfluorene, 2,2-diphenylhexafluoropropane, diphenyl sulfide, oxydiphenylene, diphenyl ether, bis(phenylene) diphenylsilane, bis(phenylene) phosphine oxide, bis(phenylene) benzene, bis(phenylene) naphthalene, bis(phenylene) anthracene, thiodiphenylene, 1,1,1-triphenylene ethane, 1,3,5-triphenylenebenzene, 1,3,5-(2-phenylene-2-propyl) benzene, 1,1,1-triphenylene methane, 1,1,2,2-Tetraphenylene-1,2-diphenylethane, bis(1,1-diphenyleneethyl) benzene, 2,2'-diphenylene-1,1,1,3,3,3 hexafluoropropane, 1,1-diphenylene-1-phenylethane, naphthalene, anthracene, or bis(phenylene) naphthacene, and more preferable examples of the polyarylene include a polyarylene in which Ar-L-Ar is biphenylene, naphthylene, p,p'-(2,2-diphenylenepropane) (or C₆H₄-C(CH₃)₂-C₆H₄-), p,p'-(2,2-diphenylene-1,1,1,3,3,3 hexafluoropropene), or (-C₆H₄-C(CF₃)₂-C₆H₄-), but are not limited thereto. Examples of a useful bisphenyl derivative include 2,2-diphenylpropane, 9,9'-diphenylfluorene, 2,2-diphenylhexafluoropropane, diphenyl sulfide, diphenyl ether, bis(phenylene) diphenylsilane, bis(phenylene) phosphine oxide, bis(phenylene) benzene, bis(phenylene) naphthalene, bis(phenylene) anthracene, and bis(phenylene) naphthacene.

The polyarylene precursor monomer may be prepared by various methods known in the art, for example, through a step (a) of selectively halogenating, preferably brominating a polyphenol (preferably a bisphenol) in a solvent (in which each phenolic ring is halogenated with one halogen at one of two positions ortho to a phenolic hydroxyl group); a step (b) of converting the phenolic hydroxyl on the obtained poly(ortho-halophenol) to a leaving group which is reactive with and replaced with an end ethynyl compound, such as a sulfonate ester (for example, a trifluoromethanesulfonate ester prepared from a trifluoromethanesulfonyl halide or a trifluoromethanesulfonic anhydride) preferably in a solvent; and a step (c) of causing the reaction product of step (b) to react with an ethynyl-containing compound or ethynyl synthone in the presence of an arylethynylation catalyst, preferably a palladium catalyst and an acid acceptor to replace the halogen and the trifluoromethyl sulfonate simultaneously with an ethynyl-containing group (for example, acetylene, phenylacetylene, phenylacetylene that has been subjected to substitution, or acetylene that has been subjected to substitution). A further description of this synthesis is provided by WO 97/10193 (Babb).

The ethynyl aromatic monomer of formula (I) is useful for preparing a polymer of either formula (II) or (III). Polymerization of the ethynyl aromatic monomer is sufficiently within capability of a person skilled in the art. Specific conditions of the polymerization depend on a variety of factors including (one or more) specific ethynyl aromatic monomers to be polymerized and desired characteristics of a polymer to be obtained, but general conditions of the polymerization are described in detail in WO 97/10193 (Babb).

Examples of a polyarylene particularly suitable for use in the present invention include those sold as a SiLK (trademark) semiconductor dielectric (available from Dow Electronic Materials in Malborough, MA). Examples of other particularly suitable polyarylenes include those disclosed in WO 00/31183 A, WO 98/11149 A, WO 97/10193 A, WO 91/09081 A, EP 755957 A, U.S. Pat. No. 5,115,082.; U.S. Pat. No. 5,155,175; U.S. Pat. No. 5,179,188; U.S. Pat. No. 5,874,516; and U.S. Pat. No. 6,093,636.

A suitable cyclic olefin material is a poly(cyclic olefin), which may be thermoplastic and may have a weight average molecular weight (Mw) of preferably 2000 to 200,000 Da, more preferably 5000 to 100,000 Da, still more preferably 2000 to 50,000 Da. A preferable poly(cyclic olefin) has a softening temperature (melt viscosity at 3,000 PaS) of at least 100°C, more preferably at least 140°C. A suitable poly(cyclic olefin) has a glass transition temperature (Tg) of preferably at least 60°C, more preferably 60 to 200°C, most preferably 75 to 160°C.

A preferable poly(cyclic olefin) contains a repeating monomer of a cyclic olefin and an acyclic olefin, or a ring-opened polymer based on a cyclic olefin. A suitable cyclic olefin for use in the present invention is selected from a norbornene-based olefin, a tetracyclododecene-based olefin, a dicyclopentadiene-based olefin, a Diels-Alder polymer such as those derived from furan and maleimide, and derivatives thereof. Examples of the derivatives include derivatives that have been subjected to substitution with an alkyl (preferably a C₁-C₂₀ alkyl, more preferably a C₁-C₁₀ alkyl), an alkylidene (preferably a C₁-C₂₀ alkylidene, more preferably a C₁-C₁₀ alkylidene), an aralkyl (preferably a C₆-C₃₀ aralkyl, more preferably a C₆-C₁₈ aralkyl), a cycloalkyl (preferably a C₃-C₃₀ cycloalkyl, more preferably a C₃-C₁₈ cycloalkyl), ether, acetyl, aromatic, ester, hydroxy, alkoxy, cyano, amide, imide, and silyl. Particularly preferable examples of the cyclic olefin for use in the present invention include those selected from the following and combinations thereof: 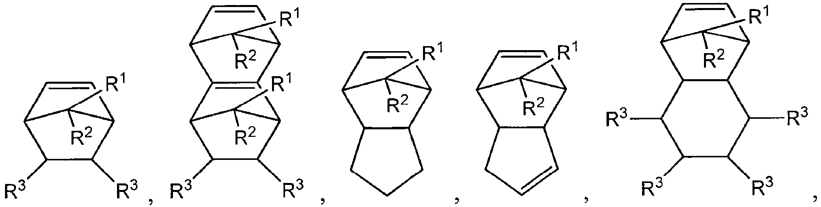 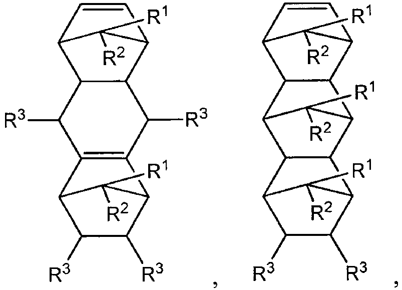 in which R¹s and R²s are each independently selected from H and an alkyl group (preferably a C₁-C₂₀ alkyl, more preferably a C₁-C₁₀ alkyl), and R³s are each independently selected from H and aryl groups (preferably a C₆-C₁₈ aryl) that have been subjected to substitution and have not been subjected to substitution, an alkyl group (preferably a C₁-C₂₀ alkyl, more preferably a C₁-C₁₀ alkyl), a cycloalkyl group (preferably a C₃-C₃₀ cycloalkyl group, more preferably a C₃-C₁₈ cycloalkyl group), an aralkyl group (preferably a C₆-C₃₀ aralkyl, more preferably a C₆-C₁₈ aralkyl group such as benzyl, phenethyl, or phenylpropyl), an ester group, an ether group, an acetyl group, an alcohol (preferably a C₁-C₁₀ alcohol), an aldehyde group, a ketone, a nitrile, and combinations thereof.

A preferable acyclic olefin is selected from branched and unbranched C₂-C₂₀ alkenes (preferably C₂-C₁₀ alkenes). More preferably, the acyclic olefin has a structure (R⁴)₂C=C(R⁴)₂, in which R⁴s are each independently selected from H and an alkyl group (preferably a C₁-C₂₀ alkyl, more preferably a C₁-C₁₀ alkyl). Examples of a particularly preferable acyclic olefin for use in the present invention include those selected from ethene, propene, and butene, and ethene is most preferable.

A method for manufacturing a cyclic olefin copolymer is known in the art. For example, the cyclic olefin copolymer can be manufactured by chain polymerization of a cyclic monomer and an acyclic monomer. When norbornene reacts with ethene under such a condition, an ethenenorbornene copolymer alternately containing norbornanediyl and an ethylene unit is obtained. Examples of a copolymer manufactured by this method include those available under TOPAS (trademark) (manufactured by Topas Advanced Polymers) brand and APEL (trademark) (manufactured by Mitsui Chemicals, Inc.) brand. A suitable method for manufacturing these copolymers is disclosed in U.S. Patent No. 6,008,298. A cycloolefin copolymer can be manufactured by ring-opening metathesis polymerization of various cyclic monomers followed by hydrogenation. A polymer obtained from this type of polymerization can be conceptually considered as a copolymer of ethene and a cyclic olefin monomer (such as alternating units of ethylene and cyclopentane-1,3-diyl). Examples of a copolymer manufactured by this ring opening method include those provided under ZEONOR (trademark) (from Zeon Chemicals) brand and ARTON (trademark) (manufactured by JSR Corporation) brand. A suitable method for manufacturing these copolymers by this ring opening method is disclosed in U.S. Patent No. 5,191,026.

An aryl cyclobutene oligomer useful as the curable adhesive material of the present invention is well known in the art. Examples of a suitable aryl cyclobutene oligomer include, but are not limited to, those having the following formula: 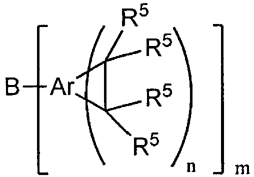 in which B represents an n-valent linking group, Ar represents a polyvalent aryl group, a carbon atom of a cyclobutene ring is bonded to an adjacent carbon atom on the same aromatic ring of Ar, m is an integer of 1 or more, n is an integer of 1 or more, and R⁵ represents a monovalent group. The polyvalent aryl group Ar may be preferably constituted by 1 to 3 aromatic carbocyclic or heteroaromatic rings. The aryl group preferably contains a single aromatic ring, more preferably a phenyl ring. The aryl group is optionally subjected to substitution with one to three groups selected from (C₁-C₆) alkyl, a tri(C₁-C₆) alkylsilyl, (C₁-C₆) alkoxy, and halo, preferably subjected to substitution with one or more of (C₁-C₆) alkyl, a tri(C₁-C₃) alkylsilyl, (C₁-C₃) alkoxy, and chloro, and more preferably subjected to substitution with one or more of (C₁-C₃) alkyl, a tri(C₁-C₃) alkylsilyl, and (C₁-C₃) alkoxy. Preferably, the aryl group has not been subjected to substitution. n = 1 or 2 is preferable, and n = 1 is more preferable. m = 1 to 4 is preferable, m = 2 to 4 is more preferable, and m = 2 is still more preferable. R⁵ is preferably selected from H and (C₁-C₆) alkyl, and more preferably selected from H and (C₁-C₃) alkyl. B preferably contains one or more carbon-carbon double bonds (ethylenically unsaturated). A suitable monovalent B group preferably has a formula -[C(R¹⁰)=CR¹¹]xZ, in which R¹⁰ and R¹¹ are each independently selected from hydrogen, (C₁-C₆) alkyl and an aryl, Z is selected from hydrogen, (C₁-C₆) alkyl, an aryl, a siloxanyl, and -CO₂R¹², R¹²s are each independently selected from H, (C₁-C₆) alkyl, an aryl, an aralkyl, and an alkaryl, and x = 1 or 2. R¹⁰ and R¹¹ are preferably each independently selected from H, (C₁-C₃) alkyl, and an aryl, and more preferably selected from H and (C₁-C₃) alkyl. R¹² is preferably (C₁-C₃) alkyl, an aryl, or an aralkyl. Z is preferably a siloxyl. A preferable siloxyl group has a formula - [Si(R¹³)₂-O]p-Si(R¹³)₂-, in which R¹³s are each independently selected from H, (C₁-C₆) alkyl, an aryl, an aralkyl, and an alkaryl, and p is an integer of 1 or more. R¹³ is selected from (C₁-C₃) alkyl, an aryl, and an aralkyl. Examples of a suitable aralkyl group include benzyl, phenethyl, and phenylpropyl.

The aryl cyclobutene oligomer preferably contains one or more oligomers of the following formula: 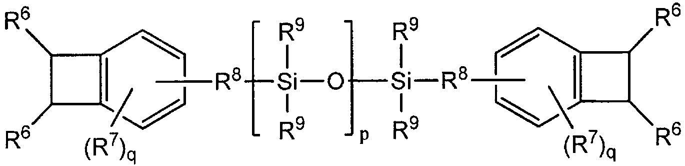 in which R⁶s are each independently selected from H and (C₁-C₆) alkyl, and preferably selected from H and (C₁-C₃) alkyl, R⁷s are each independently selected from (C₁-C₆) alkyl, a tri(C₁-C₆) alkylsilyl, (C₁-C₆) alkoxy, and halo, R⁸s each independently represent a divalent ethylenically unsaturated organic group, R⁹s are each independently selected from H, (C₁-C₆) alkyl, an aralkyl, and a phenyl, p is an integer of 1 or more, and q is an integer of 0 to 3. R⁶s are each independently selected from H and (C₁-C₃) alkyl, and more preferably each represent H. R⁷s are preferably each independently selected from (C₁-C₆) alkyl, a tri(C₁-C₃) alkylsilyl, (C₁-C₃) alkoxy, and chloro, and more preferably each independently selected from (C₁-C₃) alkyl, a tri(C₁-C₃) alkylsilyl, and (C₁-C₃) alkoxy. R⁸s are preferably each independently selected from (C₂-C₆) alkenyls, and more preferably each represent -CH=CH-. R⁹s are preferably each selected from (C₁-C₃) alkyls, and more preferably each represent methyl. p = 1 to 5 is preferable, p = 1 to 3 is more preferable, and p = 1 is still more preferable. q = 0 is preferable. A particularly preferable aryl cyclobutene oligomer, 1,3-bis(2-bicyclo [4.2.0] octa-1,3,5-trien-3-ylethenyl)-1,1,3,3-tetramethyldisiloxane ("DVS-bisBCB") has the following formula:

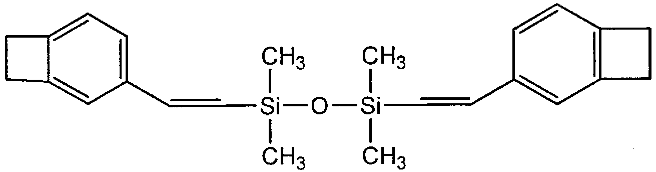

The arylcyclobutene oligomer may be prepared by any suitable means, for example by those described in U.S. Patent No. 4,812,588, U.S. Pat. No. 5,136,069, U.S. Pat. No. 5,138,081 and WO 94/25903 A. A suitable aryl cyclobutene oligomer is also commercially available under CYCLOTENE (trademark) brand available from Dow Electronic Materials. The aryl cyclobutene oligomer may be used as it is or may be further purified by any suitable means.

A curable vinyl aromatic oligomer can be used as the curable adhesive material in the present invention. Such a vinyl aromatic oligomer is usually an oligomer of one or more reactive ethylenically unsaturated comonomers and a vinyl aromatic monomer. The vinyl aromatic monomer preferably contains one vinyl group. The suitable vinyl aromatic monomer is a vinyl aromatic monomer that has not been subjected to substitution or a vinyl aromatic monomer that has been subjected to substitution, in which one or more hydrogen atoms are replaced with a substituent selected from the group consisting of (C₁-C₆) alkyl, (C₁-C₆) alkoxy, halo, and amino. Examples of the vinyl aromatic monomer include, but are not limited to, styrene, vinyltoluene, vinylxylene, vinylanisole, vinyldimethoxybenzene, vinylaniline, a halostyrene such as fluorostyrene, α-methylstyrene, β-methoxystyrene, ethylvinylbenzene, vinylpyridine, vinylimidazole, vinylpyrrole, and a mixture thereof. Preferable vinyl aromatic monomers are styrene, vinyl toluene, vinyl xylene, vinyl anisole, ethyl vinyl benzene, and a mixture thereof. A preferable reactive comonomer contains, in addition to an olefin (or ethylenically unsaturated) moiety used to form a vinyl aromatic oligomer, a reactive moiety, that is, a moiety which can be further polymerized (or crosslinked) after formation of the vinyl aromatic oligomer, for example, an ally moiety or a vinyl group. Such a reactive comonomer may be suitably any asymmetric diene or triene that can be further polymerized by a Diels-Alder reaction after oligomerization with a vinyl aromatic monomer. The reactive comonomer more preferably contains an allyl moiety in addition to an ethylenic unsaturation used to form a vinyl aromatic oligomer, and still more preferably contains an allyl ester moiety in addition to this ethylenic unsaturation. Examples of the reactive comonomer useful for forming a vinyl aromatic oligomer include vinyl cyclohexene, vinyl ether, an asymmetric diene or triene such as a terpene monomer, dicyclopentadiene, diallyl maleate, allyl acrylate, allyl methacrylate, allyl cinnamate, diallyl fumarate, allyl tigrate, or divinylbenzene, and a mixture thereof, but are not limited thereto. Preferable reactive comonomers are diallyl maleate, allyl acrylate, allyl methacrylate, allyl cinnamate, diallyl fumarate, and a mixture thereof, and more preferable reactive comonomers are diallyl maleate, allyl methacrylate, and a mixture thereof. Examples of the terpene monomer include, but are not limited to, limonene, dipentene, and myrcene. A person skilled in the art will understand that one or more second comonomers may be used to form a vinyl aromatic oligomer. Such a second comonomer is ethylenically unsaturated but does not contain a reactive moiety. Examples of the second comonomer include (meth)acrylic acid, (meth)acrylamide, (C1-C10) alkyl (meth)acrylate, aromatic (meth)acrylate, an ethylene monomer that has been subjected to substitution, and a poly (alkylene oxide) monomer, but are not limited thereto.

A molar ratio of vinyl aromatic monomer : comonomer in such a vinyl aromatic oligomer is preferably 99 : 1 to 1 : 99, more preferably 95 : 5 to 5 : 95, and still more preferably 90 : 10 to 10 : 90. Such a vinyl aromatic oligomer may be prepared by any suitable method, for example, by any method known in the art. A vinyl aromatic oligomer is usually prepared by free radical polymerization of a vinyl aromatic monomer and a comonomer. A preferable vinyl aromatic oligomers contains an unreacted allyl moiety capable of further curing such an oligomer.

A wide variety of materials may be used as the release additive in the temporary bonding composition, but these materials do not react with the adhesive material under conditions of storage and use, and are non-curable under conditions used to cure the adhesive material. In addition, the release additive should be compatible with the temporary bonding composition. That is, the release additive needs to be dispersible, miscible, or otherwise substantially compatible with the adhesive material and any other component used in the temporary bonding composition, such as an organic solvent. When an organic solvent (or mixed solvent system) is used in the temporary bonding composition, the release additive and the curable adhesive material need to be soluble in such a solvent. The release additive in the present invention is sufficiently non-volatile such that the release additive does not substantially evaporate under conditions of use. That is, the release additive does not substantially evaporate during a deposition step, for example, spin coating, or any subsequent heating step used to remove an organic solvent or to cure the adhesive material. When a film or a layer of the temporary bonding composition is cast, for example, by spin coating, many (or all) solvents evaporate. Preferably, the release additive is soluble in any organic solvent used, but is not completely soluble in the curable adhesive material. The release additive is more hydrophilic than the cured adhesive material. Without being bound by theory, it is considered that when the adhesive material is cured, a release additive phase is separated and preferentially moves toward an active surface of a wafer (a surface that is more hydrophilic than a carrier surface). Use of a suitable hydrophilic moiety in the release additive allows complete dispersion, or preferably dissolution, of the release additive in the temporary bonding composition and allows phase separation of the release additive during curing of the adhesive material with movement of the release additive toward the more hydrophilic surface. Any material that is not phaseseparated from the adhesive material during curing does not function as the release additive according to the present invention.

In general, the release additive may contain one or more relatively hydrophilic moieties such as one or more moieties containing oxygen, nitrogen, phosphorus, and sulfur. Examples of a suitable release additive include, but are not limited to, an ether, an ester, a carboxylate, an alcohol, a thioether, a thiol, an amine, an imine, an amide, a phosphate ester, a sulfonate ester, and a mixture thereof. The release additive preferably contains one or more polar end groups, which contain one or more of oxygen, nitrogen, and sulfur, and preferably contain oxygen. Examples of the polar end group include alkoxy, aryloxy, hydroxy, carboxylate, alkoxycarbonyl, mercapto, alkylthio, primary amine, secondary amine, and tertiary amine. A preferable end group is selected from (C₁-C₆) alkoxy, (C₆-C₁₀) aryloxy, hydroxy, carboxylate, (C₁-C₆) alkoxycarbonyl, mercapto, (C₁-C₆) alkylthio, amino, (C₁-C₆) alkylamino, and a di(C₁-C₆) alkya lamino. A more preferable end group is selected from (C₁-C₆) alkoxy, (C₆-C₁₀) aryloxy, hydroxy, carboxylate, and (C₁-C₆) alkoxycarbonyl. A still more preferable end group is selected from (C₁-C₆) alkoxy, hydroxy, a carboxylate, and (C1-C6) alkoxycarbonyl. A particularly preferable polar end group is selected from hydroxy, methoxy, ethoxy, propoxy, butoxy, carboxyl, and acetoxy. Preferably, the release additive does not contain silicon.

A suitable release additive has a number average molecular weight (Mn) of ≤ 10,000 Da, preferably ≤ 7500 Da, more preferably ≤ 7000 Da. The release additive has a minimum molecular weight (Mn) sufficient to render the release additive substantially non-volatile (that is, < 5%, preferably < 3%, more preferably ≤ 1% of the release additive volatilizes during use) during a condition of use. The release additive preferably has Mn of ≥ 500 Da. A preferable range of Mn is 500 to 10,000 Da, a more preferable range of Mn is 500 to 7500 Da, and a still more preferable range of Mn is 500 to 7000 Da. The release additive may be a linear polymer, a branched polymer such as a dendritic polymer or a star-like polymer, a polymer particle, or the like, but is preferably a linear polymer or a polymer particle, and more preferably a linear polymer. Without being bound by theory, it is considered that a linear polymer can move more favorably through a curing adhesive material phase toward a hydrophilic wafer surface as compared with a branched polymer.

A polyether is a preferable release additive. Examples of a polyether compound include an alkylene oxide homopolymer and an alkylene oxide copolymer, which may be random copolymers or block copolymers. The polyalkylene oxide release additive may have a variety of polar end groups. Such a polar end group is preferably hydroxy, (C₁-C₆) alkoxy, or (C₁-C₆) alkoxycarbonyl, and more preferably hydroxy, (C₁-C₃) alkoxy, or acetoxy. Preferable examples of the polyether compound include a polyglycol (or a polyalkylene oxide) such as a poly (C₁-C₄) alkylene oxide compound, which may contain one alkylene oxide repeating unit or two or more different alkylene oxide repeating units. Preferable examples of the polyether compound include polyethylene glycol, polypropylene glycol, poly(1,3-propanediol), poly(tetrahydrofuran), an ethylene oxide-propylene oxide copolymer, an ethylene oxide-butylene oxide copolymer, and a mixture thereof. Preferably, when the release additive contains butylene oxide as a repeating unit, the release additive is a copolymer with one or more different alkylene oxide repeating units. A person skilled in the art will understand that a mixture of the release additive may be used in the temporary bonding composition of the present invention. Examples of a suitable release additive include polyethers sold under product names PLURONIC (registered trademark), TETRONIC, and POLYTHF (available from BASF, Ludwigshafen, Germany), a product name FORTEGRA (The Dow Chemical Company, Midland, Michigan), and a product name TERATHANE (available from Invista, Wichita, Kansas), all of which can be used without being further purified.

### <<Third Embodiment>>

As a preferable embodiment, the adhesive composition used in the present invention contains, for example, a thermosetting polymer described below.

As the adhesive composition of the third embodiment, for example, a thermosetting polymer described in JP 6528747 B2 can be used.

The thermosetting polymer is not particularly limited, but preferable examples thereof include a siloxane bond-containing polymer (hereinafter, also referred to as silicone A) having a weight average molecular weight of 3,000 to 500,000 and containing a repeating unit represented by the following formula (3) and, as necessary, containing a repeating unit represented by the following formula (4). 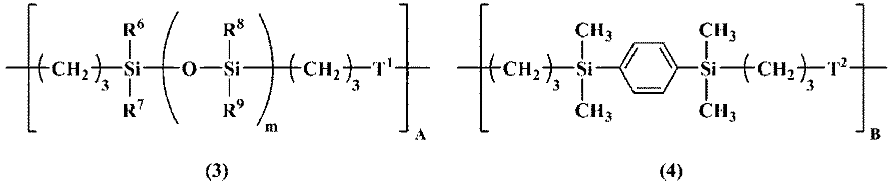 [in which R⁶ to R⁹ each independently represent a monovalent hydrocarbon group having 1 to 8 carbon atoms. m represents an integer of 1 to 100. A and B are positive numbers satisfying 0 < A < 1, 0 < B < 1, and A + B = 1. T¹ and T² are divalent organic groups represented by the following formula (5). 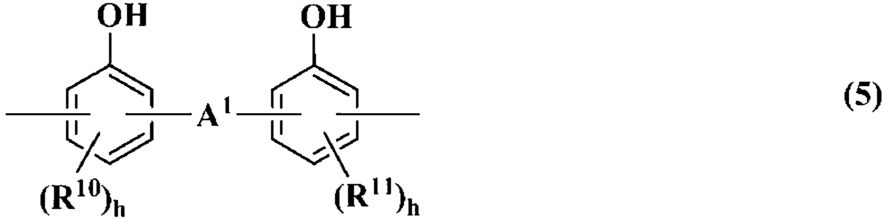 (in which A¹ is a single bond or a divalent organic group selected from groups represented by the following formulas: 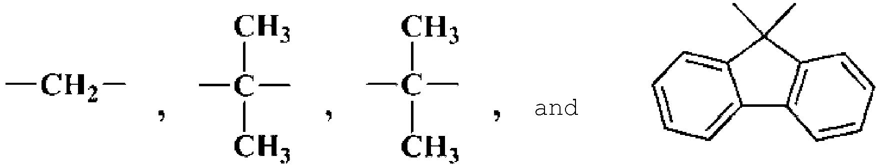 R¹⁰ and R¹¹ are each independently an alkyl group or an alkoxy group having 1 to 4 carbon atoms. hs are each independently 0, 1, or 2.)]

Examples of the monovalent hydrocarbon group represented by each of R⁶ to R⁹ include an alkyl group such as a methyl group or an ethyl group, and an aryl group such as a phenyl group. m is an integer of preferably 3 to 60, more preferably 8 to 40. A is preferably 0.3 to 0.8, B is preferably 0.2 to 0.7, and A/B satisfies preferably 0.1 to 20, more preferably 0.5 to 5.

Preferable examples of the thermosetting polymer include a siloxane bond-containing polymer (hereinafter, also referred to as silicone B) having a weight average molecular weight of 3,000 to 500,000 and containing a repeating unit represented by the following formula (6) and as necessary, a repeating unit represented by the following formula (7). 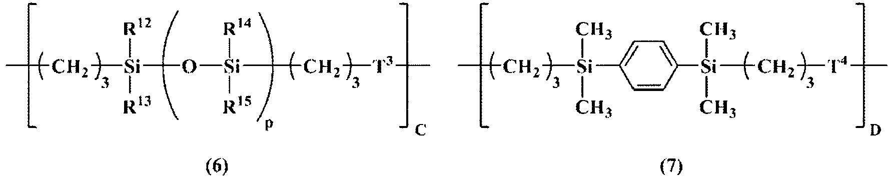 [in which R¹² to R¹⁵ each independently represent a monovalent hydrocarbon group having 1 to 8 carbon atoms. p represents an integer of 1 to 100. C and D are positive numbers satisfying 0 < C ≤ 1, 0 ≤ D < 1, and C + D = 1. T³ and T⁴ are divalent organic groups represented by the following formula (8). 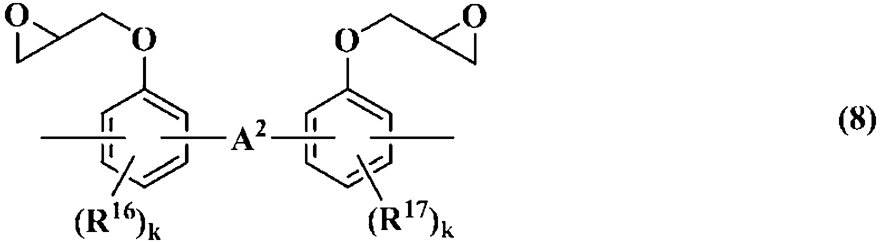 (in which A² is a single bond or a divalent organic group selected from groups represented by the following formulas: 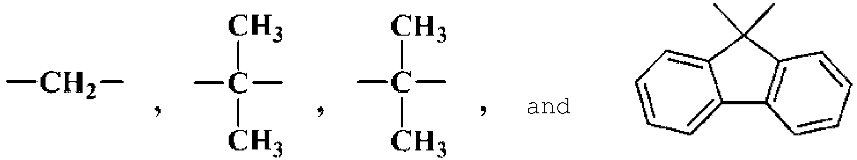 R¹⁶ and R¹⁷ are each independently an alkyl group or an alkoxy group having 1 to 4 carbon atoms. ks are each independently 0, 1, or 2.)]

In this case, examples of the monovalent hydrocarbon group represented by R¹¹ to R¹⁴ include the same groups as those exemplified as those represented by R⁵ to R⁸. p is an integer of preferably 3 to 60, more preferably 8 to 40. C is preferably 0.3 to 1, D is preferably 0 to 0.7, and C + D = 1.

An adhesive layer formed using the thermosetting polymer as the adhesive composition of the third embodiment is preferably a layer of a cured product of a thermosetting resin composition containing silicone A or silicone B as a main component. Silicone A and silicone B can be used in combination. In this case, a ratio (polymerization ratio) is preferably silicone A : silicone B = 0.1 : 99.9 to **99.9** : 0.1, and more preferably silicone A : silicone B = 20 : 80 to 80 : 20.

A thermosetting resin composition containing silicone A as a main component contains one or more crosslinking agents selected from an amino condensate modified with formalin or formalin-alcohol, a phenol compound having two or more methylol groups or alkoxymethylol groups on average in one molecule, and an epoxy compound having two or more epoxy groups on average in one molecule.

Meanwhile, a thermosetting resin composition containing silicone B as a main component contains one or more crosslinking agents selected from a phenol compound having two or more phenol groups on average in one molecule and an epoxy compound having two or more epoxy groups on average in one molecule for thermal curing thereof.

A thermosetting resin composition containing silicone A and silicone B contains one or more crosslinking agents selected from epoxy compounds each having two or more epoxy groups on average in one molecule for thermal curing thereof.

Examples of the amino condensate include a melamine resin and a urea resin. Examples of a melamine resin modified with formalin or formalin-alcohol include those obtained by addition condensation polymerization of a modified melamine monomer (for example, trimethoxymethyl monomethylol melamine) or a multimer thereof (for example, an oligomer such as a dimer or a trimer) with formaldehyde to a desired molecular weight according to a known method. Note that these can be used singly or in combination of two or more types thereof.

Examples of a urea resin modified with formalin or formalin-alcohol include a methoxymethylated urea condensate, an ethoxymethylated urea condensate, and a propoxymethylated urea condensate. Note that these can be used singly or in combination of two or more types thereof. The urea resin modified with formalin or formalin-alcohol can be prepared by, for example, modifying a urea condensate having a desired molecular weight by methylol formation with formalin or further modifying the modified product by alkoxylation with alcohol according to a known method.

Examples of the phenol compound having two or more methylol groups or alkoxymethylol groups on average in one molecule include (2-hydroxy-5-methyl)-1,3-benzenedimethanol and 2,2', 6,6'-tetramethoxymethylbisphenol A. Note that these can be used singly or in combination of two or more types thereof.

The epoxy compound having two or more epoxy groups on average in one molecule is not particularly limited, but examples thereof include a bifunctional, trifunctional, or tetrafunctional or higher polyfunctional epoxy resin such as EOCN-1020 (see the following formula), EOCN-102S, XD-1000, NC-2000-L, EPPN-201, GAN, and NC 6000 manufactured by Nippon Kayaku Co., Ltd., and compounds represented by the following formulas.

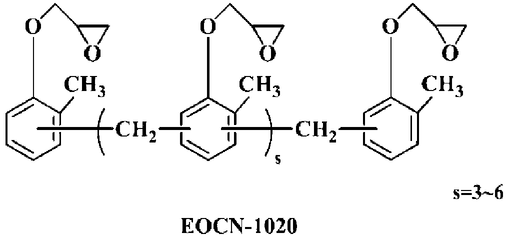

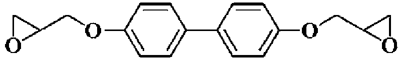

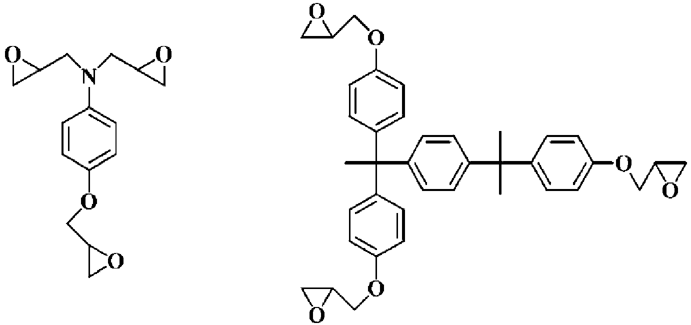

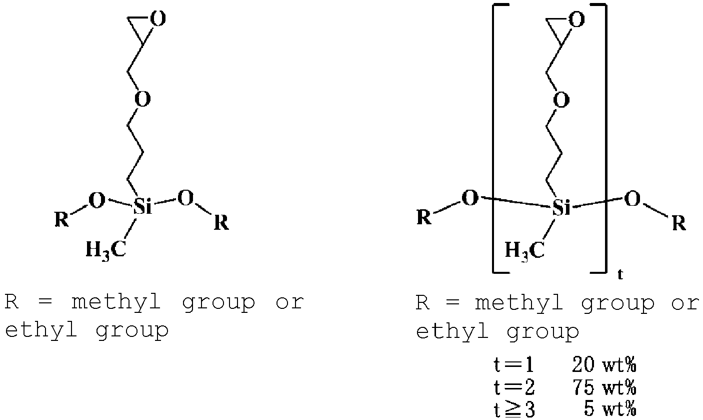

Examples of the phenol compound having two or more phenol groups on average in one molecule include a m- or p-cresol novolac resin (for example, EP-6030G manufactured by Asahi Yukizai Corporation), a trifunctional phenol compound (for example, Tris-P-PA manufactured by Honshu Chemical Industry Co., Ltd.), and a tetrafunctional phenol compound (for example, TEP-TPA manufactured by Asahi Yukizai Corporation).

A blending amount of the crosslinking agent in the thermosetting resin composition is preferably 0.1 to 50 parts by mass, more preferably 0.2 to 30 parts by mass, and still more preferably 1 to 20 parts by mass with respect to 100 parts by mass of the thermosetting polymer. The crosslinking agent can be used singly or in combination of two or more types thereof.

The thermosetting resin composition may contain a curing catalyst such as an acid anhydride in an amount of 10 parts by mass or less with respect to 100 parts by mass of the thermosetting polymer.

### <<Fourth Embodiment>>

As a preferable embodiment, the adhesive composition used in the present invention contains, for example, a compound selected from the group consisting of polymers and oligomers of imide, amideimide, and amideimide-siloxane contained in a thermoplastic composition for forming a bonding composition layer described in JP 5788173 B2.

The compound is, for example, selected from the group consisting of polymers and oligomers each having a repeating unit of at least one of the following formula (I) and the following formula (II). 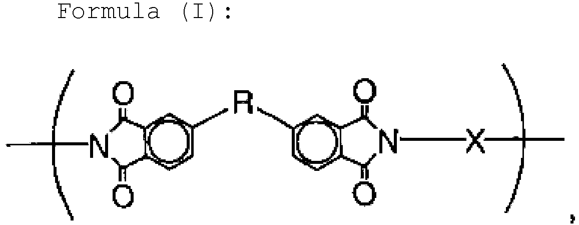 [in which R is selected from the group consisting of 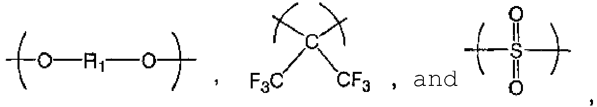 (in which R₁ is selected from the group consisting of alkyl-replaced phenyl, 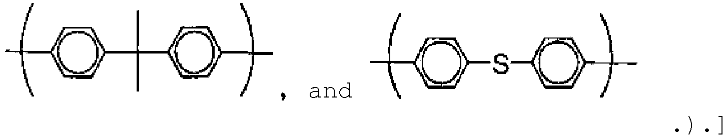 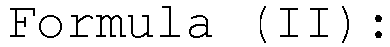 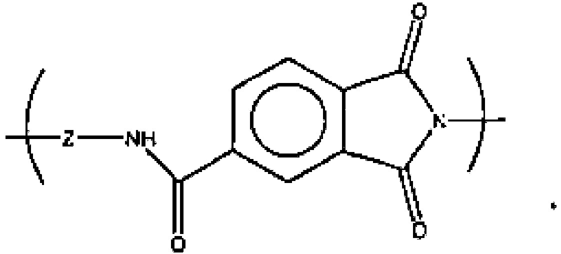 (in which Z is selected from the group consisting of a siloxane and a moiety having an ether bridge.)

A preferable alkyl-replaced phenyl is C₁-C₆ alkyl-replaced phenyl. Particularly preferable examples of the alkyl-replaced phenyl include those selected from the group consisting of

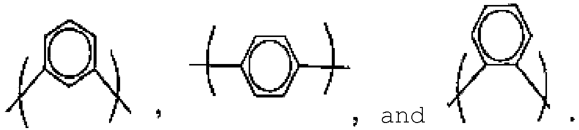

In formula (I), X is selected from the group consisting of phenyl sulfone, a (preferably C₆-C₆₀, more preferably C₆-C₃₀, still more preferably C₆-C₂₄) aromatic compound, a (preferably C₂-C₁₅, more preferably C₂-C₁₀, still more preferably C₂-C₆) aliphatic compound, and a (preferably C₄-C₆₀, more preferably C₄-C₂₀, still more preferably C₄-C₁₂) alicyclic compound.

In an embodiment, X may be the above-described aromatic group, the above-described aliphatic group, or the above-described alicyclic group. In another embodiment, X can contain an aromatic group having an ether bridge (as discussed with respect to Z) or an aromatic group having a linking group and/or a -NH₂ group in a meta position.

A particularly preferable X group is selected from the group consisting of alkyl-replaced phenyl (as described above), isopropylidenediphenyl, and hexafluoroisopropylidene.

In an embodiment where Z is a siloxane in formula (II), a preferable siloxane is represented by formula: 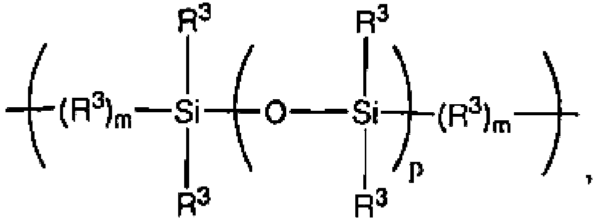 [in which R³s are each individually selected from the group consisting of hydrogen, (preferably C₁-C₁₀, more preferably C₁-C₂) alkyl, and phenyl,
m is 1 to 6,
p is 1 to 50, preferably 1 to 20, and more preferably 1 to 10.].

In formula (II), a preferable moiety having an ether bridge of Z is selected from the group consisting of 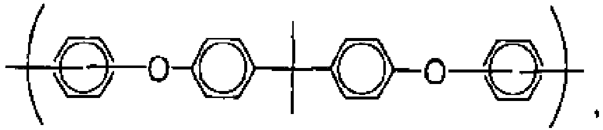 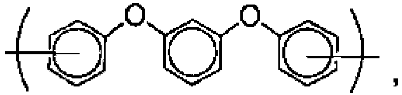 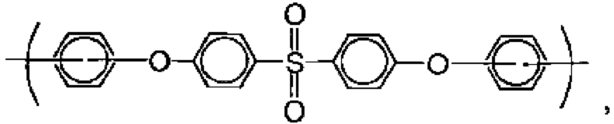 and

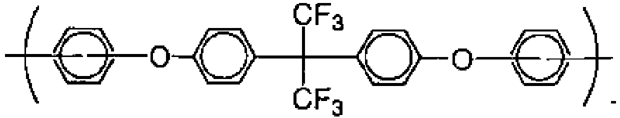

In the embodiment of formula (I) or the embodiment of formula (II), the polymer or the oligomer preferably further has an end-capping group. A preferable end-capping group is derived from a compound selected from the group consisting of an aromatic monoamine, an aliphatic monoamine, an alicyclic monoamine, and phthalic anhydride. A particularly preferable end-capping group has a group selected from the group consisting of (preferably C₁-C₁₅, more preferably C₁-C₁₀, still more preferably C₁-C₆) alkyl, 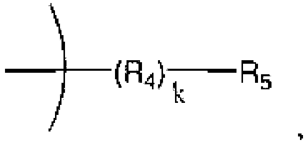 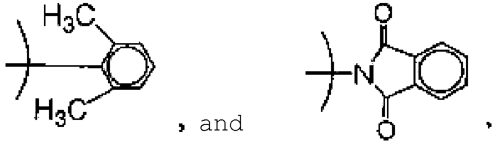 [in which R₄ is a (preferably C₁-C₁₅, more preferably C₁-C₁₀, still more preferably C₁-C₆) alkyl, R₅ is a (preferably C₃-C₁₂, more preferably C₅-C₆) alicyclic group, and
k is 0 to 20, preferably 0 to 10, and more preferably 0 to 5.]

A polymer or an oligomer compound of imide, amideimide, and amide-imide-siloxane is thermoplastic and has a weight average molecular weight of preferably about 3000 Da to about 300,000 Da, more preferably about 6000 Da to about 50,000 Da. A preferable compound has a softening temperature (at a melt viscosity of 3000 Pa•s) of preferably at least about 150°C, more preferably at least about 200°C, still more preferably about 200°C to about 250°C.

The adhesive composition used in the present invention may contain a solvent for the purpose of adjusting a viscosity, and specific examples thereof include an aliphatic hydrocarbon, an aromatic hydrocarbon, and a ketone, but are not limited thereto.

More specific examples of the solvent include hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone, but are not limited thereto. Such a solvent can be used singly or in combination of two or more types thereof.

When the adhesive composition used in the present invention contains a solvent, the content thereof is appropriately determined in consideration of a desired viscosity of the composition, a coating method to be adopted, the thickness of a film to be prepared, and the like, but is in a range of about 10 to 90% by mass with respect to the entire composition.

A viscosity of the adhesive composition used in the present invention is not particularly limited, but is usually 500 to 20,000 mPa•s and preferably 1,000 to 5,000 mPa•s at 25°C. The viscosity of the adhesive composition used in the present invention can be adjusted by changing the type of a solvent to be used, a ratio thereof, the concentrations of film constituent components, and the like in consideration of various factors such as a coating method to be used and a desired film thickness.

An example of the adhesive composition used in the present invention can be manufactured by mixing the component (A), the component (B) when used, and a solvent.

A mixing order therefor is not particularly limited, but examples of a method by which the adhesive composition can be easily manufactured with good reproducibility include: a method for dissolving the component (A) and the component (B) in a solvent; and a method for dissolving a part of the component (A) and the component (B) in a solvent, dissolving the rest in a solvent, and mixing the obtained solutions, but are not limited thereto. Note that when the adhesive composition is prepared, heating may be appropriately performed as long as the components are not decomposed or altered.

In the present invention, for the purpose of removing foreign substances, a solvent, a solution, and the like to be used may be filtered using a filter or the like during manufacture of the adhesive composition or after all the components are mixed.

The thickness of the adhesive layer included in the laminate of the present invention is not particularly limited, but is usually 5 to 500 µm, preferably 10 µm or more, more preferably 20 µm or more, and still more preferably 30 µm or more from a viewpoint of maintaining a film strength, and is preferably 200 µm or less, more preferably 150 µm or less, still more preferably 120 µm or less, and further still more preferably 70 µm or less from a viewpoint of avoiding nonuniformity caused by a thick film.

The laminate of the present invention is suitably manufactured, for example, by the following method for manufacturing a laminate of the present invention.

Hereinafter, an example of the laminate will be described with reference to the drawings.

Fig. 1 is a schematic cross-sectional view of an example of the laminate.

The laminate of Fig. 1 includes a semiconductor substrate 1, an adhesive layer 2, a release layer 3, and a support substrate 4 in this order.

The adhesive layer 2 and the release layer 3 are disposed between the semiconductor substrate 1 and the support substrate 4. The adhesive layer 2 is in contact with the semiconductor substrate 1. The release layer 3 is in contact with the adhesive layer 2 and the support substrate 4.

### <Method for manufacturing laminate>

The laminate of the present invention can be manufactured, for example, by a method including: a first step of applying an adhesive composition to a surface of a semiconductor substrate and, if necessary, heating the adhesive composition to form an adhesive coating layer; a second step of applying a release agent composition to a surface of a support substrate and, if necessary, heating the release agent composition to form a release agent coating layer; and a third step of bringing the adhesive coating layer of the semiconductor substrate and the release agent coating layer of the support substrate into close contact with each other by applying a load in a thickness direction of the semiconductor substrate and the support substrate while performing at least one of a heating treatment and a decompression treatment, and then performing a post-heating treatment to form a laminate.

In addition, the laminate of the present invention can be manufactured, for example, by a method including: a first step of applying a release agent composition to a surface of a semiconductor substrate and, if necessary, heating the release agent composition to form a release agent coating layer; a second step of applying an adhesive composition to a surface of a support substrate and, if necessary, heating the adhesive composition to form an adhesive coating layer; and a third step of bringing the release agent coating layer of the semiconductor substrate and the adhesive coating layer of the support substrate into close contact with each other by applying a load in a thickness direction of the semiconductor substrate and the support substrate while performing at least one of a heating treatment and a decompression treatment, and then performing a post-heating treatment to form a laminate.

Note that as long as the effect of the present invention is not impaired, coating and heating of the compositions may be sequentially performed on either one of the substrates.

The coating method is not particularly limited, but is usually a spin coating method. Note that a method for separately forming a coating film by a spin coating method or the like and attaching the sheet-like coating film as an adhesive coating layer or a release agent coating layer can be adopted.

A heating temperature of the applied adhesive composition varies depending on the type and amount of an adhesive component contained in the adhesive composition, whether or not a solvent is contained, a boiling point of a solvent used, a desired thickness of the adhesive layer, and the like, and thus cannot be generally specified, but is usually 80 to 150°C, and heating time thereof is usually 30 seconds to five minutes.

When the adhesive composition contains a solvent, the applied adhesive composition is usually heated.

A heating temperature of the applied release agent composition varies depending on the type and amount of an acid generator, a boiling point of a solvent used, a desired thickness of the release layer, and the like, and thus cannot be generally specified, but is 80°C or higher from a viewpoint of achieving a suitable release layer with good reproducibility, and is 300°C or lower from a viewpoint of suppressing decomposition of the acid generator and the like, and heating time thereof is usually determined appropriately in a range of ten seconds to ten minutes depending on the heating temperature.

When the release agent composition contains a solvent, the applied release agent composition is usually heated.

Heating can be performed using a hot plate, an oven, or the like.

The film thickness of the adhesive coating layer obtained by applying the adhesive composition and, if necessary, heating the adhesive composition is usually about 5 to 500 µm, and is appropriately determined so as to finally fall within the above-described range of the thickness of the adhesive layer.

The film thickness of the release layer coating layer obtained by applying the release agent composition and, if necessary, heating the release agent composition is usually about 5 nm to 100 µm, and is appropriately determined so as to finally fall within the above-described range of the thickness of the adhesive layer.

In the present invention, the laminate of the present invention can be obtained by superimposing such coating layers so as to be in contact with each other, applying a load in a thickness direction of the semiconductor substrate and the support substrate to bring the two layers into close contact with each other while performing a heating treatment and/or a decompression treatment, and then performing a post-heating treatment. Note that which treatment condition is adopted among the heating treatment, the decompression treatment, and a combination thereof is appropriately determined in consideration of various circumstances such as the type of the adhesive composition, the specific composition of the release agent composition, compatibility between films obtained from these compositions, the film thicknesses thereof, and a required adhesive strength.

When a solvent is contained in the composition, the heating treatment is appropriately determined usually from a range of 20 to 150°C from a viewpoint of removing the solvent and from a viewpoint of softening the adhesive coating layer to suitably bond the adhesive coating layer to the release agent coating layer. In particular, the heating temperature is preferably 130°C or lower, and more preferably 90°C or lower from a viewpoint of suppressing or avoiding excessive curing and unnecessary alteration of the adhesive component (A). Heating time thereof is appropriately determined depending on the heating temperature and the type of the adhesive, but is usually 30 seconds or more, and preferably one minute or more from a viewpoint of reliably achieving suitable bonding, and is usually ten minutes or less, and preferably five minutes or less from a viewpoint of suppressing alteration of the adhesive layer and other members.

In the decompression treatment, the adhesive coating layer and the release agent coating layer in contact with each other only need to be exposed to an atmospheric pressure of 10 to 10,000 Pa. Time for the decompression treatment is usually one to 30 minutes.

The two layers in contact with each other are bonded to each other preferably by the decompression treatment, more preferably by combined use of the heating treatment and the decompression treatment from a viewpoint of obtaining a laminate in which the substrate can be favorably separated from each other with good reproducibility.

The load in the thickness direction of the semiconductor substrate and the support substrate is not particularly limited as long as the load does not adversely affect the semiconductor substrate, the support substrate, and the two layers therebetween and can reliably bring these into close contact with each other, but is usually within a range of 10 to 1000 N.

A temperature for the post-heating is preferably 120°C or higher from a viewpoint of achieving a sufficient curing rate or the like, and is preferably 260°C or lower from a viewpoint of preventing alteration of the substrates and the layers or the like.

Time for the post-heating is usually one minute or more, and preferably five minutes or more from a viewpoint of achieving suitable bonding of the substrates and the layers constituting the laminate, and is usually 180 minutes or less, and preferably 120 minutes or less from a viewpoint of suppressing or avoiding an adverse effect on the layers due to excessive heating and the like.

Heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from a viewpoint of achieving suitable release with good reproducibility.

Note that one object of the post-heating treatment is to achieve an adhesive layer and a release layer which are more suitable self-supporting films, and particularly to suitably achieve curing by a hydrosilylation reaction.

### (Method for manufacturing processed semiconductor substrate)

A method for manufacturing a processed semiconductor substrate of the present invention includes a first step, a second step, and a third step.

The first step is a step of processing the semiconductor substrate of the laminate of the present invention.

The second step is a step of separating the semiconductor substrate processed in the first step and the support substrate from each other.

The third step is a step of cleaning the separated semiconductor substrate with a cleaning agent composition.

The processing performed on the semiconductor substrate in the first step is, for example, processing on a side of a wafer opposite to a circuit surface, such as thinning of the wafer by polishing a back surface of the wafer. Thereafter, a through silicon via (TSV) or the like is formed, and thereafter, the thinned wafer is released from the support substrate to form a laminate of the wafer, and the wafer is three-dimensionally mounted. Before and after that, a wafer back surface electrode and the like are also formed. Heat of about 250 to 350°C is applied in the thinning of the wafer and the TSV process in a state where the wafer is bonded to the support substrate. The laminate of the present invention including the adhesive layer and the release layer usually has heat resistance to the load.

Note that the processing is not limited to the above-described processing, and includes, for example, implementation of a process of mounting a semiconductor component in a case where a base material for mounting a semiconductor component is temporarily bonded to the support substrate in order to support the base material.

In the second step, examples of the method for separating (releasing) the semiconductor substrate and the support substrate from each other include mechanical release with equipment having a sharp part and release between the support and the wafer after the release layer is irradiated with light, but are not limited thereto.

By irradiating the release layer with light from the support substrate side, alteration of the release layer (for example, separation or decomposition of the release layer) is caused as described above, and thereafter, for example, one of the substrates is pulled up, and the semiconductor substrate and the support substrate can be easily separated from each other.

The entire region of the release layer does not necessarily have to be irradiated with light. Even when a region irradiated with light and a region not irradiated with light are mixed, the semiconductor substrate and the support substrate can be separated from each other by a slight external force such as pulling up the support substrate as long as releasing ability is sufficiently improved as the entire release layer. A ratio and a positional relationship between a region irradiated with light and a region not irradiated with light vary depending on the type and specific composition of an adhesive to be used, the thickness of the adhesive layer, the thickness of the release layer, an intensity of light to be emitted, and the like, but a person skilled in the art can appropriately set conditions without requiring an excessive test. For such circumstances, according to the method for manufacturing a processed semiconductor substrate of the present invention, for example, in a case where a support substrate of a laminate to be used is light-transmissive, it is possible to shorten light irradiation time when release is performed by light irradiation from the support substrate side. As a result, not only improvement in throughput can be expected, but also physical stress and the like for release can be avoided, and the semiconductor substrate and the support substrate can be easily and efficiently separated from each other only by light irradiation.

Usually, a light irradiation amount for release is 50 to 3,000 mJ/cm². Irradiation time is appropriately determined depending on a wavelength and the irradiation amount.

Light irradiation may be performed using laser light, or may be performed using non-laser light from a light source such as an ultraviolet lamp.

In the third step, cleaning is performed by spraying a cleaning agent composition onto a surface of the separated semiconductor substrate or immersing the separated semiconductor substrate in the cleaning agent composition, and then rinsing and drying are usually performed using a solvent. Note that examples of the cleaning agent composition include those described above.

In the method for manufacturing a processed semiconductor substrate of the present invention, the processed semiconductor substrate manufactured through the third step is favorably cleaned with the cleaning agent composition, but the surface of the processed semiconductor substrate may be further cleaned using a removal tape or the like, and the surface may be further cleaned using a removal tape or the like, if necessary.

The constituent elements and method elements related to the above-described steps of the method for manufacturing a processed semiconductor substrate of the present invention may be variously changed without departing from the gist of the present invention.

The method for manufacturing a processed semiconductor substrate of the present invention may include a step other than the above-described steps.

In the releasing method of the present invention, when the semiconductor substrate or the support substrate of the laminate of the present invention is light-transmissive, the semiconductor substrate and the support substrate of the laminate are separated from each other by irradiating the release layer with light from the semiconductor substrate side or the support substrate side.

In the laminate of the present invention, the semiconductor substrate and the support substrate are temporarily bonded to each other by the adhesive layer and the release layer so as to be suitably releasable. Therefore, for example, when the support substrate is light-transmissive, the semiconductor substrate and the support substrate can be separated from each other by irradiating the release layer with light from the support substrate side of the laminate. Usually, release is performed after the semiconductor substrate of the laminate is processed.

### Examples

Hereinafter, the present invention will be described more specifically with reference to Examples, but the present invention is not limited to the following Examples. Note that apparatuses used are as follows.

### [Apparatus]

(1) Stirrer: rotation and revolution mixer ARE-500 manufactured by THINKY CORPORATION
(2) Viscometer: rotation viscometer TVE-22H manufactured by Toki Sangyo Co., Ltd.
(3) Vacuum bonding apparatus: automatic bonder manufactured by Suss Micro Tech SE.
(4) Optical film thickness meter (film thickness measurement): F-50 manufactured by Filmetrics Japan, Inc.
(5) Laser irradiation device: IPEX-848 manufactured by Light Machinery.

### [Structure of silane]

KF-1005 manufactured by Shin-Etsu Chemical Co., Ltd. 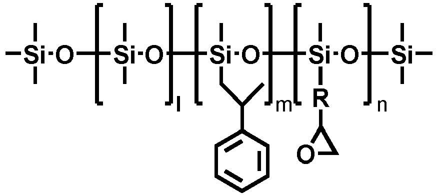 (Each of l, m, and n represents the number of repeating units, and is a positive integer. R is an alkylene group having 1 to 10 carbon atoms.)

X-22-163 manufactured by Shin-Etsu Chemical Co., Ltd. 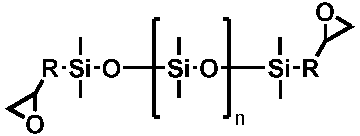 (n represents the number of repeating units, and is a positive integer. R is an alkylene group having 1 to 10 carbon atoms.)

KR-470 manufactured by Shin-Etsu Chemical Co., Ltd.

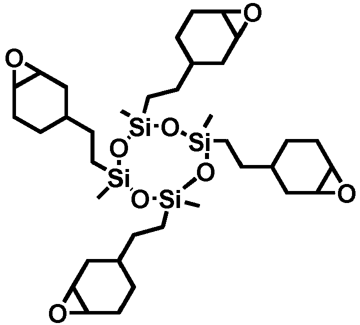

### [Conditions for measuring molecular weight of novolac resin]

A weight average molecular weight of a novolac resin was measured using a GPC apparatus (HLC-8320GPC manufactured by Tosoh Corporation) and GPC columns (TSKgel Super-Multipore HZ-N (two columns)), at a column temperature of 40°C, using THF as an eluent (elution solvent), at a flow rate of 0.35 mL/min, and using polystyrene (Shodex manufactured by Showa Denko K.K.) as a standard sample.

### [Conditions for measuring molecular weight of organosiloxane (specific compound)]

A weight average molecular weight of an organosiloxane was measured using a GPC apparatus (HLC-8320GPC manufactured by Tosoh Corporation) and GPC columns (Asahipak [registered trademark] GF-310HQ, GF-510HQ, and GF-710HQ), at a column temperature of 40°C, using DMF as an eluent (elution solvent), at a flow rate of 0.6 mL/min, and using polystyrene (Shodex manufactured by Showa Denko K.K.) as a standard sample.

### [1] Preparation of adhesive composition

### [Preparation Example 1]

Into a 600 mL vessel dedicated to the stirrer, 80 g of an MQ resin (manufactured by Wacker Chemie GmbH) containing a polysiloxane skeleton and a vinyl group, 2.52 g of a SiH group-containing linear polydimethylsiloxane (manufactured by Wacker Chemie GmbH) having a viscosity of 100 mPa•s, 5.89 g of a SiH group-containing linear polydimethylsiloxane (manufactured by Wacker Chemie GmbH) having a viscosity of 70 mPa•s, and 0.22 g of 1-ethynyl-1-cyclohexanol (manufactured by Wacker Chemie GmbH) were put, and stirred with the stirrer for five minutes to obtain a mixture (I).

0.147 g of a platinum catalyst (manufactured by Wacker Chemie GmbH) and 5.81 g of a vinyl group-containing linear polydimethylsiloxane (manufactured by Wacker Chemie GmbH) having a viscosity of 1,000 mPa•s were stirred with the stirrer for five minutes to obtain a mixture (II).

3.96 g of the obtained mixture (II) was added to the mixture (I), and the mixture was stirred with the stirrer for five minutes to obtain a mixture (III).

Finally, the obtained mixture (III) was filtered through a nylon filter 300 mesh to obtain an adhesive composition.

### [2] Preparation of cleaning agent composition

### [Preparation Example 2]

6 g of a tetrabutylammonium fluoride trihydrate (manufactured by KANTO CHEMICAL CO., INC.) was mixed with 94 g of N,N-dimethylpropionamide, and the mixture was well stirred to obtain a cleaning agent composition.

### [3] Synthesis of novolak resin

### [Synthesis Example 1]

Into a flask, 56.02 g of N-phenyl-1-naphthylamine, 50.00 g of 1-pyrenecarboxaldehyde, 6.67 g of 4-(trifluoromethyl) benzaldehyde, and 2.46 g of methanesulfonic acid were put, and 86.36 g of 1,4-dioxane and 86.36 g of toluene were added thereto. The mixture was stirred under reflux for 18 hours under a nitrogen atmosphere to obtain a reaction mixture.

The obtained reaction mixture was cooled, and then diluted by adding 96 g of tetrahydrofuran thereto to obtain a diluted solution. The obtained diluted solution was added dropwise to methanol to obtain a precipitate. The obtained precipitate was collected by filtration, and a residue was washed with methanol and dried at 60°C under reduced pressure to obtain 72.12 g of a novolac resin. As a result of measurement by the above-described method, a weight average molecular weight of the novolak resin as a polymer was 900.

### [4] Synthesis of organosiloxane

### [Example A]

Into a flask, 8.00 g of KF-1005 manufactured by Shin-Etsu Chemical Co., Ltd., 3.99 g of 4-hydroxybenzaldehyde, 0.55 g of tetrabutylphosphonium bromide, and 50.17 g of propylene glycol monomethyl ether acetate (hereinafter, abbreviated as PGMEA) were put to prepare a raw material mixture, and the raw material mixture was stirred at 105°C for 24 hours under a nitrogen atmosphere. Subsequently, a solution in which 2.17 g of malononitrile was dissolved in 8.68 g of PGMEA was added into the flask, and the mixture was further stirred at 105°C for four hours under a nitrogen atmosphere. The mixture was cooled to room temperature. Thereafter, to the obtained reaction mixture, a cation exchange resin (product name: Amberlyst [registered trademark] 15JWET, Organo Corporation, the same applies hereinafter) and an anion exchange resin (product name: Amberjet [registered trademark] 4002, Organo Corporation, the same applies hereinafter) were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. Here, the solid content of the raw material mixture means components of the raw material mixture other than the solvent (the same applies hereinafter). The obtained reaction product corresponds to the following formula (A-1), and as a result of measurement by the above-described method, a weight average molecular weight thereof was 15,400. 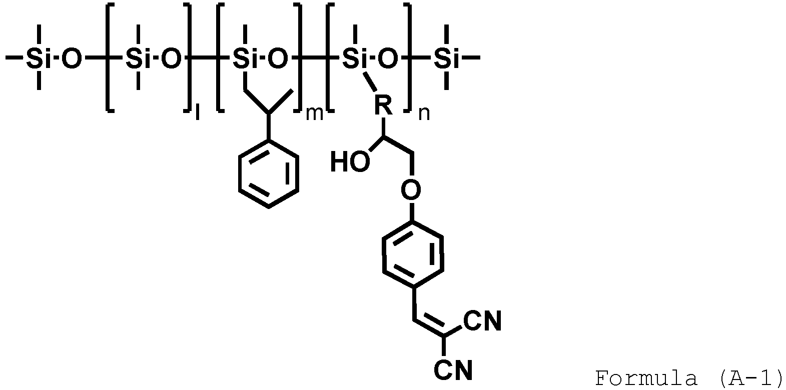 (Each of l, m, and n represents the number of repeating units, and is a positive integer. R is an alkylene group having 1 to 10 carbon atoms.)

### [Example B]

Into a flask, 10.00 g of KF-1005 manufactured by Shin-Etsu Chemical Co., Ltd., 6.13 g of terephthalaldehyde acid, 0.69 g of tetrabutylphosphonium bromide, and 67.29 g of PGMEA were put to prepare a raw material mixture, and the raw material mixture was stirred at 105°C for 24 hours under a nitrogen atmosphere. Subsequently, a solution in which 2.71 g of malononitrile was dissolved in 10.84 g of PGMEA was added into the flask, and the mixture was further stirred at 105°C for four hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-2), and as a result of measurement by the above-described method, a weight average molecular weight thereof was 25,900. 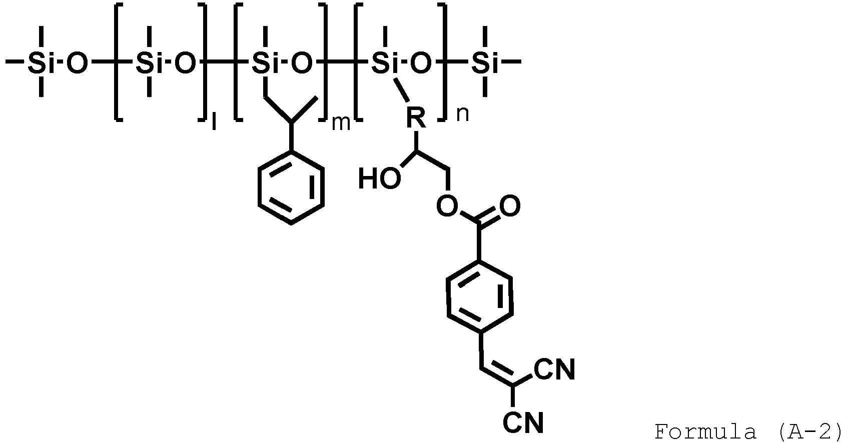 (Each of l, m, and n represents the number of repeating units, and is a positive integer. R is an alkylene group having 1 to 10 carbon atoms.)

### [Example C]

Into a flask, 15.00 g of KF-1005 manufactured by Shin-Etsu Chemical Co., Ltd., 11.59 g of α-cyano-4-hydroxycinnamic acid, 1.04 g of tetrabutylphosphonium bromide, and 64.46 g of propylene glycol monomethyl ether (hereinafter, abbreviated as PGME) were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-3), and as a result of measurement by the above-described method, a weight average molecular weight thereof was 45,000. 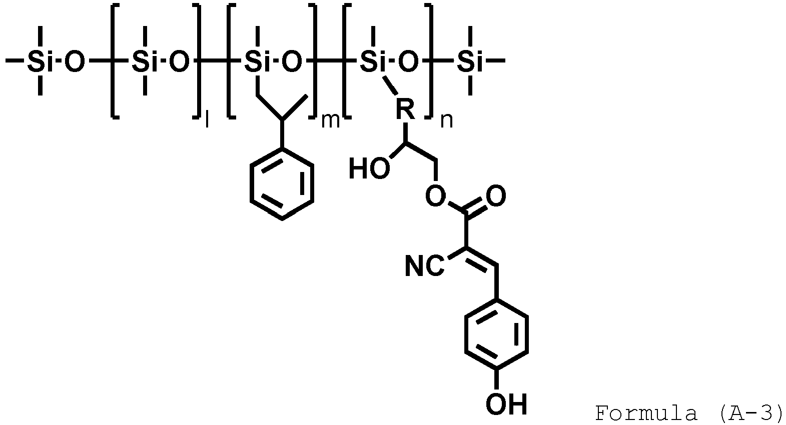 (Each of l, m, and n represents the number of repeating units, and is a positive integer. R is an alkylene group having 1 to 10 carbon atoms.)

### [Example D]

Into a flask, 15.00 g of KF-1005 manufactured by Shin-Etsu Chemical Co., Ltd., 10.92 g of trans-4-methoxycinnamic acid, 1.04 g of tetrabutylphosphonium bromide, and 62.89 g of PGME were put to prepare a reaction mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-4), and as a result of measurement by the above-described method, a weight average molecular weight thereof was 18,300. 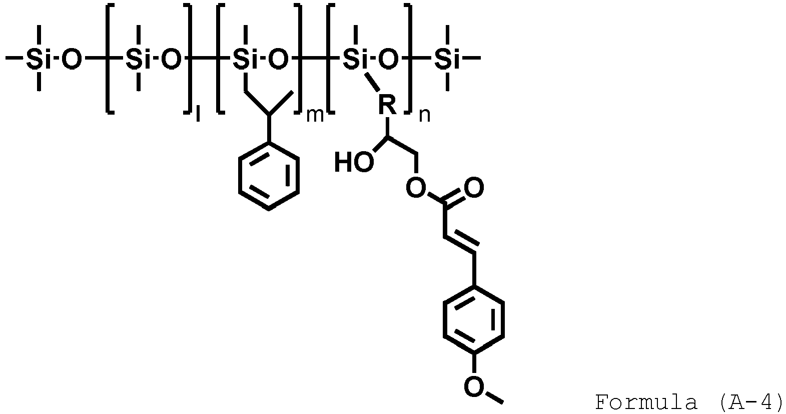 (Each of l, m, and n represents the number of repeating units, and is a positive integer. R is an alkylene group having 1 to 10 carbon atoms.)

### [Example E]

Into a flask, 16.00 g of KF-1005 manufactured by Shin-Etsu Chemical Co., Ltd., 12.62 g of 4-nitrocinnamic acid, 1.11 g of tetrabutylphosphonium bromide, and 69.37 g of PGME were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-5), and as a result of measurement by the above-described method, a weight average molecular weight thereof was 24,600. 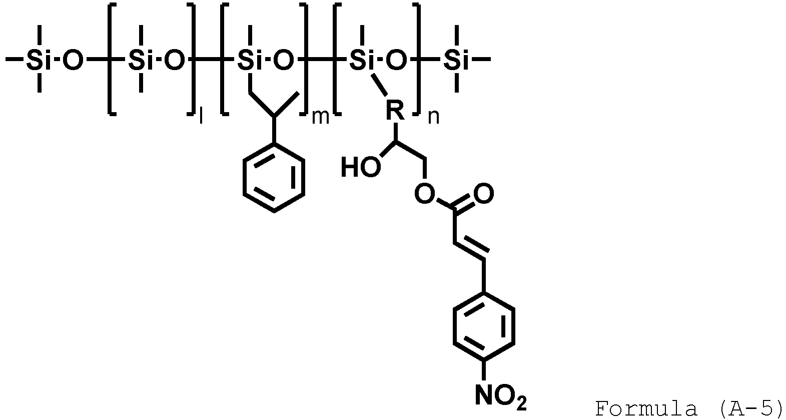 (Each of l, m, and n represents the number of repeating units, and is a positive integer. R is an alkylene group having 1 to 10 carbon atoms.)

### [Example F]

Into a flask, 15.00 g of X-22-163 manufactured by Shin-Etsu Chemical Co., Ltd., 8.15 g of α-cyano-4-hydroxycinnamic acid, 1.39 g of tetrabutylphosphonium bromide, and 57.26 g of PGME were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-6), and as a result of measurement by the above-described method, a weight average molecular weight thereof was 1,700. 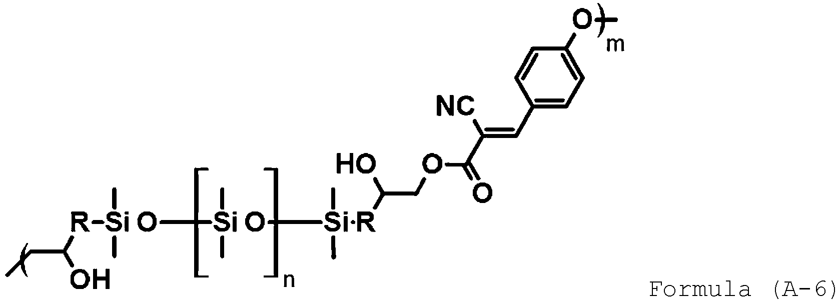 (Each of n and m represents the number of repeating units, and is a positive integer. R is an alkylene group having 1 to 10 carbon atoms.)

### [Example G]

Into a flask, 10.00 g of KR-470 manufactured by Shin-Etsu Chemical Co., Ltd., 10.04 g of α-cyano-4-hydroxycinnamic acid, 0.90 g of tetrabutylphosphonium bromide, and 48.85 g of PGME were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-7), and as a result of measurement by the above-described method, a weight average molecular weight thereof was 1,700.

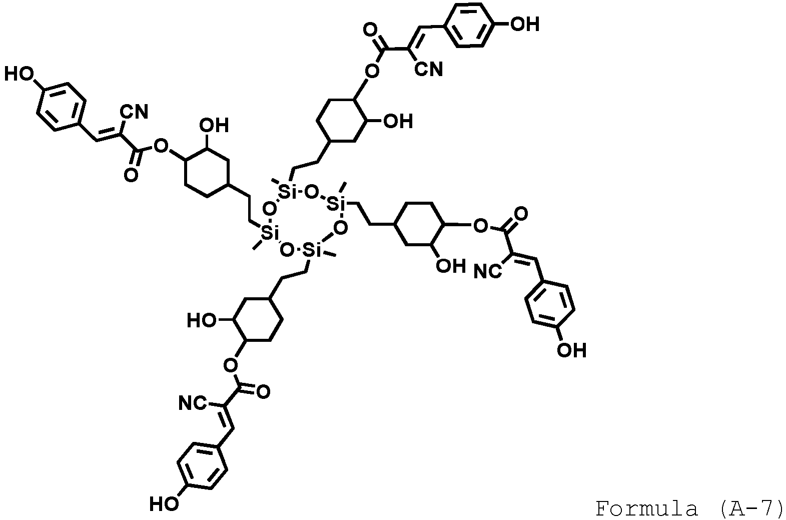

### [Example H]

Into a flask, 4.50 g of KR-470 manufactured by Shin-Etsu Chemical Co., Ltd., 4.25 g of trans-4-methoxycinnamic acid, 0.41 g of tetrabutylphosphonium bromide, and 21.37 g of PGME were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-8), and as a result of measurement by the above-described method, a weight average molecular weight thereof was 1,700.

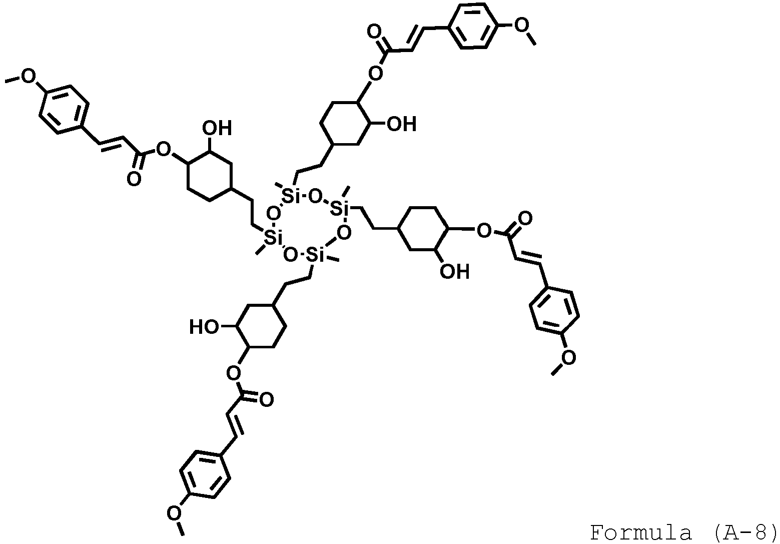

### [Example I]

Into a flask, 8.00 g of KR-470 manufactured by Shin-Etsu Chemical Co., Ltd., 8.20 g of 4-nitrocinnamic acid, 0.72 g of tetrabutylphosphonium bromide, and 39.47 g of PGME were put to prepare a raw material mixture, and the raw material mixture was heated and refluxed for 24 hours under a nitrogen atmosphere. The mixture was cooled to room temperature Thereafter, to the obtained reaction mixture, a cation exchange resin and an anion exchange resin were added. Subsequently, the mixture was stirred at room temperature for four hours to remove unreacted monomers and a catalyst used for the reaction. Finally, the ion exchange resins were removed by filtration to obtain a solution containing a reaction product as a filtrate. Note that each of the mass of the cation exchange resin and the mass of the anion exchange resin was the same as that of the solid of the raw material mixture prepared at the beginning. The obtained reaction product corresponds to the following formula (A-9), and as a result of measurement by the above-described method, a weight average molecular weight thereof was 2,000.

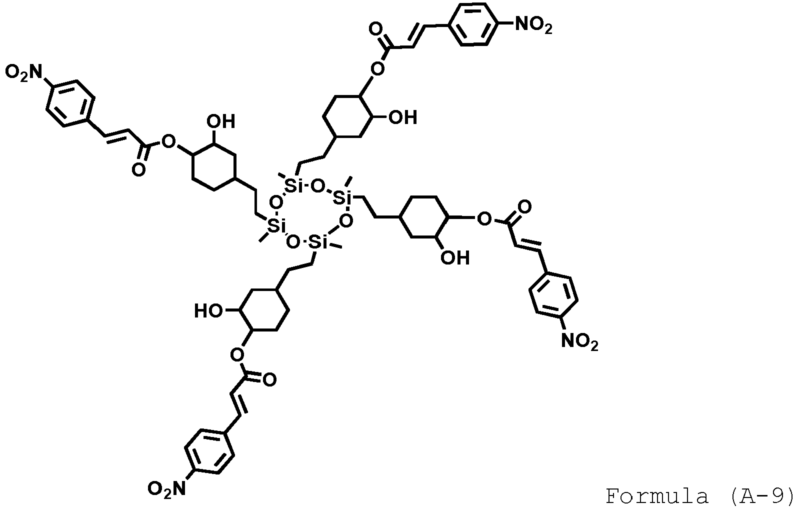

### [5] Preparation of release agent composition

### [Comparative Example 1-1]

Into a screw tube, 1.74 g of the novolac resin obtained in Synthesis Example 1, 0.35 g of TMOM-BP [3,3',5,5'-tetrakis(methoxymethyl)-[1,1'-biphenyl]-4,4'-diol] as a crosslinking agent, 4.34 g of a PGME solution of 1% by mass pyridinium phenol sulfonate as a crosslinking catalyst, 9.64 g of PGME, and 13.94 g of PGMEA were put, and the obtained solution was filtered using a polyethylene microfilter having a pore size of 0.2 µm to obtain a release agent composition.

### [Example 1-1]

Into a screw tube, 14.26 g of a solution (reaction product concentration: 14.98% by mass) of the reaction product corresponding to the formula (A-1) obtained in Example A, 5.34 g of a PGME solution of 1% by mass pyridinium trifluoromethanesulfonate as a crosslinking catalyst, 1.78 g of PGME, and 8.62 g of PGMEA were put, and the obtained solution was filtered using a polyethylene microfilter having a pore size of 0.2 µm to obtain a release agent composition.

### [Example 1-2]

Into a screw tube, 11.76 g of a solution (reaction product concentration: 16.18% by mass) of the reaction product corresponding to the formula (A-2) obtained in Example B, 4.76 g of a PGME solution of 1% by mass pyridinium trifluoromethanesulfonate as a crosslinking catalyst, 4.17 g of PGME, and 9.32 g of PGMEA were put, and the obtained solution was filtered using a polyethylene microfilter having a pore size of 0.2 µm to obtain a release agent composition.

### [Example 1-3]

Into a screw tube, 7.29 g of a solution (reaction product concentration: 24.09% by mass) of the reaction product corresponding to the formula (A-3) obtained in Example C, 4.39 g of a PGME solution of 1% by mass pyridinium trifluoromethanesulfonate as a crosslinking catalyst, 4.22 g of PGME, and 14.10 g of PGMEA were put, and the obtained solution was filtered using a polyethylene microfilter having a pore size of 0.2 µm to obtain a release agent composition.

### [Example 1-4]

Into a screw tube, 8.03 g of a solution (reaction product concentration: 24.09% by mass) of the reaction product corresponding to the formula (A-3) obtained in Example C, 0.097 g of tetramethoxymethylglycoluril as a crosslinking agent, 0.97 g of a PGME solution of 1% by mass pyridinium trifluoromethanesulfonate as a crosslinking catalyst, 12.52 g of PGME, and 8.39 g of PGMEA were put, and the obtained solution was filtered using a polyethylene microfilter having a pore size of 0.2 µm to obtain a release agent composition.

### [Example 1-5]

Into a screw tube, 7.29 g of a solution (reaction product concentration: 26.02% by mass) of the reaction product corresponding to the formula (A-4) obtained in Example D, 4.46 g of a PGME solution of 1% by mass pyridinium trifluoromethanesulfonate as a crosslinking catalyst, 4.59 g of PGME, and 14.09 g of PGMEA were put, and the obtained solution was filtered using a polyethylene microfilter having a pore size of 0.2 µm to obtain a release agent composition.

### [Example 1-6]

Into a screw tube, 6.73 g of a solution (reaction product concentration: 26.02% by mass) of the reaction product corresponding to the formula (A-4) obtained in Example D, 0.26 g of tetramethoxymethylglycoluril as a crosslinking agent, 2.63 g of a PGME solution of 1% by mass pyridinium trifluoromethanesulfonate as a crosslinking catalyst, 11.99 g of PGME, and 8.39 g of PGMEA were put, and the obtained solution was filtered using a polyethylene microfilter having a pore size of 0.2 µm to obtain a release agent composition.

### [Example 1-7]

Into a screw tube, 7.72 g of a solution (reaction product concentration: 25.03% by mass) of the reaction product corresponding to the formula (A-5) obtained in Example E, 4.83 g of a PGME solution of 1% by mass pyridinium trifluoromethanesulfonate as a crosslinking catalyst, 9.23 g of PGME, and 8.22 g of PGMEA were put, and the obtained solution was filtered using a polyethylene microfilter having a pore size of 0.2 µm to obtain a release agent composition.

### [Example 1-8]

Into a screw tube, 7.00 g of a solution (reaction product concentration: 25.03% by mass) of the reaction product corresponding to the formula (A-5) obtained in Example E, 0.26 g of tetramethoxymethylglycoluril as a crosslinking agent, 2.63 g of a PGME solution of 1% by mass pyridinium trifluoromethanesulfonate as a crosslinking catalyst, 11.73 g of PGME, and 8.39 g of PGMEA were put, and the obtained solution was filtered using a polyethylene microfilter having a pore size of 0.2 µm to obtain a release agent composition.

### [Example 1-9]

Into a screw tube, 4.76 g of a solution (reaction product concentration: 37.33% by mass) of the reaction product corresponding to the formula (A-6) obtained in Example F, 0.27 g of tetramethoxymethylglycoluril as a crosslinking agent, 2.67 g of a PGME solution of 1% by mass pyridinium trifluoromethanesulfonate as a crosslinking catalyst, 13.93 g of PGME, and 8.38 g of PGMEA were put, and the obtained solution was filtered using a polyethylene microfilter having a pore size of 0.2 µm to obtain a release agent composition.

### [Example 1-10]

Into a screw tube, 1.19 g of a solution (reaction product concentration: 26.59% by mass) of the reaction product corresponding to the formula (A-7) obtained in Example G, 0.79 g of a PGME solution of 1% by mass pyridinium trifluoromethanesulfonate as a crosslinking catalyst, 0.68 g of PGME, and 2.34 g of PGMEA were put, and the obtained solution was filtered using a polyethylene microfilter having a pore size of 0.2 µm to obtain a release agent composition.

### [Example 1-11]

Into a screw tube, 1.31 g of a solution (reaction product concentration: 24.17% by mass) of the reaction product corresponding to the formula (A-8) obtained in Example H, 0.79 g of a PGME solution of 1% by mass pyridinium trifluoromethanesulfonate as a crosslinking catalyst, 0.59 g of PGME, and 2.34 g of PGMEA were put, and the obtained solution was filtered using a polyethylene microfilter having a pore size of 0.2 µm to obtain a release agent composition.

### [Example 1-12]

Into a screw tube, 1.38 g of a solution (reaction product concentration: 24.17% by mass) of the reaction product corresponding to the formula (A-8) obtained in Example H, 0.033 g of tetramethoxymethylglycoluril as a crosslinking agent, 0.33 g of a PGME solution of 1% by mass pyridinium trifluoromethanesulfonate as a crosslinking catalyst, 1.87 g of PGME, and 1.39 g of PGMEA were put, and the obtained solution was filtered using a polyethylene microfilter having a pore size of 0.2 µm to obtain a release agent composition.

### [Example 1-13]

Into a screw tube, 1.28 g of a solution (reaction product concentration: 24.86% by mass) of the reaction product corresponding to the formula (A-9) obtained in Example I, 0.048 g of tetramethoxymethylglycoluril as a crosslinking agent, 0.48 g of a PGME solution of 1% by mass pyridinium trifluoromethanesulfonate as a crosslinking catalyst, 1.81 g of PGME, and 1.39 g of PGMEA were put, and the obtained solution was filtered using a polyethylene microfilter having a pore size of 0.2 µm to obtain a release agent composition.

### [6] Confirmation of film removability (film reduction ratio)

### [Examples 2-1 to 2-13]

The release agent compositions obtained in Examples 1-1 to 1-13 were each spin-coated on a silicon wafer cut into 4 cm square with a final film thickness of 200 nm, and heated at 230°C for five minutes to form a film on a substrate. The substrates on each of which the film was formed were prepared as many as necessary.

### [Comparative Example 2-1]

A film was formed on a substrate in a similar manner to Example 2-1 except that the release agent composition obtained in Comparative Example 1-1 was used in place of the release agent composition obtained in Example 1-1.

The film thickness of each of the films obtained in Examples 2-1 to Example 2-13 and Comparative Example 2-1 was measured (film thickness before immersion). Then, each of the films was immersed in 7 mL of the cleaning agent composition obtained in Preparation Example 2 together with the substrate for ten minutes and dried with an air gun, and then the film thickness of each of the films was measured again (film thickness after immersion).

The film thickness was measured by performing similar operation except that each of OK73 thinner (components of which are propylene glycol monomethyl ether 70% and propylene glycol monomethyl ether acetate 30%) (manufactured by TOKYO OHKA KOGYO Co., Ltd.) and N-methyl-2-pyrrolidone (NMP) was used in place of the cleaning agent composition.

A film reduction ratio (%) by immersion was calculated by the following formula. 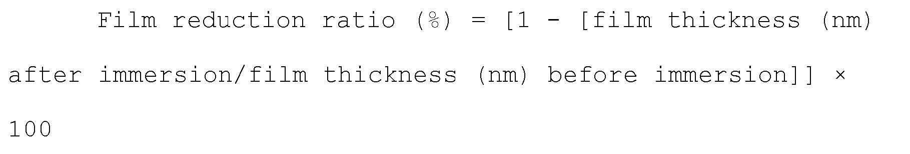 Film reduction ratio (%) = [1 - [film thickness (nm) after immersion/film thickness (nm) before immersion]] × 100

Results are presented in Tables 1 and 2.

**[Table 1]**

| | Example 2-1 | Example 2-2 | Example 2-3 | Example 2-4 | Example 2-5 | Example 2-6 | Example 2-7 |
|---|---|---|---|---|---|---|---|
| Release agent composition | Example 1-1 | Example 1-2 | Example 1-3 | Example 1-4 | Example 1-5 | Example 1-6 | Example 1-7 |
| Cleaning agent composition | 100% | 100% | 100% | 100% | 100% | 100% | 100% |
| OK73 thinner | 1% | 2% | 1% | 2% | 5% | 0% | 4% |
| NMP | 1% | 3% | 4% | 2% | 3% | 0% | 3% |

**[Table 2]**

| | Example 2-8 | Example 2-9 | Example 2-10 | Example 2-11 | Example 2-12 | Example 2-13 | Comparative Example 2-1 |
|---|---|---|---|---|---|---|---|
| Release agent composition | Example 1-8 | Example 1-9 | Example 1-10 | Example 1-11 | Example 1-12 | Example 1-13 | Comparative Example 1-1 |
| Cleaning agent composition | 100% | 100% | 100% | 100% | 100% | 100% | 0% |
| OK73 thinner | 1% | 2% | 1% | 1% | 3% | 3% | 0% |
| NMP | 2% | 3% | 3% | 1% | 3% | 1% | 0% |

As presented in Tables 1 and 2, the film obtained in Comparative Example 2-1 had a film reduction ratio of 0% when immersed in each of the cleaning agent composition, the OK73 thinner, and NMP. This means that the film obtained in Comparative Example 2-1 was not dissolved in any of the cleaning agent composition, the OK73 thinner, and NMP. In Examples 2-1 to 2-13, films were obtained in each of which a film reduction ratio when immersed in various solvents was 5% or less, but a film reduction ratio when immersed in the cleaning agent composition was 100%. That is, the films of Examples 2-1 to 2-13 could not be suitably removed with various solvents, but could be suitably removed with the cleaning agent composition.

### [7] Manufacture of laminate and confirmation of releasability by light irradiation

### [Examples 3-1 to 3-5]

Each of the release agent compositions obtained in Examples 1-2, 1-3, 1-4, 1-7, and 1-8 was spin-coated on a 300 mm glass wafer (EAGLE-XG, manufactured by Corning Incorporated, thickness: 700 µm) as a substrate on a carrier side such that a film thickness thereof in a finally obtained laminate was 200 nm to form a release agent coating layer on the glass wafer as a support substrate.

Meanwhile, the adhesive composition obtained in Preparation Example 1 was spin-coated on a 300 mm silicon wafer (thickness: 775 µm) as a substrate on a device side such that a film thickness thereof in a finally obtained laminate was 65 µm to form an adhesive coating layer on the silicon wafer as a semiconductor substrate.

Then, using a bonding apparatus, the glass wafer and the silicon wafer were bonded to each other so as to sandwich the release agent coating layer and the adhesive coating layer therebetween, and then subjected to postheating treatment at 200°C for ten minutes to prepare a laminate. Note that bonding was performed under a load of 30 N at a temperature of 23°C and a decompression degree of 1,000 Pa.

Using a laser irradiation device, the release layer was irradiated with a laser having a wavelength of 308 nm from the glass wafer side of the fixed laminate, and the lowest irradiation amount at which release occurred was defined as an optimum irradiation amount. Then, the entire surface of the release layer was irradiated with a laser having a wavelength of 308 nm at an optimum irradiation amount from the glass wafer side of the fixed laminate, and the support substrate was manually lifted to confirm whether or not release was possible. When the silicon wafer could be released without being damaged, it was defined that release was possible. Results are presented in Table 3. Note that a numerical value in parentheses is an optimum irradiation amount.

### [Comparative Example 3-1]

A laminate was manufactured in a similar manner to Example 3-1 except that the release agent composition obtained in Comparative Example 2-1 was used in place of the release agent composition obtained in Example 1-2, and releasability was confirmed.

**[Table 3]**

| | Example 3-1 | Example 3-2 | Example 3-3 | Example 3-4 | Example 3-5 | Comparative Example 3-1 |
|---|---|---|---|---|---|---|
| Release agent composition | Example 1-2 | Example 1-3 | Example 1-4 | Example 1-7 | Example 1-8 | Comparative Example 1-1 |
| Releasability with laser | Releasable (225 mJ/cm²) | Releasable (225 mJ/cm²) | Releasable (275 mJ/cm²) | Releasable (275 mJ/cm²) | Releasable (300 mJ/cm²) | Releasable (175 mJ/cm²) |

As presented in Table 3, even when the semiconductor substrate and the support substrate of the laminate including a film obtained using the release agent composition containing the specific compound as the release layer were separated from each other by irradiating the release layer with light, good releasability was confirmed as in the case of using the release agent composition containing a novolak resin.

### Industrial Applicability

According to the present invention, in the laminate of the present invention, a support substrate and a semiconductor substrate can be easily separated from each other when the support substrate and the semiconductor substrate are separated from each other, and a release layer after light irradiation can be dissolved in a cleaning agent composition when the semiconductor substrate is cleaned. Therefore, the laminate is useful for manufacturing a processed semiconductor substrate.

### Reference Signs List

- 1: Semiconductor substrate
- 2: Adhesive layer
- 3: Release layer
- 4: Support substrate

## Claims

1. A compound having a styrylene structure represented by the following formula (1) as a first structure and a siloxane structure as a second structure, 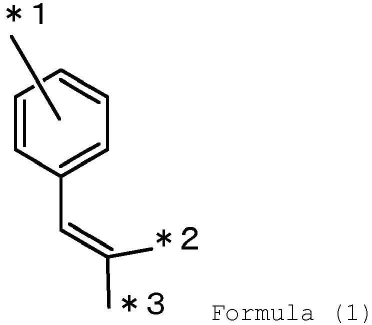
wherein, in formula (1), *1 to *3 each independently represent a bond, and
wherein the compound having a styrylene structure is selected from the group consisting of a compound having a structure represented by the following formula (2-1) and a repeating unit represented by the following formula (2-2), a compound having a repeating unit represented by the following formula (3-1) and a repeating unit represented by the following formula (3-2), a compound having a repeating unit represented by the following formula (4-1) and a repeating unit represented by the following formula (4-2), and a compound represented by the following formula (5), 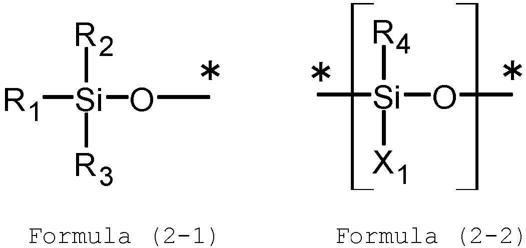
wherein, in formula (2-1), R₁ to R₃ each independently represent a hydrogen atom, a hydroxy group, or a hydrocarbon group having 1 to 6 carbon atoms, and * represents a bond,
wherein, in formula (2-2), R₄ represents a hydrogen atom, a hydroxy group, or a hydrocarbon group having 1 to 6 carbon atoms, X₁ represents a monovalent group having 9 to 30 carbon atoms and having a styrylene structure represented by the formula (1), and * represents a bond, 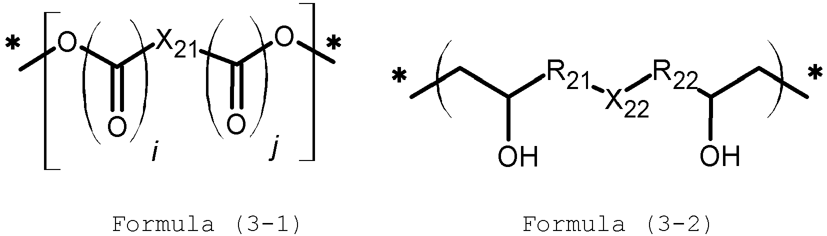
wherein, in formula (3-1), X₂₁ represents a divalent group having 8 to 30 carbon atoms and having a styrylene structure represented by the formula (1), i and j each independently represent 0 or 1, and * represents a bond,
wherein, in formula (3-2), X₂₂ represents a group represented by the following formula (B), R₂₁ and R₂₂ each independently represent a single bond or an alkylene group having 1 to 10 carbon atoms and * represents a bond, 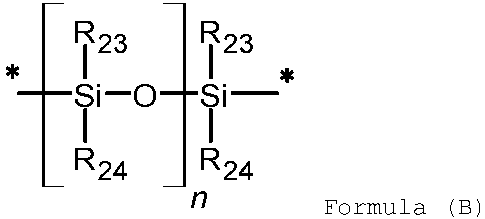
wherein, in formula (B), R₂₃ and R₂₄ each independently represent a hydrogen atom, a hydroxy group, or a hydrocarbon group having 1 to 6 carbon atoms, n represents an integer of 0 or more, and * represents a bond, 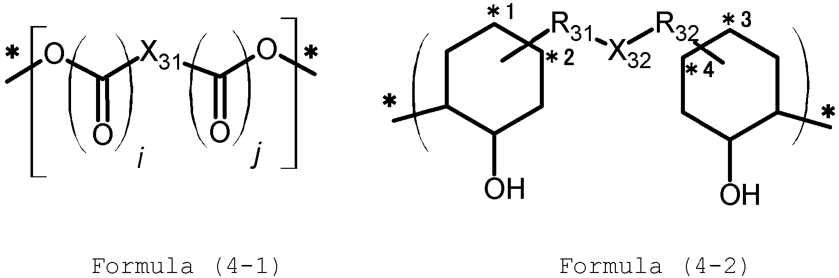
wherein, in formula (4-1), X₃₁ represents a divalent group having 8 to 30 carbon atoms and having a styrylene structure represented by the formula (1), i and j each independently represent 0 or 1, and * represents a bond,
wherein, in formula (4-2), X₃₂ represents a group represented by the formula (B), R₃₁ and R₃₂ each independently represent a single bond or an alkylene group having 1 to 10 carbon atoms, * represents a bond, R₃₁ is bonded to a *1 carbon atom or a *2 carbon atom, R₃₂ is bonded to a*3 carbon atom or a *4 carbon atom, and 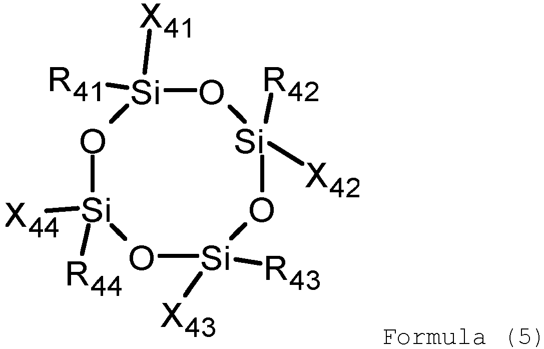
wherein, in formula (5), R₄₁ to R₄₄ each independently represent a hydrogen atom, a hydroxy group, or a monovalent group having 1 to 30 carbon atoms, and X₄₁ to X₄₄ each independently represent a hydrogen atom, a hydroxy group, or a monovalent group having 1 to 30 carbon atoms, provided that at least one of X₄₁ to X₄₄ represents a monovalent group having 9 to 30 carbon atoms and having a styrylene structure represented by the formula (1), and, when two or more of X₄₁ to X₄₄ are monovalent groups each having 9 to 30 carbon atoms and each having a styrylene structure represented by the formula (1), they may be the same or different.

2. The compound according to claim 1, wherein
in the formula (2-2), X₁ is a monovalent group represented by any one of the following formulas (A-1) to (A-4),
in the formula (3-1), X₂₁ is a divalent group represented by the following formula (C),
in the formula (4-1), X₃₁ is a divalent group represented by the following formula (C), and
in the formula (5), the monovalent group having 9 to 30 carbon atoms and having a styrylene structure represented by the formula (1) is a monovalent group represented by either one of the following formulas (D-1) and (D-2), 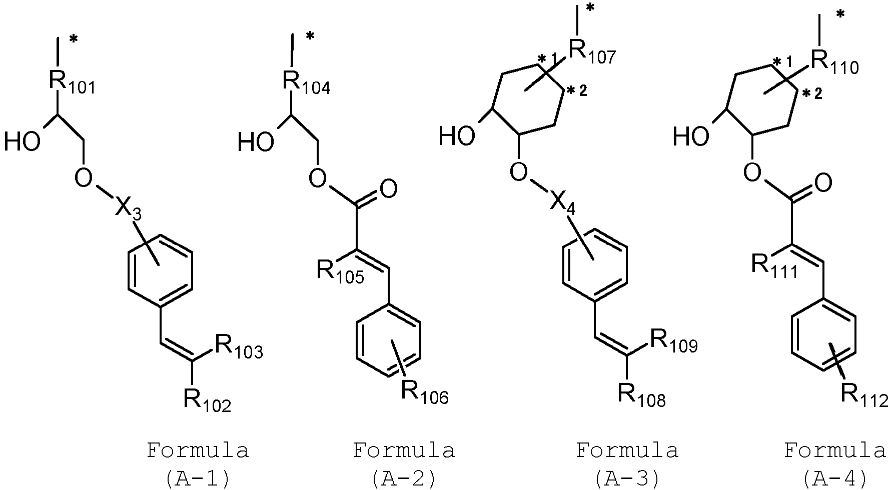
wherein, in formula (A-1), R₁₀₁ represents a single bond or an alkylene group having 1 to 10 carbon atoms, X₃ represents a single bond or -CO-, R₁₀₂ and R₁₀₃ each independently represent a hydrogen atom or a cyano group, and * represents a bond to Si in the formula (2-2),
wherein, in formula (A-2), R₁₀₄ represents a single bond or an alkylene group having 1 to 10 carbon atoms, R₁₀₅ represents a hydrogen atom or a cyano group, R₁₀₆ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, and * represents a bond to Si in the formula (2-2),
wherein, in formula (A-3), R₁₀₇ represents a single bond or an alkylene group having 1 to 10 carbon atoms, X₄ represents a single bond or -CO-, R₁₀₈ and R₁₀₉ each independently represent a hydrogen atom or a cyano group, * represents a bond to Si in the formula (2-2), and R₁₀₇ is bonded to a *1 carbon atom or a *2 carbon atom,
wherein, in formula (A-4), R₁₁₀ represents a single bond or an alkylene group having 1 to 10 carbon atoms, R₁₁₁ represents a hydrogen atom or a cyano group, R₁₁₂ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (2-2), and R₁₁₀ is bonded to a *1 carbon atom or a *2 carbon atom, 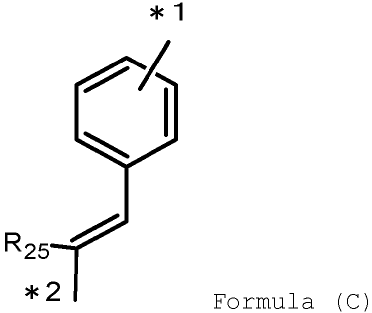
wherein, in formula (C), R₂₅ represents a hydrogen atom or a cyano group, and *1 and *2 each represent a bond, 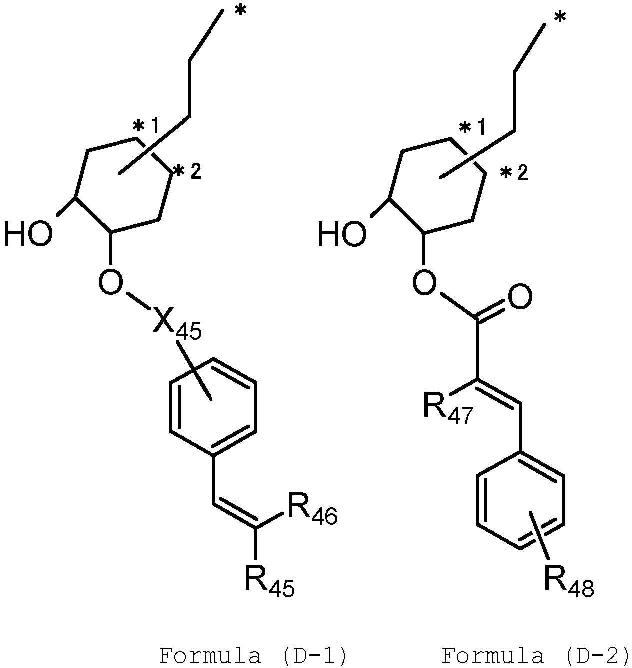
wherein, in formula (D-1), X₄₅ represents a single bond or -CO-, R₄₅ and R₄₆ each independently represent a hydrogen atom or a cyano group, * represents a bond to Si in the formula (5), an ethylene group bonded to Si is bonded to a *1 carbon atom or a *2 carbon atom of a cyclohexane ring, and
wherein, in formula (D-2), R₄₇ represents a hydrogen atom or a cyano group, R₄₈ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (5), and an ethylene group bonded to Si is bonded to a *1 carbon atom or a *2 carbon atom of a cyclohexane ring.

3. A release agent composition comprising a compound as defined in claim 1 or 2.

4. The release agent composition according to claim 3, wherein the compound contained in the release agent composition is at least one selected from the group consisting of a compound having a structure represented by the following formula (2-1) and a repeating unit represented by the following formula (2-2), a compound having a repeating unit represented by the following formula (3-1) and a repeating unit represented by the following formula (3-2), a compound having a repeating unit represented by the following formula (4-1) and a repeating unit represented by the following formula (4-2), and a compound represented by the following formula (5), 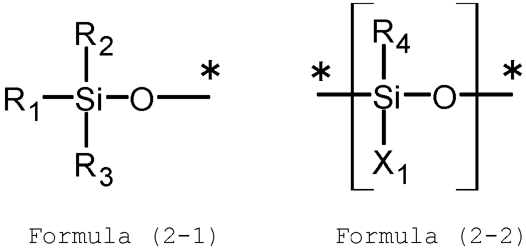
wherein, in formula (2-1), R₁ to R₃ each independently represent a hydrogen atom, a hydroxy group, or a hydrocarbon group having 1 to 6 carbon atoms, and * represents a bond,
wherein, in formula (2-2), R₄ represents a hydrogen atom, a hydroxy group, or a hydrocarbon group having 1 to 6 carbon atoms, X₁ represents a monovalent group having 9 to 30 carbon atoms and having a styrylene structure represented by the formula (1), and * represents a bond, 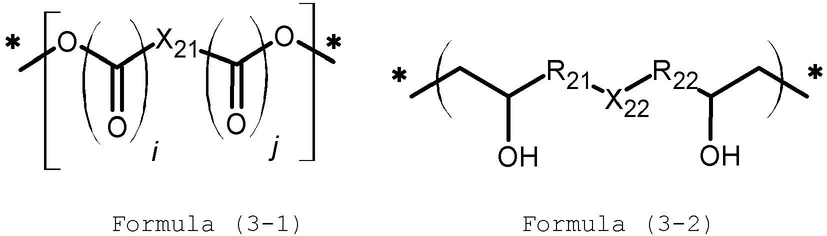
wherein, in formula (3-1), X₂₁ represents a divalent group having 8 to 30 carbon atoms and having a styrylene structure represented by the formula (1), i and j each independently represent 0 or 1, and * represents a bond,
wherein, in formula (3-2), X₂₂ represents a group represented by the following formula (B), R₂₁ and R₂₂ each independently represent a single bond or an alkylene group having 1 to 10 carbon atoms and * represents a bond, 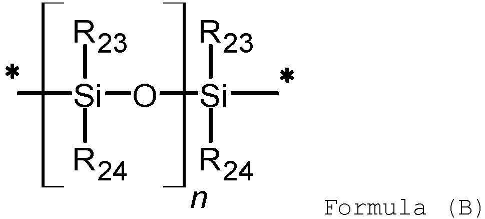
wherein, in formula (B), R₂₃ and R₂₄ each independently represent a hydrogen atom, a hydroxy group, or a hydrocarbon group having 1 to 6 carbon atoms, n represents an integer of 0 or more, and * represents a bond, 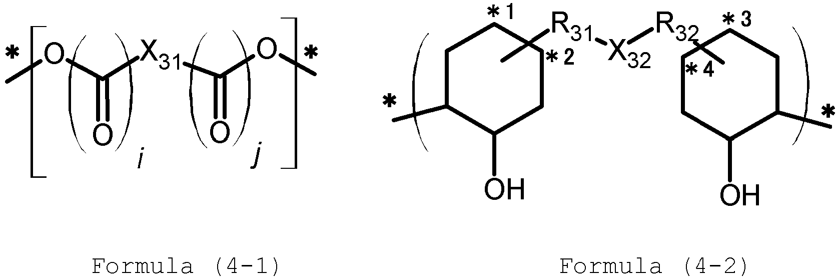
wherein, in formula (4-1), X₃₁ represents a divalent group having 8 to 30 carbon atoms and having a styrylene structure represented by the formula (1), i and j each independently represent 0 or 1, And * represents a bond,
wherein, in formula (4-2), X₃₂ represents a group represented by the formula (B), R₃₁ and R₃₂ each independently represent a single bond or an alkylene group having 1 to 10 carbon atoms, * represents a bond, R₃₁ is bonded to a *1 carbon atom or a *2 carbon atom, R₃₂ is bonded to a*3 carbon atom or a *4 carbon atom, and 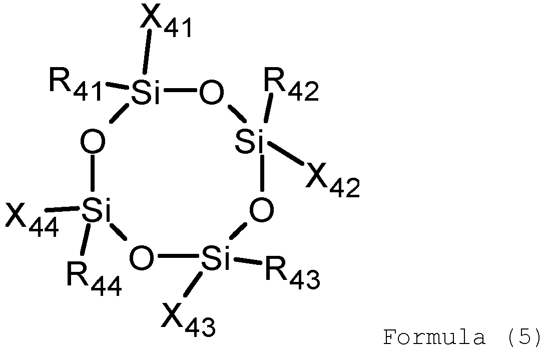
wherein, in formula (5), R₄₁ to R₄₄ each independently represent a hydrogen atom, a hydroxy group, or a monovalent group having 1 to 30 carbon atoms, and X₄₁ to X₄₄ each independently represent a hydrogen atom, a hydroxy group, or a monovalent group having 1 to 30 carbon atoms, provided that at least one of X₄₁ to X₄₄ represents a monovalent group having 9 to 30 carbon atoms and having a styrylene structure represented by the formula (1), and, when two or more of X₄₁ to X₄₄ are monovalent groups each having 9 to 30 carbon atoms and each having a styrylene structure represented by the formula (1), they may be the same or different.

5. The release agent composition according to claim 4, wherein
in the formula (2-2), X₁ is a monovalent group represented by any one of the following formulas (A-1) to (A-4),
in the formula (3-1), X₂₁ is a divalent group represented by the following formula (C),
in the formula (4-1), X₃₁ is a divalent group represented by the following formula (C), and
in the formula (5), the monovalent group having 9 to 30 carbon atoms and having a styrylene structure represented by the formula (1) is a monovalent group represented by either one of the following formulas (D-1) and (D-2), 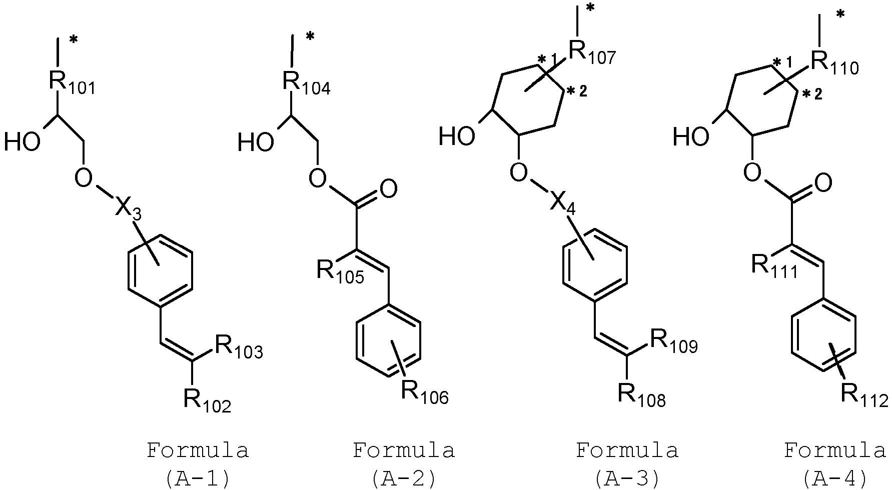
wherein, in formula (A-1), R₁₀₁ represents a single bond or an alkylene group having 1 to 10 carbon atoms, X₃ represents a single bond or -CO-, R₁₀₂ and R₁₀₃ each independently represent a hydrogen atom or a cyano group, and * represents a bond to Si in the formula (2-2),
wherein, in formula (A-2), R₁₀₄ represents a single bond or an alkylene group having 1 to 10 carbon atoms, R₁₀₅ represents a hydrogen atom or a cyano group, R₁₀₆ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, and * represents a bond to Si in the formula (2-2),
wherein, in formula (A-3), R₁₀₇ represents a single bond or an alkylene group having 1 to 10 carbon atoms, X₄ represents a single bond or -CO-, R₁₀₈ and R₁₀₉ each independently represent a hydrogen atom or a cyano group, * represents a bond to Si in the formula (2-2), and R₁₀₇ is bonded to a *1 carbon atom or a *2 carbon atom,
wherein, in formula (A-4), R₁₁₀ represents a single bond or an alkylene group having 1 to 10 carbon atoms, R₁₁₁ represents a hydrogen atom or a cyano group, R₁₁₂ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (2-2), and R₁₁₀ is bonded to a *1 carbon atom or a *2 carbon atom, 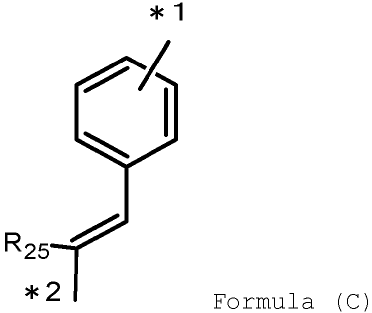
wherein, in formula (C), R₂₅ represents a hydrogen atom or a cyano group, and *1 and *2 each represent a bond, 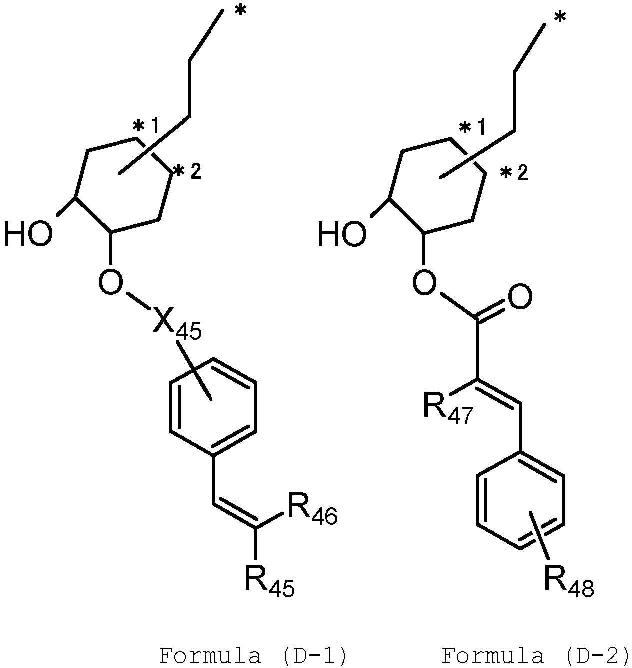
wherein, in formula (D-1), X₄₅ represents a single bond or -CO-, R₄₅ and R₄₆ each independently represent a hydrogen atom or a cyano group, * represents a bond to Si in the formula (5), an ethylene group bonded to Si is bonded to a *1 carbon atom or a *2 carbon atom of a cyclohexane ring, and
wherein, in formula (D-2), R₄₇ represents a hydrogen atom or a cyano group, R₄₈ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (5), and an ethylene group bonded to Si is bonded to a *1 carbon atom or a *2 carbon atom of a cyclohexane ring.

6. The release agent composition according to any one of claims 3 to 5, comprising a crosslinking agent.

7. A laminate comprising:
a semiconductor substrate;
a light-transmissive support substrate; and
an adhesive layer and a release layer disposed between the semiconductor substrate and the support substrate,
the laminate being used for releasing the semiconductor substrate and the support substrate after the release layer absorbs light emitted from the support substrate side, wherein
the release layer is formed of a release agent composition as defined in claim 3.

8. The laminate according to claim 7, wherein the compound contained in the release agent composition is at least one selected from the group consisting of a compound having a structure represented by the following formula (2-1) and a repeating unit represented by the following formula (2-2), a compound having a repeating unit represented by the following formula (3-1) and a repeating unit represented by the following formula (3-2), a compound having a repeating unit represented by the following formula (4-1) and a repeating unit represented by the following formula (4-2), and a compound represented by the following formula (5), 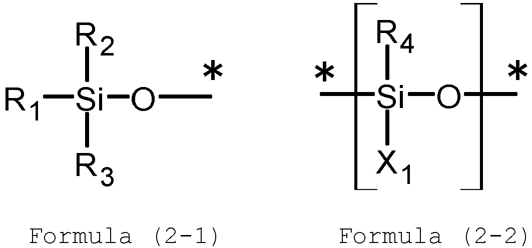
wherein, in formula (2-1), R₁ to R₃ each independently represent a hydrogen atom, a hydroxy group, or a hydrocarbon group having 1 to 6 carbon atoms, and * represents a bond,
wherein, in formula (2-2), R₄ represents a hydrogen atom, a hydroxy group, or a hydrocarbon group having 1 to 6 carbon atoms, X₁ represents a monovalent group having 9 to 30 carbon atoms and having a styrylene structure represented by the formula (1), and * represents a bond, 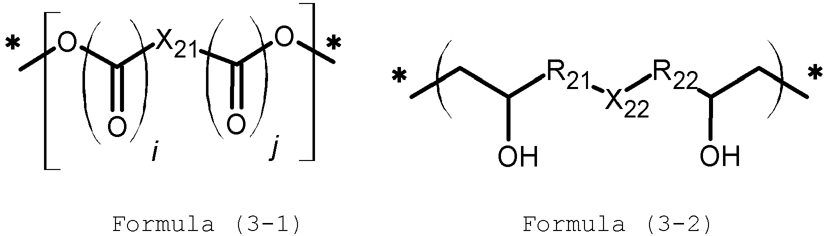
wherein, in formula (3-1), X₂₁ represents a divalent group having 8 to 30 carbon atoms and having a styrylene structure represented by the formula (1), i and j each independently represent 0 or 1, and * represents a bond,
wherein, in formula (3-2), X₂₂ represents a group represented by the following formula (B), R₂₁ and R₂₂ each independently represent a single bond or an alkylene group having 1 to 10 carbon atoms and * represents a bond, 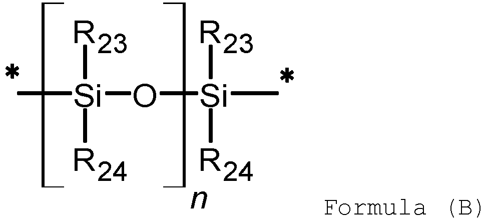
wherein, in formula (B), R₂₃ and R₂₄ each independently represent a hydrogen atom, a hydroxy group, or a hydrocarbon group having 1 to 6 carbon atoms, n represents an integer of 0 or more, and * represents a bond, 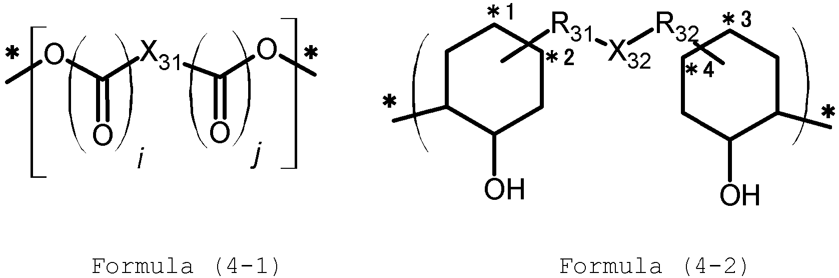
wherein, in formula (4-1), X₃₁ represents a divalent group having 8 to 30 carbon atoms and having a styrylene structure represented by the formula (1), i and j each independently represent 0 or 1, And * represents a bond,
wherein, in formula (4-2), X₃₂ represents a group represented by the formula (B), R₃₁ and R₃₂ each independently represent a single bond or an alkylene group having 1 to 10 carbon atoms, * represents a bond, R₃₁ is bonded to a *1 carbon atom or a *2 carbon atom, R₃₂ is bonded to a*3 carbon atom or a *4 carbon atom, and 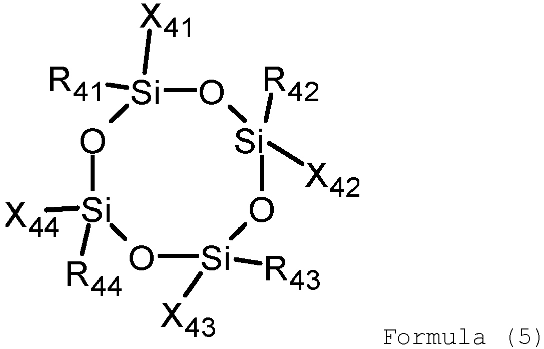
wherein, in formula (5), R₄₁ to R₄₄ each independently represent a hydrogen atom, a hydroxy group, or a monovalent group having 1 to 30 carbon atoms, and X₄₁ to X₄₄ each independently represent a hydrogen atom, a hydroxy group, or a monovalent group having 1 to 30 carbon atoms, provided that at least one of X₄₁ to X₄₄ represents a monovalent group having 9 to 30 carbon atoms and having a styrylene structure represented by the formula (1), and, when two or more of X₄₁ to X₄₄ are monovalent groups each having 9 to 30 carbon atoms and each having a styrylene structure represented by the formula (1), they may be the same or different.

9. The laminate according to claim 8, wherein
in the formula (2-2), X₁ is a monovalent group represented by any one of the following formulas (A-1) to (A-4),
in the formula (3-1), X₂₁ is a divalent group represented by the following formula (C),
in the formula (4-1), X₃₁ is a divalent group represented by the following formula (C), and
in the formula (5), the monovalent group having 9 to 30 carbon atoms and having a styrylene structure represented by the formula (1) is a monovalent group represented by either one of the following formulas (D-1) and (D-2), 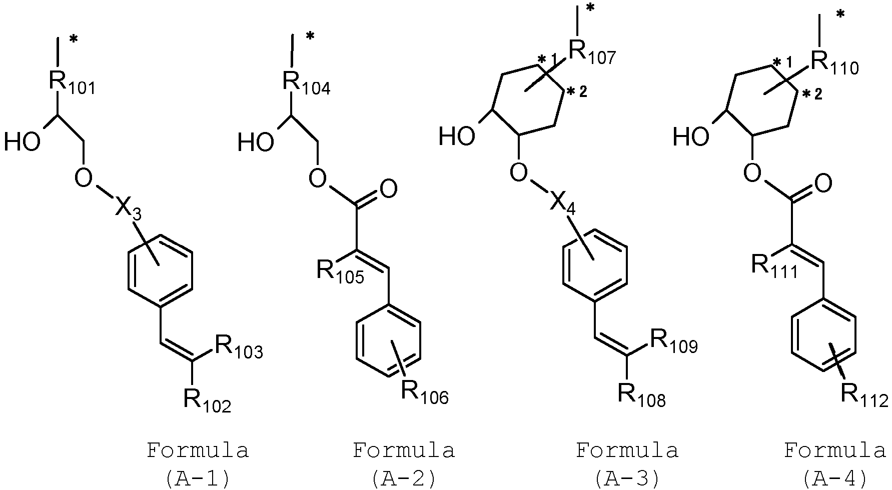
wherein, in formula (A-1), R₁₀₁ represents a single bond or an alkylene group having 1 to 10 carbon atoms, X₃ represents a single bond or -CO-, R₁₀₂ and R₁₀₃ each independently represent a hydrogen atom or a cyano group, and * represents a bond to Si in the formula (2-2),
wherein, in formula (A-2), R₁₀₄ represents a single bond or an alkylene group having 1 to 10 carbon atoms, R₁₀₅ represents a hydrogen atom or a cyano group, R₁₀₆ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, and * represents a bond to Si in the formula (2-2),
wherein, in formula (A-3), R₁₀₇ represents a single bond or an alkylene group having 1 to 10 carbon atoms, X₄ represents a single bond or -CO-, R₁₀₈ and R₁₀₉ each independently represent a hydrogen atom or a cyano group, * represents a bond to Si in the formula (2-2), and R₁₀₇ is bonded to a *1 carbon atom or a *2 carbon atom,
wherein, in formula (A-4), R₁₁₀ represents a single bond or an alkylene group having 1 to 10 carbon atoms, R₁₁₁ represents a hydrogen atom or a cyano group, R₁₁₂ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (2-2), and R₁₁₀ is bonded to a *1 carbon atom or a *2 carbon atom, 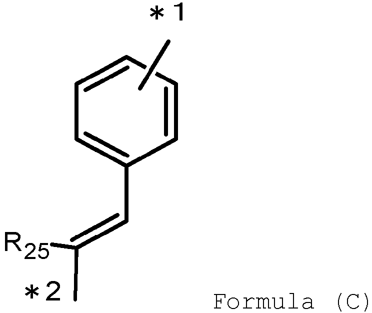
wherein, in formula (C), R₂₅ represents a hydrogen atom or a cyano group, and *1 and *2 each represent a bond, 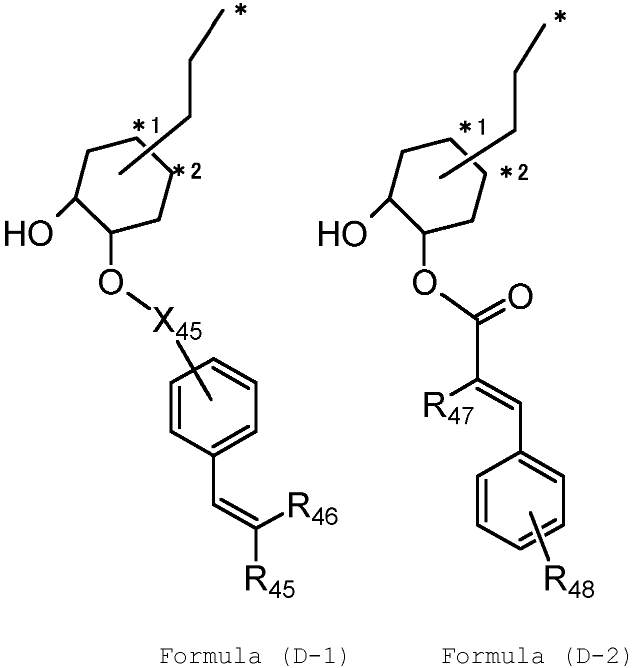
wherein, in formula (D-1), X₄₅ represents a single bond or -CO-, R₄₅ and R₄₆ each independently represent a hydrogen atom or a cyano group, * represents a bond to Si in the formula (5), an ethylene group bonded to Si is bonded to a *1 carbon atom or a *2 carbon atom of a cyclohexane ring, and
wherein, in formula (D-2), R₄₇ represents a hydrogen atom or a cyano group, R₄₈ represents a hydrogen atom, a halogen atom, a hydroxy group, a nitro group, a cyano group, an alkyl group having 1 to 10 carbon atoms, an alkoxy group having 1 to 10 carbon atoms, a halogenated alkyl group having 1 to 10 carbon atoms, or a halogenated alkoxy group having 1 to 10 carbon atoms, * represents a bond to Si in the formula (5), and an ethylene group bonded to Si is bonded to a *1 carbon atom or a *2 carbon atom of a cyclohexane ring.

10. The laminate according to any one of claims 7 to 9, wherein the release agent composition contains a crosslinking agent.

11. The laminate according to any one of claims 7 to 10, wherein the adhesive layer is formed of an adhesive composition containing a compound having a siloxane structure.

12. The laminate according to claim 11, wherein the adhesive composition contains a curable component (A).

13. The laminate according to claim 12, wherein the component (A) is curable by a hydrosilylation reaction.

14. The laminate according to claim 12 or 13, wherein
the component (A) contains:
a polyorganosiloxane (a1) having an alkenyl group having 2 to 40 carbon atoms and bonded to a silicon atom;
a polyorganosiloxane (a2) having a Si-H group; and
a platinum group metal-based catalyst (A2).

15. A method for manufacturing a processed semiconductor substrate, the method comprising:
a first step of processing the semiconductor substrate of the laminate according to any one of claims 7 to 14;
a second step of separating the semiconductor substrate processed in the first step and the support substrate from each other; and
a third step of cleaning the separated semiconductor substrate with a cleaning agent composition.

16. The method for manufacturing a processed semiconductor substrate according to claim 15, wherein the second step comprises a step of irradiating the release layer with light.

17. The method for manufacturing a processed semiconductor substrate according to claim 15 or 16, wherein the cleaning agent composition contains a quaternary ammonium salt and a solvent.

18. The method for manufacturing a processed semiconductor substrate according to claim 17, wherein the quaternary ammonium salt is a halogen-containing quaternary ammonium salt.

19. The method for manufacturing a processed semiconductor substrate according to claim 18, wherein the halogen-containing quaternary ammonium salt is a fluorine-containing quaternary ammonium salt.

## Patentansprüche

1. Verbindung, die eine durch die folgende Formel (1) dargestellte Styrylen-Struktur als erste Struktur und eine Siloxan-Struktur als zweite Struktur aufweist, 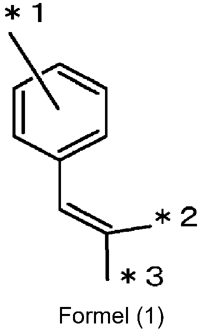
wobei in Formel (1) *1 bis *3 jeweils unabhängig voneinander eine Bindung darstellen und wobei die Verbindung mit einer Styrylen-Struktur ausgewählt ist aus der Gruppe, die besteht aus einer Verbindung mit einer durch die folgende Formel (2-1) dargestellten Struktur und einer durch die folgende Formel (2-2) dargestellten Wiederholungseinheit, einer Verbindung mit einer durch die folgende Formel (3-1) dargestellten Wiederholungseinheit und einer durch die folgende Formel (3-2) dargestellten Wiederholungseinheit, einer Verbindung mit einer durch die folgende Formel (4-1) dargestellten Wiederholungseinheit und einer durch die folgende Formel (4-2) dargestellten Wiederholungseinheit und einer durch die folgende Formel (5) dargestellten Verbindung, 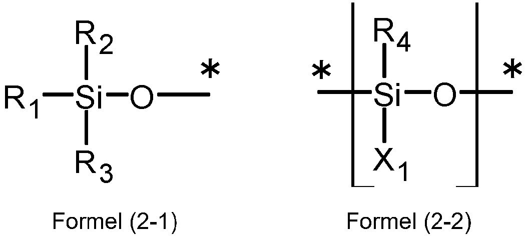
wobei in Formel (2-1) R₁ bis R₃ jeweils unabhängig voneinander ein Wasserstoffatom, eine Hydroxygruppe oder eine Kohlenwasserstoffgruppe mit 1 bis 6 Kohlenstoffatomen darstellen und * eine Bindung darstellt,
wobei in Formel (2-2) R₄ ein Wasserstoffatom, eine Hydroxygruppe oder eine Kohlenwasserstoffgruppe mit 1 bis 6 Kohlenstoffatomen darstellt, X₁ eine einwertige Gruppe mit 9 bis 30 Kohlenstoffatomen und mit einer durch die Formel (1) dargestellten Styrylen-Struktur darstellt und * eine Bindung darstellt, 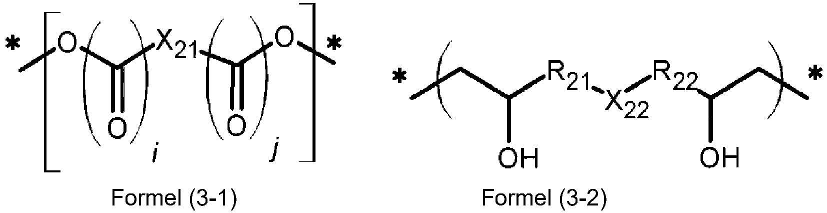
wobei in Formel (3-1) X₂₁ eine zweiwertige Gruppe mit 8 bis 30 Kohlenstoffatomen und mit einer durch die Formel (1) dargestellten Styrylen-Struktur darstellt, i und j jeweils unabhängig voneinander 0 oder 1 darstellen und * eine Bindung darstellt,
wobei in Formel (3-2) X₂₂ eine durch die folgende Formel (B) dargestellte Gruppe darstellt, R₂₁ und R₂₂ jeweils unabhängig voneinander eine Einfachbindung oder eine Alkylengruppe mit 1 bis 10 Kohlenstoffatomen darstellen und * eine Bindung darstellt, 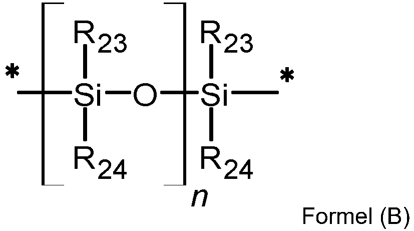
wobei in Formel (B) R₂₃ und R₂₄ jeweils unabhängig voneinander ein Wasserstoffatom, eine Hydroxygruppe oder eine Kohlenwasserstoffgruppe mit 1 bis 6 Kohlenstoffatomen darstellen, n eine ganze Zahl von 0 oder mehr darstellt und * eine Bindung darstellt, 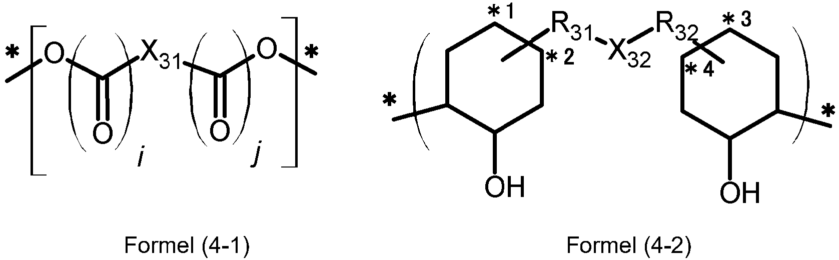
wobei in Formel (4-1) X₃₁ eine zweiwertige Gruppe mit 8 bis 30 Kohlenstoffatomen und mit einer durch die Formel (1) dargestellten Styrylen-Struktur darstellt, i und j jeweils, unabhängig voneinander, 0 oder 1 darstellen, und * eine Bindung darstellt,
wobei in Formel (4-2) X₃₂ eine durch die Formel (B) dargestellte Gruppe darstellt, R₃₁ und R₃₂ jeweils unabhängig voneinander eine Einfachbindung oder eine Alkylengruppe mit 1 bis 10 Kohlenstoffatomen darstellen, * eine Bindung darstellt, R₃₁ an ein *1-Kohlenstoffatom oder ein *2-Kohlenstoffatom gebunden ist, R₃₂ an ein *3-Kohlenstoffatom oder ein *4-Kohlenstoffatom gebunden ist und 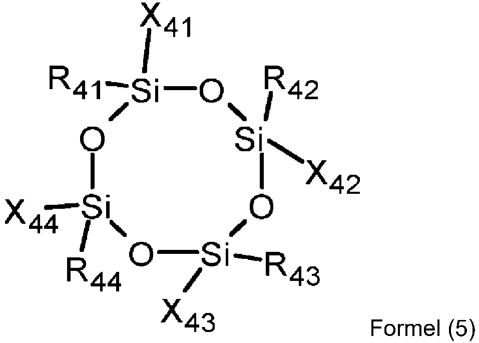
wobei in Formel (5) R₄₁ bis R₄₄ jeweils unabhängig voneinander ein Wasserstoffatom, eine Hydroxygruppe oder eine einwertige Gruppe mit 1 bis 30 Kohlenstoffatomen darstellen und X₄₁ bis X₄₄ jeweils unabhängig voneinander ein Wasserstoffatom, eine Hydroxygruppe oder eine einwertige Gruppe mit 1 bis 30 Kohlenstoffatomen darstellen, mit der Maßgabe, dass mindestens eines von X₄₁ bis X₄₄ eine einwertige Gruppe mit 9 bis 30 Kohlenstoffatomen und mit einer durch die Formel (1) dargestellten Styrylen-Struktur darstellt und dass, wenn zwei oder mehr von X₄₁ bis X₄₄ jeweils einwertige Gruppen mit jeweils 9 bis 30 Kohlenstoffatomen und jeweils mit einer durch die Formel (1) dargestellten Styrylen-Struktur sind, sie gleich oder verschieden sein können.

2. Verbindung nach Anspruch 1, wobei
in der Formel (2-2) X₁ eine durch eine der folgenden Formeln (A-1) bis (A-4) dargestellte einwertige Gruppe ist,
in der Formel (3-1) X₂₁ eine durch die folgende Formel (C) dargestellte zweiwertige Gruppe ist,
in der Formel (4-1) X₃₁ eine durch die folgende Formel (C) dargestellte zweiwertige Gruppe ist und
in der Formel (5) die einwertige Gruppe mit 9 bis 30 Kohlenstoffatomen und mit einer durch die Formel (1) dargestellten Styrylen-Struktur eine durch eine der folgenden Formeln (D-1) und (D-2) dargestellte einwertige Gruppe ist, 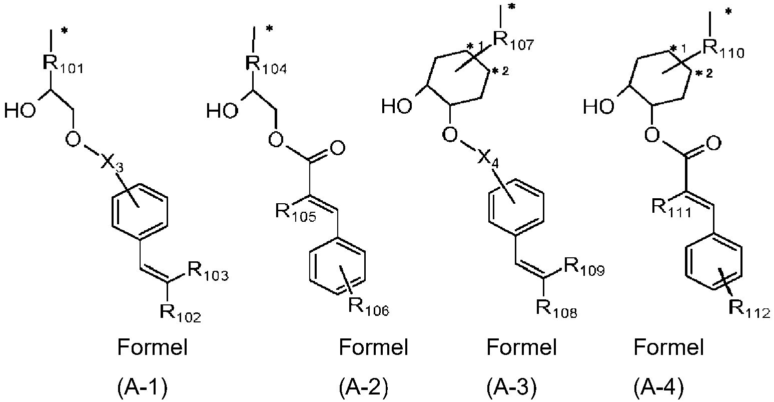
wobei in Formel (A-1) R₁₀₁ eine Einfachbindung oder eine Alkylengruppe mit 1 bis 10 Kohlenstoffatomen darstellt, X₃ eine Einfachbindung oder -CO- darstellt, R₁₀₂ und R₁₀₃ jeweils unabhängig voneinander ein Wasserstoffatom oder eine Cyanogruppe darstellen und * eine Bindung an Si in Formel (2-2) darstellt,
wobei in Formel (A-2) R₁₀₄ eine Einfachbindung oder eine Alkylengruppe mit 1 bis 10 Kohlenstoffatomen darstellt, R₁₀₅ ein Wasserstoffatom oder eine Cyanogruppe darstellt, R₁₀₆ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt und * eine Bindung an Si in Formel (2-2) darstellt,
wobei in Formel (A-3) R₁₀₇ eine Einfachbindung oder eine Alkylengruppe mit 1 bis 10 Kohlenstoffatomen darstellt, X₄ eine Einfachbindung oder -CO- darstellt, R₁₀₈ und R₁₀₉ jeweils unabhängig voneinander ein Wasserstoffatom oder eine Cyanogruppe darstellen, * eine Bindung an Si in Formel (2-2) darstellt und R₁₀₇ an ein *1-Kohlenstoffatom oder ein *2-Kohlenstoffatom gebunden ist,
wobei in Formel (A-4) R₁₁₀ eine Einfachbindung oder eine Alkylengruppe mit 1 bis 10 Kohlenstoffatomen darstellt, R₁₁₁ ein Wasserstoffatom oder eine Cyanogruppe darstellt, R₁₁₂ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen, oder eine halogenierte Alkoxygruppe mit 1 bis 10 Kohlenstoffatomen darstellt, * eine Bindung an Si in Formel (2-2) darstellt und R₁₁₀ an ein *1-Kohlenstoffatom oder ein *2-Kohlenstoffatom gebunden ist, 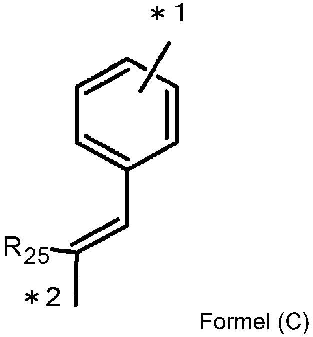
wobei in Formel (C) R₂₅ ein Wasserstoffatom oder eine Cyanogruppe darstellt und *1 und *2 jeweils eine Bindung darstellen, 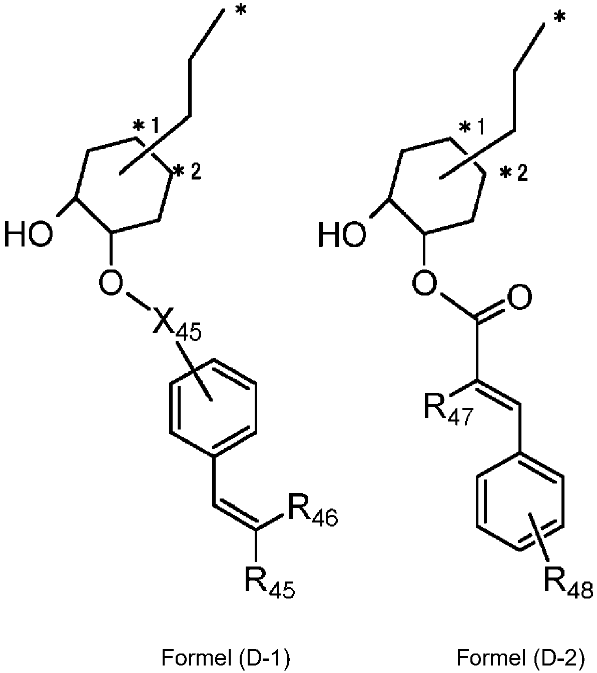
wobei in Formel (D-1) X₄₅ eine Einfachbindung oder -CO- darstellt, R₄₅ und R₄₆ jeweils unabhängig voneinander ein Wasserstoffatom oder eine Cyanogruppe darstellen, * eine Bindung an Si in Formel (5) darstellt, eine an Si gebundene Ethylengruppe an ein *1-Kohlenstoffatom oder ein *2-Kohlenstoffatom eines Cyclohexanrings gebunden ist und
wobei in Formel (D-2) R₄₇ ein Wasserstoffatom oder eine Cyanogruppe darstellt, R₄₈ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen, oder eine halogenierte Alkoxygruppe mit 1 bis 10 Kohlenstoffatomen darstellt, * eine Bindung an Si in Formel (5) darstellt und eine an Si gebundene Ethylengruppe an ein *1-Kohlenstoffatom oder ein *2-Kohlenstoffatom eines Cyclohexanrings gebunden ist.

3. Trennmittelzusammensetzung, umfassend eine Verbindung wie in Anspruch 1 oder 2 definiert.

4. Trennmittelzusammensetzung nach Anspruch 3, wobei die in der Trennmittelzusammensetzung enthaltene Verbindung mindestens eine ist, ausgewählt aus der Gruppe bestehend aus einer Verbindung mit einer durch die folgende Formel (2-1) dargestellten Struktur und einer durch die folgende Formel (2-2) dargestellten Wiederholungseinheit, einer Verbindung mit einer durch die folgende Formel (3-1) dargestellten Wiederholungseinheit und einer durch die folgende Formel (3-2) dargestellten Wiederholungseinheit, einer Verbindung mit einer durch die folgende Formel (4-1) dargestellten Wiederholungseinheit und einer durch die folgende Formel (4-2) dargestellten Wiederholungseinheit und einer durch die folgende Formel (5) dargestellten Verbindung, 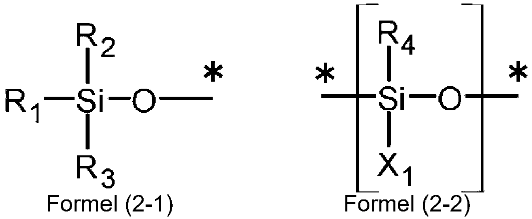
wobei in Formel (2-1) R₁ bis R₃ jeweils unabhängig voneinander ein Wasserstoffatom, eine Hydroxygruppe oder eine Kohlenwasserstoffgruppe mit 1 bis 6 Kohlenstoffatomen darstellen und * eine Bindung darstellt,
wobei in Formel (2-2) R₄ ein Wasserstoffatom, eine Hydroxygruppe oder eine Kohlenwasserstoffgruppe mit 1 bis 6 Kohlenstoffatomen darstellt, X₁ eine einwertige Gruppe mit 9 bis 30 Kohlenstoffatomen und mit einer durch die Formel (1) dargestellten Styrylen-Struktur darstellt und * eine Bindung darstellt, 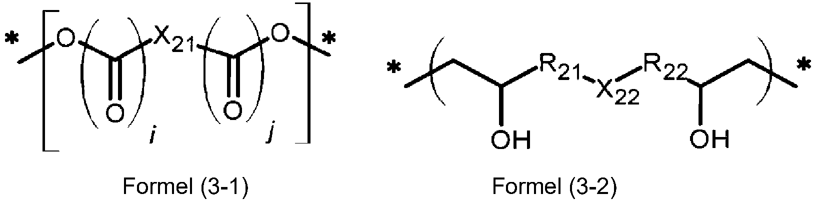
wobei in Formel (3-1) X₂₁ eine zweiwertige Gruppe mit 8 bis 30 Kohlenstoffatomen und mit einer durch die Formel (1) dargestellten Styrylen-Struktur darstellt, i und j jeweils unabhängig voneinander 0 oder 1 darstellen und * eine Bindung darstellt,
wobei in Formel (3-2) X₂₂ eine durch die folgende Formel (B) dargestellte Gruppe darstellt, R₂₁ und R₂₂ jeweils unabhängig voneinander eine Einfachbindung oder eine Alkylengruppe mit 1 bis 10 Kohlenstoffatomen darstellen und * eine Bindung darstellt, 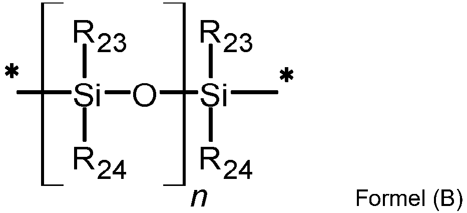
wobei in Formel (B) R₂₃ und R₂₄ jeweils unabhängig voneinander ein Wasserstoffatom, eine Hydroxygruppe oder eine Kohlenwasserstoffgruppe mit 1 bis 6 Kohlenstoffatomen darstellen, n eine ganze Zahl von 0 oder mehr darstellt und * eine Bindung darstellt, 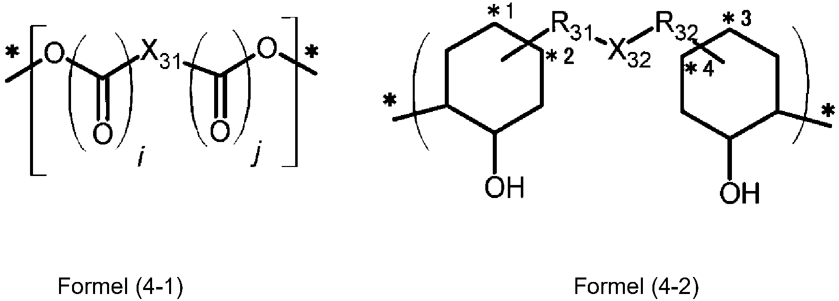
wobei in Formel (4-1) X₃₁ eine zweiwertige Gruppe mit 8 bis 30 Kohlenstoffatomen und mit einer durch die Formel (1) dargestellten Styrylen-Struktur darstellt, i und j jeweils, unabhängig voneinander, 0 oder 1 darstellen, und * eine Bindung darstellt,
wobei in Formel (4-2) X₃₂ eine durch die Formel (B) dargestellte Gruppe darstellt, R₃₁ und R₃₂ jeweils unabhängig voneinander eine Einfachbindung oder eine Alkylengruppe mit 1 bis 10 Kohlenstoffatomen darstellen, * eine Bindung darstellt, R₃₁ an ein *1-Kohlenstoffatom oder ein *2-Kohlenstoffatom gebunden ist, R₃₂ an ein *3-Kohlenstoffatom oder ein *4-Kohlenstoffatom gebunden ist und 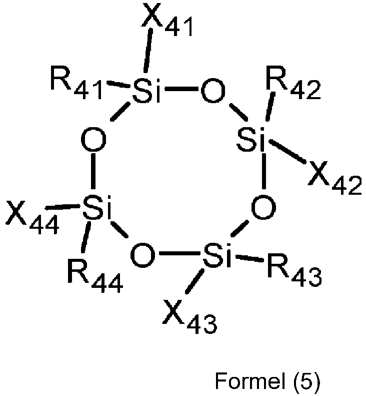
wobei in Formel (5) R₄₁ bis R₄₄ jeweils unabhängig voneinander ein Wasserstoffatom, eine Hydroxygruppe oder eine einwertige Gruppe mit 1 bis 30 Kohlenstoffatomen darstellen und X₄₁ bis X₄₄ jeweils unabhängig voneinander ein Wasserstoffatom, eine Hydroxygruppe, oder eine einwertige Gruppe mit 1 bis 30 Kohlenstoffatomen darstellen, mit der Maßgabe, dass mindestens eines von X₄₁ bis X₄₄ eine einwertige Gruppe mit 9 bis 30 Kohlenstoffatomen und mit einer durch die Formel (1) dargestellten Styrylen-Struktur darstellt und dass, wenn zwei oder mehr von X₄₁ bis X₄₄ jeweils einwertige Gruppen mit jeweils 9 bis 30 Kohlenstoffatomen und jeweils mit einer durch die Formel (1) dargestellten Styrylen-Struktur sind, sie gleich oder verschieden sein können.

5. Trennmittelzusammensetzung nach Anspruch 4, wobei
in der Formel (2-2) X₁ eine durch eine der folgenden Formeln (A-1) bis (A-4) dargestellte einwertige Gruppe ist,
in der Formel (3-1) X₂₁ eine durch die folgende Formel (C) dargestellte zweiwertige Gruppe ist,
in der Formel (4-1) X₃₁ eine durch die folgende Formel (C) dargestellte zweiwertige Gruppe ist und
in der Formel (5) die einwertige Gruppe mit 9 bis 30 Kohlenstoffatomen und mit einer durch die Formel (1) dargestellten Styrylen-Struktur eine durch eine der folgenden Formeln (D-1) und (D-2) dargestellte einwertige Gruppe ist, 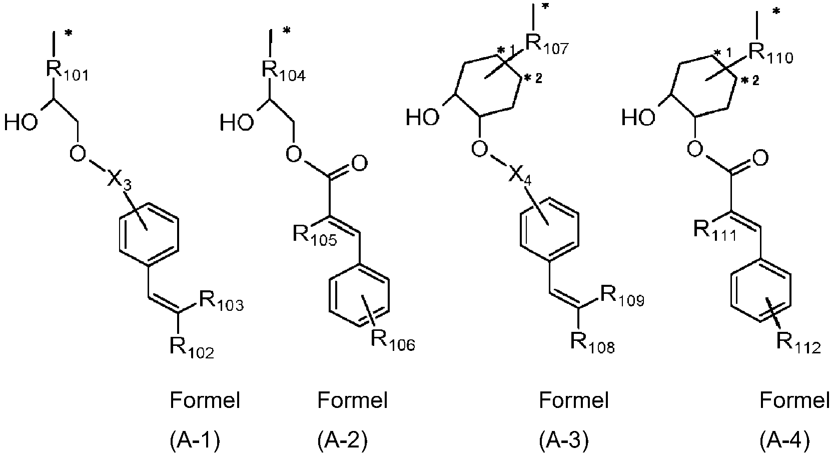
wobei in Formel (A-1) R₁₀₁ eine Einfachbindung oder eine Alkylengruppe mit 1 bis 10 Kohlenstoffatomen darstellt, X₃ eine Einfachbindung oder -CO- darstellt, R₁₀₂ und R₁₀₃ jeweils unabhängig voneinander ein Wasserstoffatom oder eine Cyanogruppe darstellen und * eine Bindung an Si in Formel (2-2) darstellt,
wobei in Formel (A-2) R₁₀₄ eine Einfachbindung oder eine Alkylengruppe mit 1 bis 10 Kohlenstoffatomen darstellt, R₁₀₅ ein Wasserstoffatom oder eine Cyanogruppe darstellt, R₁₀₆ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt und * eine Bindung an Si in Formel (2-2) darstellt,
wobei in Formel (A-3) R₁₀₇ eine Einfachbindung oder eine Alkylengruppe mit 1 bis 10 Kohlenstoffatomen darstellt, X₄ eine Einfachbindung oder -CO- darstellt, R₁₀₈ und R₁₀₉ jeweils unabhängig voneinander ein Wasserstoffatom oder eine Cyanogruppe darstellen, * eine Bindung an Si in Formel (2-2) darstellt und R₁₀₇ an ein *1-Kohlenstoffatom oder ein *2-Kohlenstoffatom gebunden ist,
wobei in Formel (A-4) R₁₁₀ eine Einfachbindung oder eine Alkylengruppe mit 1 bis 10 Kohlenstoffatomen darstellt, R₁₁₁ ein Wasserstoffatom oder eine Cyanogruppe darstellt, R₁₁₂ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt, * eine Bindung an Si in Formel (2-2) darstellt und R₁₁₀ an ein *1-Kohlenstoffatom oder ein *2-Kohlenstoffatom gebunden ist, 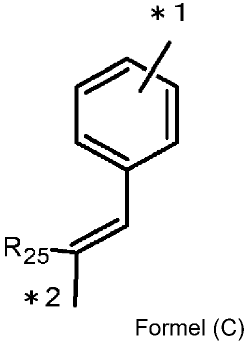
wobei in Formel (C) R₂₅ ein Wasserstoffatom oder eine Cyanogruppe darstellt und *1 und *2 jeweils eine Bindung darstellen, 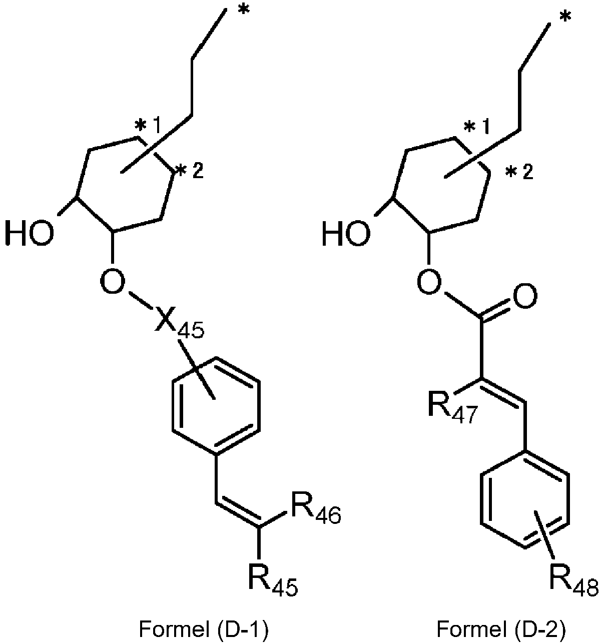
wobei in Formel (D-1) X₄₅ eine Einfachbindung oder -CO- darstellt, R₄₅ und R₄₆ jeweils unabhängig voneinander ein Wasserstoffatom oder eine Cyanogruppe darstellen, * eine Bindung an Si in Formel (5) darstellt, eine an Si gebundene Ethylengruppe an ein *1-Kohlenstoffatom oder ein *2-Kohlenstoffatom eines Cyclohexanrings gebunden ist und
wobei in Formel (D-2) R₄₇ ein Wasserstoffatom oder eine Cyanogruppe darstellt, R₄₈ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt, * eine Bindung an Si in Formel (5) darstellt und eine an Si gebundene Ethylengruppe an ein *1-Kohlenstoffatom oder ein *2-Kohlenstoffatom eines Cyclohexanrings gebunden ist.

6. Trennmittelzusammensetzung nach einem der Ansprüche 3 bis 5, umfassend ein Vernetzungsmittel.

7. Laminat, umfassend:
ein Halbleitersubstrat;
ein lichtdurchlässiges Trägersubstrat; und
eine Klebeschicht und eine Trennschicht, angeordnet zwischen dem Halbleitersubstrat und dem Trägersubstrat,
wobei das Laminat zum Trennen des Halbleitersubstrats und des Trägersubstrats verwendet wird, nachdem die Trennschicht von der Seite des Trägersubstrats emittiertes Licht absorbiert hat, wobei
die Trennschicht aus einer Trennmittelzusammensetzung gebildet ist, wie in Anspruch 3 definiert.

8. Laminat nach Anspruch 7, wobei die in der Trennmittelzusammensetzung enthaltene Verbindung mindestens eine ist, ausgewählt aus der Gruppe bestehend aus einer Verbindung mit einer durch die folgende Formel (2-1) dargestellten Struktur und einer durch die folgende Formel (2-2) dargestellten Wiederholungseinheit, einer Verbindung mit einer durch die folgende Formel (3-1) dargestellten Wiederholungseinheit und einer durch die folgende Formel (3-2) dargestellten Wiederholungseinheit, einer Verbindung mit einer durch die folgende Formel (4-1) dargestellten Wiederholungseinheit und einer durch die folgende Formel (4-2) dargestellten Wiederholungseinheit und einer durch die folgende Formel (5) dargestellten Verbindung, 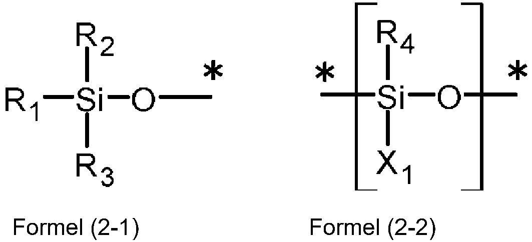
wobei in Formel (2-1) R₁ bis R₃ jeweils unabhängig voneinander ein Wasserstoffatom, eine Hydroxygruppe oder eine Kohlenwasserstoffgruppe mit 1 bis 6 Kohlenstoffatomen darstellen und * eine Bindung darstellt,
wobei in Formel (2-2) R₄ ein Wasserstoffatom, eine Hydroxygruppe oder eine Kohlenwasserstoffgruppe mit 1 bis 6 Kohlenstoffatomen darstellt, X₁ eine einwertige Gruppe mit 9 bis 30 Kohlenstoffatomen und mit einer durch die Formel (1) dargestellten Styrylen-Struktur darstellt und * eine Bindung darstellt, 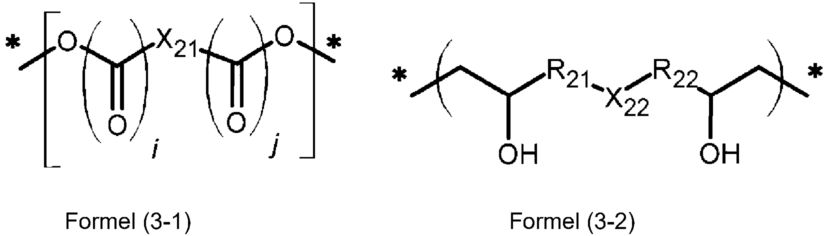
wobei in Formel (3-1) X₂₁ eine zweiwertige Gruppe mit 8 bis 30 Kohlenstoffatomen und mit einer durch die Formel (1) dargestellten Styrylen-Struktur darstellt, i und j jeweils unabhängig voneinander 0 oder 1 darstellen und * eine Bindung darstellt,
wobei in Formel (3-2) X₂₂ eine durch die folgende Formel (B) dargestellte Gruppe darstellt, R₂₁ und R₂₂ jeweils unabhängig voneinander eine Einfachbindung oder eine Alkylengruppe mit 1 bis 10 Kohlenstoffatomen darstellen und * eine Bindung darstellt, 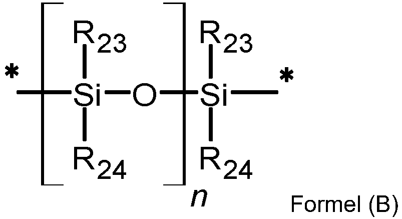
wobei in Formel (B) R₂₃ und R₂₄ jeweils unabhängig voneinander ein Wasserstoffatom, eine Hydroxygruppe oder eine Kohlenwasserstoffgruppe mit 1 bis 6 Kohlenstoffatomen darstellen, n eine ganze Zahl von 0 oder mehr darstellt und * eine Bindung darstellt, 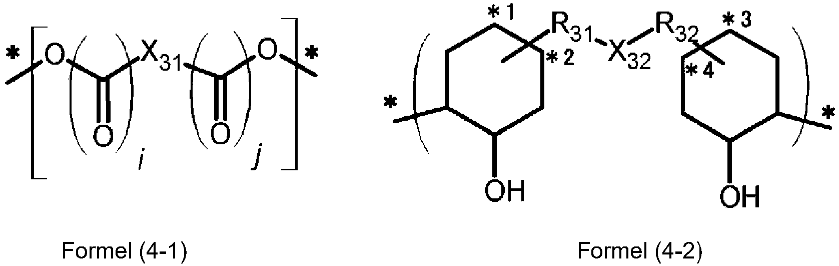
wobei in Formel (4-1) X₃₁ eine zweiwertige Gruppe mit 8 bis 30 Kohlenstoffatomen und mit einer durch die Formel (1) dargestellten Styrylen-Struktur darstellt, i und j jeweils, unabhängig voneinander, 0 oder 1 darstellen, und * eine Bindung darstellt,
wobei in Formel (4-2) X₃₂ eine durch die Formel (B) dargestellte Gruppe darstellt, R₃₁ und R₃₂ jeweils unabhängig voneinander eine Einfachbindung oder eine Alkylengruppe mit 1 bis 10 Kohlenstoffatomen darstellen, * eine Bindung darstellt, R₃₁ an ein *1-Kohlenstoffatom oder ein *2-Kohlenstoffatom gebunden ist, R₃₂ an ein *3-Kohlenstoffatom oder ein *4-Kohlenstoffatom gebunden ist und 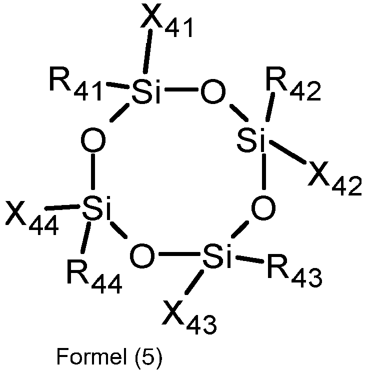
wobei in Formel (5) R₄₁ bis R₄₄ jeweils unabhängig voneinander ein Wasserstoffatom, eine Hydroxygruppe oder eine einwertige Gruppe mit 1 bis 30 Kohlenstoffatomen darstellen und X₄₁ bis X₄₄ jeweils unabhängig voneinander ein Wasserstoffatom, eine Hydroxygruppe oder eine einwertige Gruppe mit 1 bis 30 Kohlenstoffatomen darstellen, mit der Maßgabe, dass mindestens eines von X₄₁ bis X₄₄ eine einwertige Gruppe mit 9 bis 30 Kohlenstoffatomen und mit einer durch die Formel (1) dargestellten Styrylen-Struktur darstellt und dass, wenn zwei oder mehr von X₄₁ bis X₄₄ jeweils einwertige Gruppen mit jeweils 9 bis 30 Kohlenstoffatomen und jeweils mit einer durch die Formel (1) dargestellten Styrylen-Struktur sind, sie gleich oder verschieden sein können.

9. Laminat nach Anspruch 8, wobei
in der Formel (2-2) X₁ eine durch eine der folgenden Formeln (A-1) bis (A-4) dargestellte einwertige Gruppe ist,
in der Formel (3-1) X₂₁ eine durch die folgende Formel (C) dargestellte zweiwertige Gruppe ist,
in der Formel (4-1) X₃₁ eine durch die folgende Formel (C) dargestellte zweiwertige Gruppe ist und
in der Formel (5) die einwertige Gruppe mit 9 bis 30 Kohlenstoffatomen und mit einer durch die Formel (1) dargestellten Styrylen-Struktur eine durch eine der folgenden Formeln (D-1) und (D-2) dargestellte einwertige Gruppe ist, 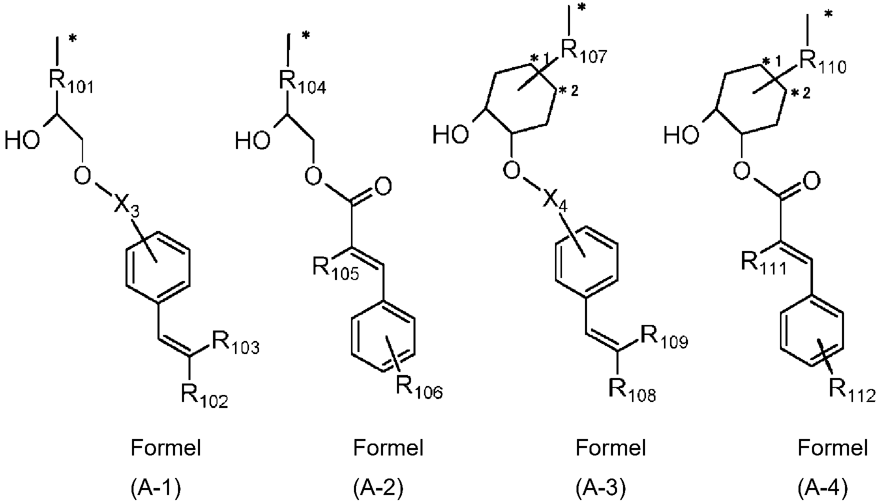
wobei in Formel (A-1) R₁₀₁ eine Einfachbindung oder eine Alkylengruppe mit 1 bis 10 Kohlenstoffatomen darstellt, X₃ eine Einfachbindung oder -CO- darstellt, R₁₀₂ und R₁₀₃ jeweils unabhängig voneinander ein Wasserstoffatom oder eine Cyanogruppe darstellen und * eine Bindung an Si in Formel (2-2) darstellt,
wobei in Formel (A-2) R₁₀₄ eine Einfachbindung oder eine Alkylengruppe mit 1 bis 10 Kohlenstoffatomen darstellt, R₁₀₅ ein Wasserstoffatom oder eine Cyanogruppe darstellt, R₁₀₆ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt und * eine Bindung an Si in Formel (2-2) darstellt,
wobei in Formel (A-3) R₁₀₇ eine Einfachbindung oder eine Alkylengruppe mit 1 bis 10 Kohlenstoffatomen darstellt, X₄ eine Einfachbindung oder -CO- darstellt, R₁₀₈ und R₁₀₉ jeweils unabhängig voneinander ein Wasserstoffatom oder eine Cyanogruppe darstellen, * eine Bindung an Si in Formel (2-2) darstellt und R₁₀₇ an ein *1-Kohlenstoffatom oder ein *2-Kohlenstoffatom gebunden ist,
wobei in Formel (A-4) R₁₁₀ eine Einfachbindung oder eine Alkylengruppe mit 1 bis 10 Kohlenstoffatomen darstellt, R₁₁₁ ein Wasserstoffatom oder eine Cyanogruppe darstellt, R₁₁₂ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt, * eine Bindung an Si in Formel (2-2) darstellt und R₁₁₀ an ein *1-Kohlenstoffatom oder ein *2-Kohlenstoffatom gebunden ist, 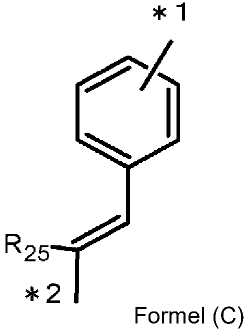
wobei in Formel (C) R₂₅ ein Wasserstoffatom oder eine Cyanogruppe darstellt und *1 und *2 jeweils eine Bindung darstellen, 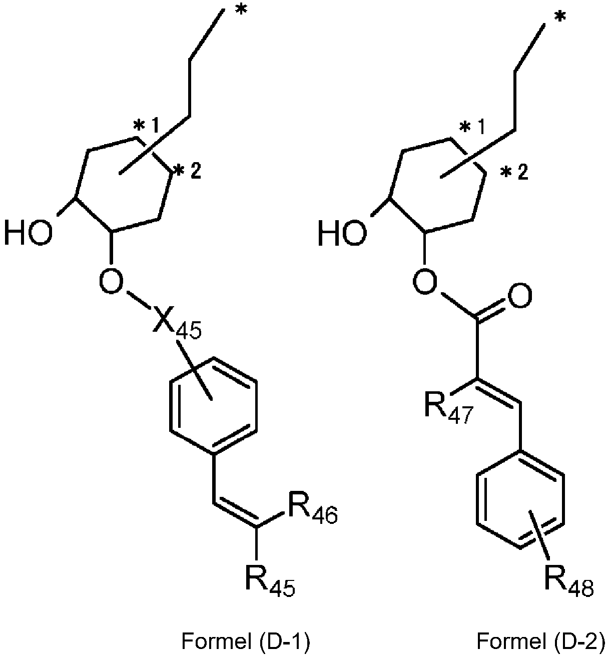
wobei in Formel (D-1) X₄₅ eine Einfachbindung oder -CO- darstellt, R₄₅ und R₄₆ jeweils unabhängig voneinander ein Wasserstoffatom oder eine Cyanogruppe darstellen, * eine Bindung an Si in Formel (5) darstellt, eine an Si gebundene Ethylengruppe an ein *1-Kohlenstoffatom oder ein *2-Kohlenstoffatom eines Cyclohexanrings gebunden ist und
wobei in Formel (D-2) R₄₇ ein Wasserstoffatom oder eine Cyanogruppe darstellt, R₄₈ ein Wasserstoffatom, ein Halogenatom, eine Hydroxygruppe, eine Nitrogruppe, eine Cyanogruppe, eine Alkylgruppe mit 1 bis 10 Kohlenstoffatomen, eine Alkoxygruppe mit 1 bis 10 Kohlenstoffatomen, eine halogenierte Alkylgruppe mit 1 bis 10 Kohlenstoffatomen oder eine halogenierte Alkoxygruppe mit 1 bis 10 Kohlenstoffatomen darstellt, * eine Bindung an Si in Formel (5) darstellt und eine an Si gebundene Ethylengruppe an ein *1-Kohlenstoffatom oder ein *2-Kohlenstoffatom eines Cyclohexanrings gebunden ist.

10. Laminat nach einem der Ansprüche 7 bis 9, wobei die Trennmittelzusammensetzung ein Vernetzungsmittel enthält.

11. Laminat nach einem der Ansprüche 7 bis 10, wobei die Klebeschicht aus einer Klebstoffzusammensetzung gebildet ist, die eine Verbindung mit einer Siloxan-Struktur enthält.

12. Laminat nach Anspruch 11, wobei die Klebstoffzusammensetzung eine härtbare Komponente (A) enthält.

13. Laminat nach Anspruch 12, wobei die Komponente (A) durch eine Hydrosilylierungsreaktion härtbar ist.

14. Laminat nach Anspruch 12 oder 13, wobei
die Komponente (A) enthält:
ein Polyorganosiloxan (a1) mit einer Alkenylgruppe mit 2 bis 40 Kohlenstoffatomen und gebunden an ein Siliziumatom;
ein Polyorganosiloxan (a2) mit einer Si-H-Gruppe; und
einen Katalysator auf Basis eines Platingruppenmetalls (A2).

15. Verfahren zur Herstellung eines verarbeiteten Halbleitersubstrats, das Verfahren umfassend:
einen ersten Schritt des Verarbeitens des Halbleitersubstrats des Laminats nach einem der Ansprüche 7 bis 14;
einen zweiten Schritt des Trennens des im ersten Schritt verarbeiteten Halbleitersubstrats und des Trägersubstrats voneinander; und
einen dritten Schritt des Reinigens des getrennten Halbleitersubstrats mit einer Reinigungsmittelzusammensetzung.

16. Verfahren zur Herstellung eines verarbeiteten Halbleitersubstrats nach Anspruch 15, wobei der zweite Schritt einen Schritt des Bestrahlens der Trennschicht mit Licht umfasst.

17. Verfahren zur Herstellung eines verarbeiteten Halbleitersubstrats nach Anspruch 15 oder 16, wobei die Reinigungsmittelzusammensetzung ein quartäres Ammoniumsalz und ein Lösungsmittel enthält.

18. Verfahren zur Herstellung eines verarbeiteten Halbleitersubstrats nach Anspruch 17, wobei das quartäre Ammoniumsalz ein halogenhaltiges quartäres Ammoniumsalz ist.

19. Verfahren zur Herstellung eines verarbeiteten Halbleitersubstrats nach Anspruch 18, wobei das halogenhaltige quartäre Ammoniumsalz ein fluorhaltiges quartäres Ammoniumsalz ist.

## Revendications

1. Composé ayant une structure styrylène représentée par la formule (1) qui suit en tant que première structure et une structure siloxane en tant que deuxième structure, 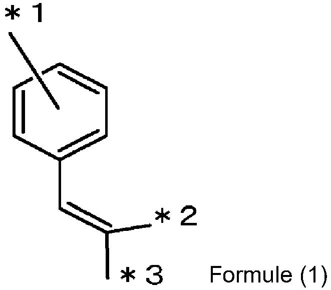
dans lequel, dans la formule (1), *1 à *3 représentent chacun indépendamment une liaison, et dans lequel le composé ayant une structure styrylène est choisi dans le groupe constitué par un composé ayant une structure représentée par la formule (2-1) qui suit et par une unité répétitive représentée par la formule (2-2) qui suit, par un composé ayant une unité répétitive représentée par la formule (3-1) qui suit et par une unité répétitive représentée par la formule (3-2) qui suit, par un composé ayant une unité répétitive représentée par la formule (4-1) qui suit et par une unité répétitive représentée par la formule (4-2) qui suit, et par un composé représenté par la formule (5) qui suit, 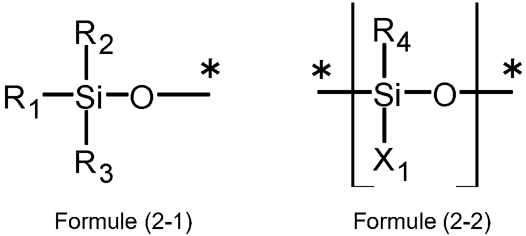
dans lequel, dans la formule (2-1), R₁ à R₃ représentent chacun indépendamment un atome d'hydrogène, un groupe hydroxy, ou un groupe hydrocarboné ayant 1 à 6 atomes de carbone, et * représente une liaison
dans lequel, dans la formule (2-2), R₄ représente un atome d'hydrogène, un groupe hydroxy, ou un groupe hydrocarboné ayant 1 à 6 atomes de carbone, X₁ représente un groupe monovalent ayant 9 à 30 atomes de carbone et ayant une structure styrylène représentée par la formule (1), et * représente une liaison, 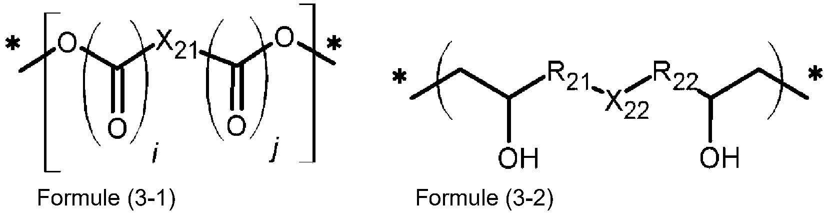
dans lequel, dans la formule (3-1), X₂₁ représente un groupe divalent ayant 8 à 30 atomes de carbone et ayant une structure styrylène représentée par la formule (1), i et j représentent chacun indépendamment 0 ou 1, et * représente une liaison,
dans lequel, dans la formule (3-2), X₂₂ représente un groupe représenté par la formule (B) qui suit, R₂₁ et R₂₂ représentent chacun indépendamment une liaison simple ou un groupe alkylène ayant 1 à 10 atomes de carbone et * représente une liaison, 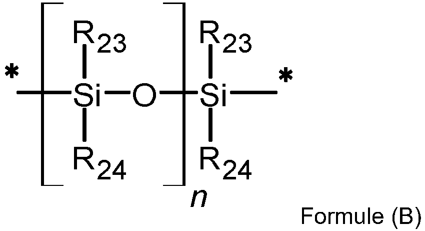
dans lequel, dans la formule (B), R₂₃ et R₂₄ représentent chacun indépendamment un atome d'hydrogène, un groupe hydroxy, ou un groupe hydrocarboné ayant 1 à 6 atomes de carbone, n représente un nombre entier de 0 ou plus, et * représente une liaison, 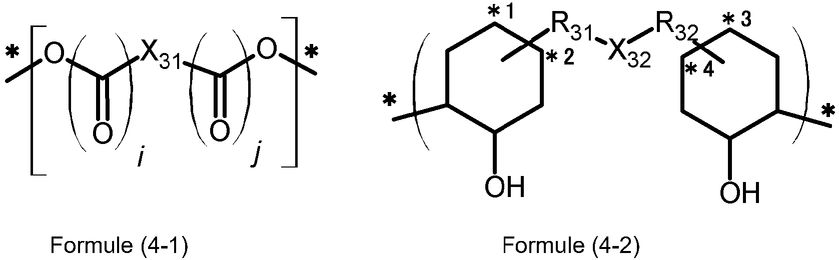
dans lequel, dans la formule (4-1), X₃₁ représente un groupe divalent ayant 8 à 30 atomes de carbone et ayant une structure styrylène représentée par la formule (1), i et j représentent chacun indépendamment 0 ou 1, et * représente une liaison,
dans lequel, dans la formule (4-2), X₃₂ représente un groupe représenté par la formule (B), R₃₁ et R₃₂ représentent chacun indépendamment une liaison simple ou un groupe alkylène ayant 1 à 10 atomes de carbone, * représente une liaison, R₃₂ est lié à un atome de carbone *1 ou à un atome de carbone *2, R₃₂ est lié à un atome de carbone*3 ou à un atome de carbone *4, et 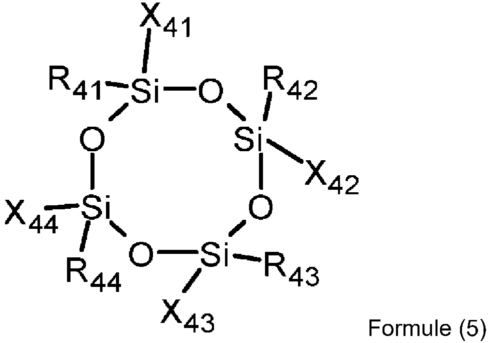
dans lequel, dans la formule (5), R₄₁ à R₄₄ représentent chacun indépendamment un atome d'hydrogène, un groupe hydroxy, ou un groupe monovalent ayant 1 à 30 atomes de carbone, et X₄₁ à X₄₄ représentent chacun indépendamment un atome d'hydrogène, un groupe hydroxy, ou un groupe monovalent ayant 1 à 30 atomes de carbone,
à condition qu'au moins un parmi X₄₁ à X₄₄ représente un groupe monovalent ayant 9 à 30 atomes de carbone et ayant une structure styrylène représentée par la formule (1), et, lorsque deux ou plus parmi X₄₁ à X₄₄ sont des groupes monovalents ayant chacun 9 à 30 atomes de carbone et ayant chacun une structure styrylène représentée par la formule (1), ils peuvent être identiques ou différents.

2. Composé selon la revendication 1, dans lequel
dans la formule (2-2), X₁ est un groupe monovalent représenté par l'une quelconque des formules (A-1) à (A-4) qui suivent,
dans la formule (3-1), X₂₁ est un groupe divalent représenté par la formule (C) qui suit,
dans la formule (4-1), X₃₁ est un groupe divalent représenté par la formule (C) qui suit, et
dans la formule (5), le groupe monovalent ayant 9 à 30 atomes de carbone et ayant une structure styrylène représentée par la formule (1) est un groupe monovalent représenté par l'une ou l'autre des formules (D-1) et (D-2) qui suivent, 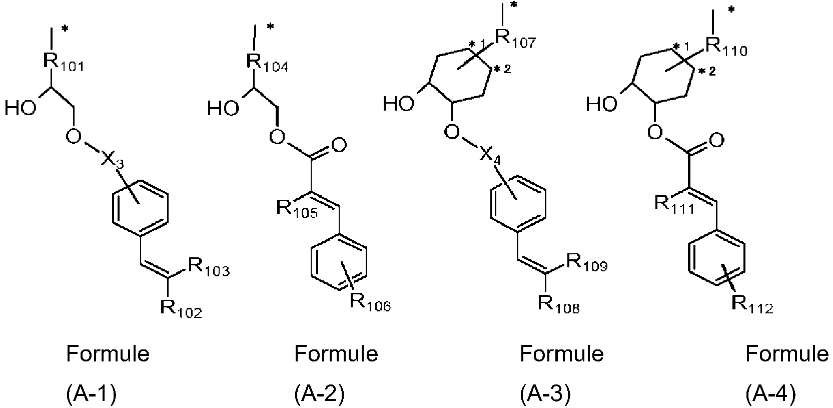
dans lequel, dans la formule (A-1), R₁₀₁ représente une liaison simple ou un groupe alkylène ayant 1 à 10 atomes de carbone, X₃ représente une liaison simple ou -CO-, R₁₀₂ et R₁₀₃ représentent chacun indépendamment un atome d'hydrogène ou un groupe cyano, et * représente une liaison à Si dans la formule (2-2),
dans lequel, dans la formule (A-2), R₁₀₄ représente une liaison simple ou un groupe alkylène ayant 1 à 10 atomes de carbone, R₁₀₅ représente un atome d'hydrogène ou un groupe cyano, R₁₀₆ représente un atome d'hydrogène, un atome d'halogène, un groupe hydroxy, un groupe nitro, un groupe cyano, un groupe alkyle ayant 1 à 10 atomes de carbone, un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, et * représente une liaison à Si dans la formule (2-2),
dans lequel, dans la formule (A-3), R₁₀₇ représente une liaison simple ou un groupe alkylène ayant 1 à 10 atomes de carbone, X₄ représente une liaison simple ou -CO-, R₁₀₈ et R₁₀₉ représentent chacun indépendamment un atome d'hydrogène ou un groupe cyano, * représente une liaison à Si dans la formule (2-2), et R₁₀₇ est lié à un atome de carbone *1 ou à un atome de carbone *2,
dans lequel, dans la formule (A-4), R₁₁₀ représente une liaison simple ou un groupe alkylène ayant 1 à 10 atomes de carbone, R₁₁₁ représente un atome d'hydrogène ou un groupe cyano, R₁₁₂ représente un atome d'hydrogène, un atome d'halogène, un groupe hydroxy, un groupe nitro, un groupe cyano, un groupe alkyle ayant 1 à 10 atomes de carbone, un groupe alcoxy ayant 1 à 10 atomes de carbone, un groupe alkyle halogéné ayant 1 à 10 atomes de carbone,
ou un groupe alcoxy halogéné ayant 1 à 10 atomes de carbone, * représente une liaison à Si dans la formule (2-2), et R₁₁₀ est lié à un atome de carbone *1 ou à un atome de carbone *2, 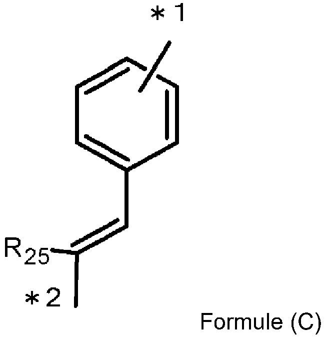
dans lequel, dans la formule (C), R₂₅ représente un atome d'hydrogène ou un groupe cyano, et *1 et *2 représentent chacun une liaison, 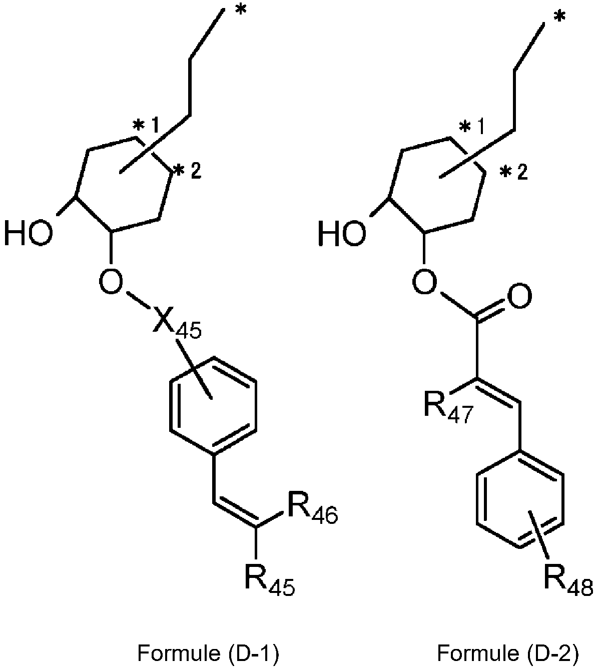
dans lequel, dans la formule (D-1), X₄₅ représente une liaison simple ou -CO-, R₄₅ et R₄₆ représentent chacun indépendamment un atome d'hydrogène ou un groupe cyano, * représente une liaison à Si dans la formule (5), un groupe éthylène lié à Si est lié à un atome de carbone *1 ou à un atome de carbone *2 d'un cycle cyclohexane, et
dans lequel, dans la formule (D-2), R₄₇ représente un atome d'hydrogène ou un groupe cyano, R₄₈ représente un atome d'hydrogène, un atome d'halogène, un groupe hydroxy, un groupe nitro, un groupe cyano, un groupe alkyle ayant 1 à 10 atomes de carbone, un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, * représente une liaison à Si dans la formule (5), et un groupe éthylène lié à Si est lié à un atome de carbone *1 ou à un atome de carbone *2 d'un cycle cyclohexane.

3. Composition d'agent antiadhésif comprenant un composé tel que défini dans la revendication 1 ou la revendication 2.

4. Composition d'agent antiadhésif selon la revendication 3, dans laquelle le composé contenu dans la composition d'agent antiadhésif est au moins un membre, choisi, du groupe constitué par un composé ayant une structure représentée par la formule (2-1) qui suit et par une unité répétitive représentée par la formule (2-2) qui suit,
par un composé ayant une unité répétitive représentée par la formule (3-1) qui suit et par une unité répétitive représentée par la formule (3-2) qui suit, par un composé ayant une unité répétitive représentée par la formule (4-1) qui suit et par une unité répétitive représentée par la formule (4-2) qui suit, et par un composé représenté par la formule (5) qui suit, 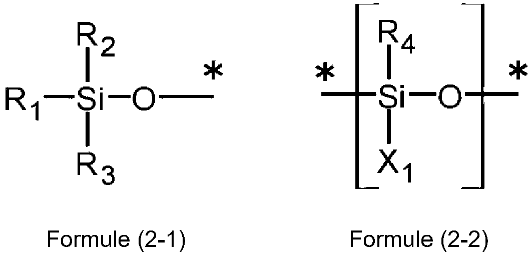
dans laquelle, dans la formule (2-1), R₁ à R₃ représentent chacun indépendamment un atome d'hydrogène, un groupe hydroxy, ou un groupe hydrocarboné ayant 1 à 6 atomes de carbone, et * représente une liaison,
dans laquelle, dans la formule (2-2), R₄ représente un atome d'hydrogène, un groupe hydroxy, ou un groupe hydrocarboné ayant 1 à 6 atomes de carbone, X₁ représente un groupe monovalent ayant 9 à 30 atomes de carbone et ayant une structure styrylène représentée par la formule (1), et * représente une liaison, 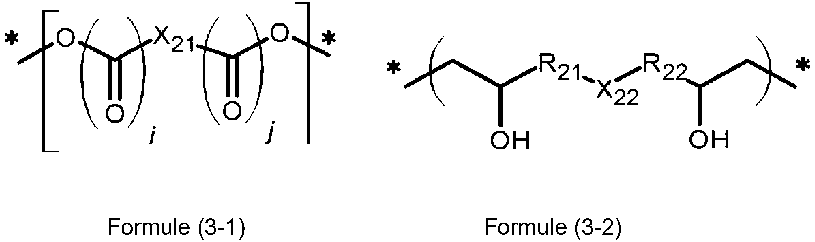
dans laquelle, dans la formule (3-1), X₂₁ représente un groupe divalent ayant 8 à 30 atomes de carbone et ayant une structure styrylène représentée par la formule (1), i et j représentent chacun indépendamment 0 ou 1, et * représente une liaison,
dans laquelle, dans la formule (3-2), X₂₂ représente un groupe représenté par la formule (B) qui suit, R₂₁ et R₂₂ représentent chacun indépendamment une liaison simple ou un groupe alkylène ayant 1 à 10 atomes de carbone et * représente une liaison, 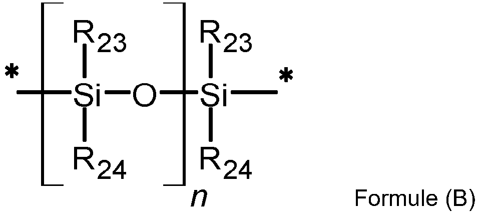
dans laquelle, dans la formule (B), R₂₃ et R₂₄ représentent chacun indépendamment un atome d'hydrogène, un groupe hydroxy, ou un groupe hydrocarboné ayant 1 à 6 atomes de carbone, n représente un nombre entier de 0 ou plus, et * représente une liaison, 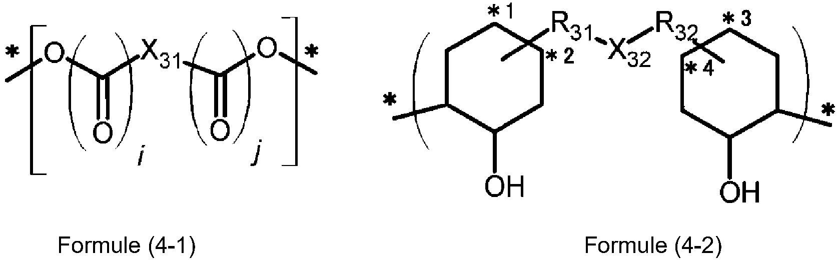
dans laquelle, dans la formule (4-1), X₃₁ représente un groupe divalent ayant 8 à 30 atomes de carbone et ayant une structure styrylène représentée par la formule (1), i et j représentent chacun indépendamment 0 ou 1, et * représente une liaison,
dans laquelle, dans la formule (4-2), X₃₂ représente un groupe représenté par la formule (B), R₃₁ et R₃₂ représentent chacun indépendamment une liaison simple ou un groupe alkylène ayant 1 à 10 atomes de carbone, * représente une liaison, R₃₁ est lié à un atome de carbone *1 ou à un atome de carbone *2, R₃₂ est lié à un atome de carbone*3 ou à un atome de carbone *4, et 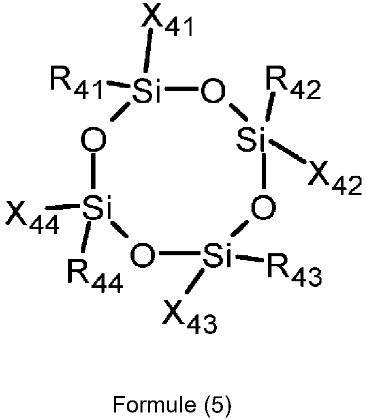
dans laquelle, dans la formule (5), R₄₁ à R₄₄ représentent chacun indépendamment un atome d'hydrogène, un groupe hydroxy, ou un groupe monovalent ayant 1 à 30 atomes de carbone, et X₄₁ à X₄₄ représentent chacun indépendamment un atome d'hydrogène, un groupe hydroxy, ou un groupe monovalent ayant 1 à 30 atomes de carbone, à condition qu'au moins un parmi X₄₁ à X₄₄ représente un groupe monovalent ayant 9 à 30 atomes de carbone et ayant une structure styrylène représentée par la formule (1), et, lorsque deux ou plus parmi X₄₁ à X₄₄ sont des groupes monovalents ayant chacun 9 à 30 atomes de carbone et ayant chacun une structure styrylène représentée par la formule (1), ils peuvent être identiques ou différents.

5. Composition d'agent antiadhésif selon la revendication 4, dans laquelle
dans la formule (2-2), X₁ est un groupe monovalent représenté par l'une quelconque des formules (A-1) à (A-4) qui suivent,
dans la formule (3-1), X₂₁ est un groupe divalent représenté par la formule (C) qui suit,
dans la formule (4-1), X₃₁ est un groupe divalent représenté par la formule (C) qui suit, et
dans la formule (5), le groupe monovalent ayant 9 à 30 atomes de carbone et ayant une structure styrylène représentée par la formule (1) est un groupe monovalent représenté par l'une ou l'autre des formules (D-1) et (D-2) qui suivent, 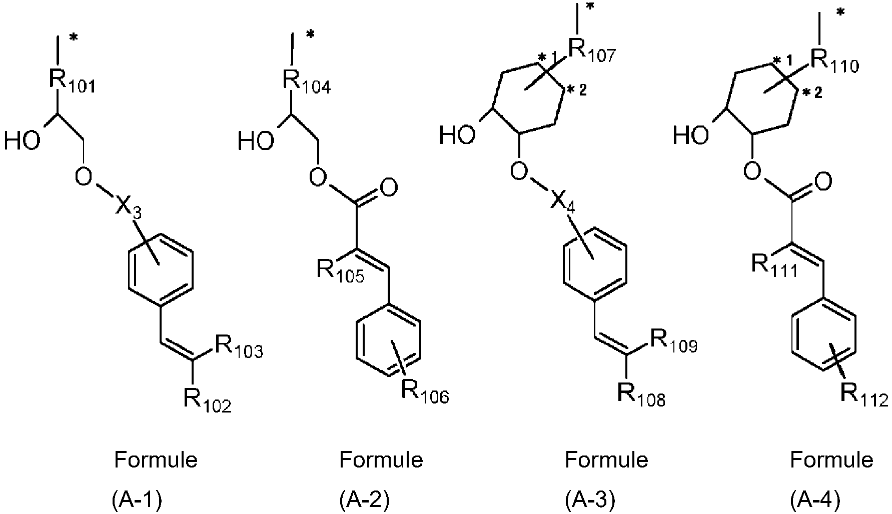
dans laquelle, dans la formule (A-1), R₁₀₁ représente une liaison simple ou un groupe alkylène ayant 1 à 10 atomes de carbone, X₃ représente une liaison simple ou -CO-, R₁₀₂ et R₁₀₃ représentent chacun indépendamment un atome d'hydrogène ou un groupe cyano, et * représente une liaison à Si dans la formule (2-2),
dans laquelle, dans la formule (A-2), R₁₀₄ représente une liaison simple ou un groupe alkylène ayant 1 à 10 atomes de carbone, R₁₀₅ représente un atome d'hydrogène ou un groupe cyano, R₁₀₆ représente un atome d'hydrogène, un atome d'halogène, un groupe hydroxy, un groupe nitro, un groupe cyano, un groupe alkyle ayant 1 à 10 atomes de carbone, un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, et * représente une liaison à Si dans la formule (2-2),
dans laquelle, dans la formule (A-3), R₁₀₇ représente une liaison simple ou un groupe alkylène ayant 1 à 10 atomes de carbone, X₄ représente une liaison simple ou -CO-, R₁₀₈ et R₁₀₉ représentent chacun indépendamment un atome d'hydrogène ou un groupe cyano, * représente une liaison à Si dans la formule (2-2), et R₁₀₇ est lié à un atome de carbone *1 ou à un atome de carbone *2,
dans laquelle, dans la formule (A-4), R₁₁₀ représente une liaison simple ou un groupe alkylène ayant 1 à 10 atomes de carbone, R₁₁₁ représente un atome d'hydrogène ou un groupe cyano, R₁₁₂ représente un atome d'hydrogène, un atome d'halogène, un groupe hydroxy, un groupe nitro, un groupe cyano, un groupe alkyle ayant 1 à 10 atomes de carbone,
un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, * représente une liaison à Si dans la formule (2-2), et R₁₁₀ est lié à un atome de carbone *1 ou à un atome de carbone *2, 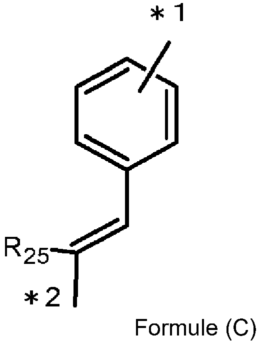
dans laquelle, dans la formule (C), R₂₅ représente un atome d'hydrogène ou un groupe cyano, et *1 et *2 représentent chacun une liaison, 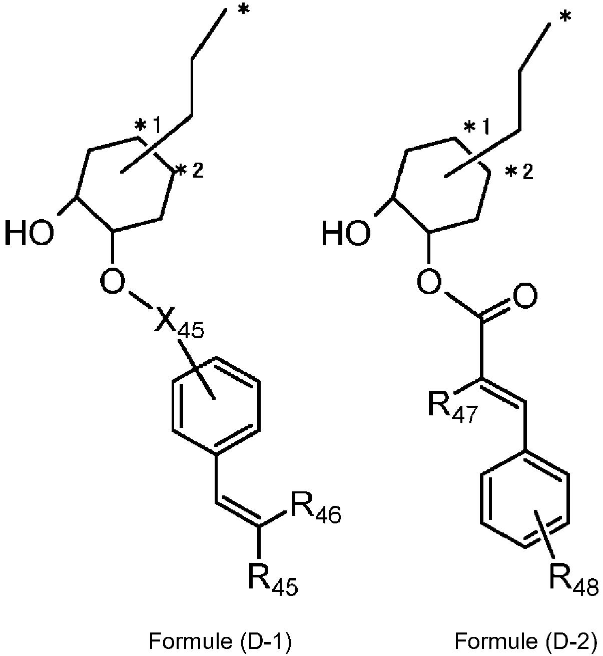
dans laquelle, dans la formule (D-1), X₄₅ représente une liaison simple ou -CO-, R₄₅ et R₄₆ représentent chacun indépendamment un atome d'hydrogène ou un groupe cyano, * représente une liaison à Si dans la formule (5), un groupe éthylène lié à Si est lié à un atome de carbone *1 ou à un atome de carbone *2 d'un cycle cyclohexane, et
dans laquelle, dans la formule (D-2), R₄₇ représente un atome d'hydrogène ou un groupe cyano, R₄₈ représente un atome d'hydrogène, un atome d'halogène, un groupe hydroxy, un groupe nitro, un groupe cyano, un groupe alkyle ayant 1 à 10 atomes de carbone,
un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, * représente une liaison à Si dans la formule (5), et un groupe éthylène lié à Si est lié à un atome de carbone *1 ou à un atome de carbone *2 d'un cycle cyclohexane.

6. Composition d'agent antiadhésif selon l'une quelconque des revendications 3 à 5, comprenant un agent de réticulation.

7. Stratifié comprenant :
un substrat semi-conducteur ;
un substrat de support, perméable à la lumière ; et
une couche adhésive et une couche de séparation disposées entre le substrat semi-conducteur et le substrat de support,
le stratifié étant utilisé pour séparer le substrat semi-conducteur et le substrat de support après que la couche de séparation absorbe la lumière émise depuis le côté du substrat de support, dans lequel
la couche de séparation est formée à partir d'une composition d'agent antiadhésif telle que définie dans la revendication 3.

8. Stratifié selon la revendication 7, dans lequel le composé contenu dans la composition d'agent antiadhésif est au moins un choisi dans le groupe constitué par un composé ayant une structure représentée par la formule (2- 1) qui suit et par une unité répétitive représentée par la formule (2-2) qui suit,
par un composé ayant une unité répétitive représentée par la formule (3-1) qui suit et par une unité répétitive représentée par la formule (3-2) qui suit, par un composé ayant une unité répétitive représentée par la formule (4-1) qui suit et par une unité répétitive représentée par la formule (4-2) qui suit, et par un composé représenté par la formule (5) qui suit, 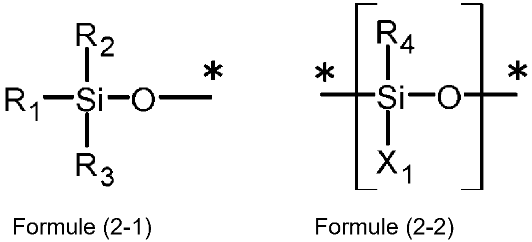
dans lequel, dans la formule (2-1), R₁ à R₃ représentent chacun indépendamment un atome d'hydrogène, un groupe hydroxy, ou un groupe hydrocarboné ayant 1 à 6 atomes de carbone, et * représente une liaison,
dans lequel, dans la formule (2-2), R₄ représente un atome d'hydrogène, un groupe hydroxy, ou un groupe hydrocarboné ayant 1 à 6 atomes de carbone, X₁ représente un groupe monovalent ayant 9 à 30 atomes de carbone et ayant une structure styrylène représentée par la formule (1), et * représente une liaison, 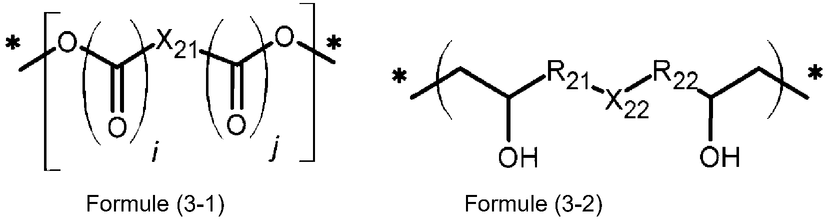
dans lequel, dans la formule (3-1), X₂₁ représente un groupe divalent ayant 8 à 30 atomes de carbone et ayant une structure styrylène représentée par la formule (1), i et j représentent chacun indépendamment 0 ou 1, et * représente une liaison ; dans la formule (3-2), X₂₂ représente un groupe représenté par la formule (B) qui suit, R₂₁ et R₂₂ représentent chacun indépendamment une liaison simple ou un groupe alkylène ayant 1 à 10 atomes de carbone et * représente une liaison, 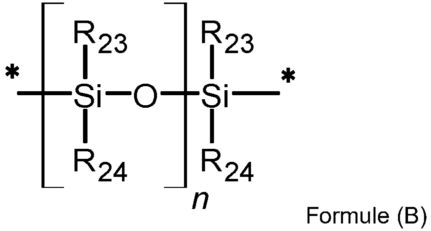
dans lequel, dans la formule (B), R₂₃ et R₂₄ représentent chacun indépendamment un atome d'hydrogène, un groupe hydroxy, ou un groupe hydrocarboné ayant 1 à 6 atomes de carbone, n représente un nombre entier de 0 ou plus, et * représente une liaison, 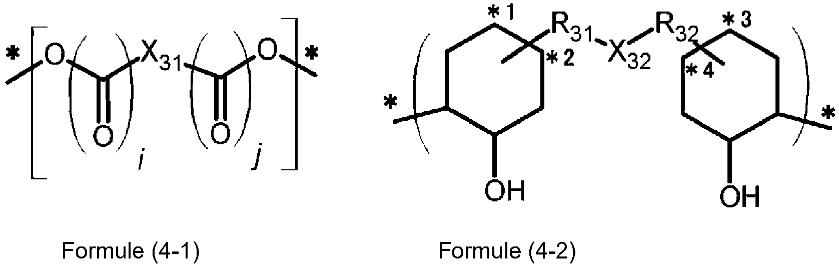
dans lequel, dans la formule (4-1), X₃₁ représente un groupe divalent ayant 8 à 30 atomes de carbone et ayant une structure styrylène représentée par la formule (1), i et j représentent chacun indépendamment 0 ou 1, et * représente une liaison,
dans lequel, dans la formule (4-2), X₃₂ représente un groupe représenté par la formule (B), R₃₁ et R₃₂ représentent chacun indépendamment une liaison simple ou un groupe alkylène ayant 1 à 10 atomes de carbone, * représente une liaison, R₃₁ est lié à un atome de carbone *1 ou à un atome de carbone *2, R₃₂ est lié à un atome de carbone*3 ou à un atome de carbone *4, et 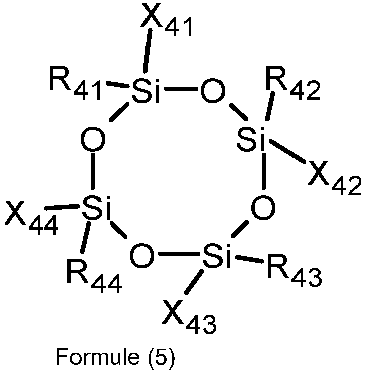
dans lequel, dans la formule (5), R₄₁ à R₄₄ représentent chacun indépendamment un atome d'hydrogène, un groupe hydroxy, ou un groupe monovalent ayant 1 à 30 atomes de carbone, et X₄₁ à X₄₄ représentent chacun indépendamment un atome d'hydrogène, un groupe hydroxy, ou un groupe monovalent ayant 1 à 30 atomes de carbone,
à condition qu'au moins un parmi X₄₁ à X₄₄ représente un groupe monovalent ayant 9 à 30 atomes de carbone et ayant une structure styrylène représentée par la formule (1), et, lorsque deux ou plus parmi X₄₁ à X₄₄ sont des groupes monovalents ayant chacun 9 à 30 atomes de carbone et ayant chacun une structure styrylène représentée par la formule (1), ils peuvent être identiques ou différents.

9. Stratifié selon la revendication 8, dans lequel
dans la formule (2-2), X₁ est un groupe monovalent représenté par l'une quelconque des formules (A-1) à (A-4) qui suivent,
dans la formule (3-1), X₂₁ est un groupe divalent représenté par la formule (C) qui suit,
dans la formule (4-1), X₃₁ est un groupe divalent représenté par la formule (C) qui suit, et
dans la formule (5), le groupe monovalent ayant 9 à 30 atomes de carbone et ayant une structure styrylène représentée par la formule (1) est un groupe monovalent représenté par l'une ou l'autre des formules (D-1) et (D-2) qui suivent, 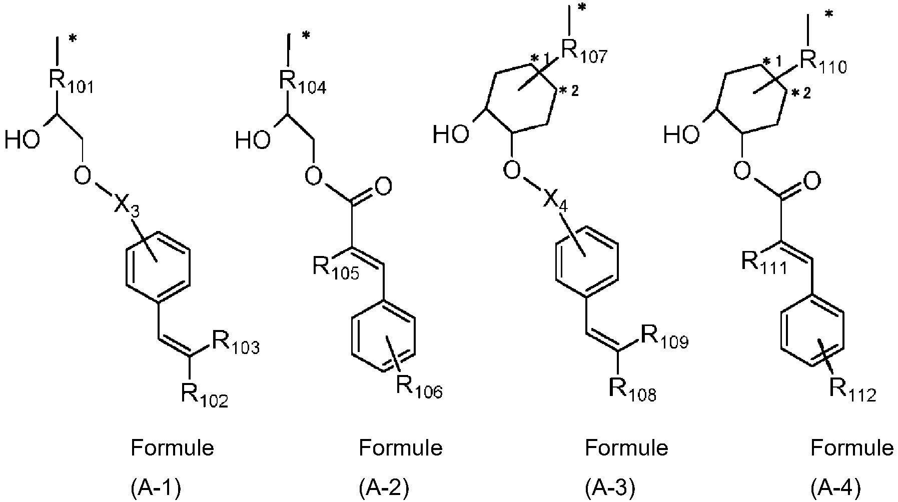
dans lequel, dans la formule (A-1), R₁₀₁ représente une liaison simple ou un groupe alkylène ayant 1 à 10 atomes de carbone, X₃ représente une liaison simple ou -CO-, R₁₀₂ et R₁₀₃ représentent chacun indépendamment un atome d'hydrogène ou un groupe cyano, et * représente une liaison à Si dans la formule (2-2),
dans lequel, dans la formule (A-2), R₁₀₄ représente une liaison simple ou un groupe alkylène ayant 1 à 10 atomes de carbone, R₁₀₅ représente un atome d'hydrogène ou un groupe cyano, R₁₀₆ représente un atome d'hydrogène, un atome d'halogène, un groupe hydroxy, un groupe nitro, un groupe cyano,
un groupe alkyle ayant 1 à 10 atomes de carbone, un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, et * représente une liaison à Si dans la formule (2-2),
dans lequel, dans la formule (A-3), R₁₀₇ représente une liaison simple ou un groupe alkylène ayant 1 à 10 atomes de carbone, X₄ représente une liaison simple ou -CO-, R₁₀₈ et R₁₀₉ représentent chacun indépendamment un atome d'hydrogène ou un groupe cyano, * représente une liaison à Si dans la formule (2-2), et R₁₀₇ est lié à un atome de carbone *1 ou à un atome de carbone *2,
dans lequel, dans la formule (A-4), R₁₁₀ représente une liaison simple ou un groupe alkylène ayant 1 à 10 atomes de carbone, R₁₁₁ représente un atome d'hydrogène ou un groupe cyano, R₁₁₂ représente un atome d'hydrogène, un atome d'halogène, un groupe hydroxy, un groupe nitro,
un groupe cyano, un groupe alkyle ayant 1 à 10 atomes de carbone, un groupe alcoxy ayant 1 à 10 atomes de carbone, un groupe alkyle halogéné ayant 1 à 10 atomes de carbone, ou un groupe alcoxy halogéné ayant 1 à 10 atomes de carbone, * représente une liaison à Si dans la formule (2-2), et R₁₁₀ est lié à un atome de carbone *1 ou à un atome de carbone *2, 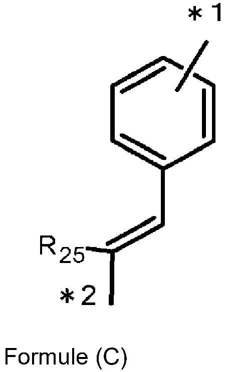
dans lequel, dans la formule (C), R₂₅ représente un atome d'hydrogène ou un groupe cyano, et *1 et *2 représentent chacun une liaison, 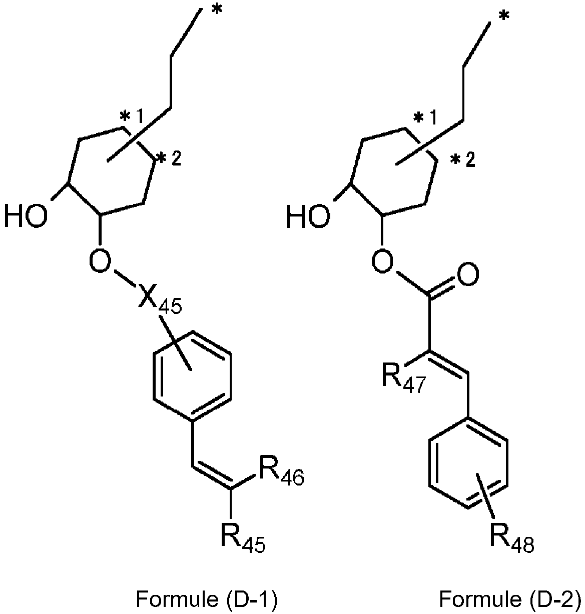
dans lequel, dans la formule (D-1), X₄₅ représente une liaison simple ou -CO-, R₄₅ et R₄₆ représentent chacun indépendamment un atome d'hydrogène ou un groupe cyano, * représente une liaison à Si dans la formule (5), un groupe éthylène lié à Si est lié à un atome de carbone *1 ou à un atome de carbone *2 d'un cycle cyclohexane, et
dans lequel, dans la formule (D-2), R₄₇ représente un atome d'hydrogène ou un groupe cyano, R₄₈ représente un atome d'hydrogène, un atome d'halogène, un groupe hydroxy, un groupe nitro, un groupe cyano, un groupe alkyle ayant 1 à 10 atomes de carbone, un groupe alcoxy ayant 1 à 10 atomes de carbone,
un groupe alkyle halogéné ayant 1 à 10 atomes de carbone, ou un groupe alcoxy halogéné ayant 1 à 10 atomes de carbone, * représente une liaison à Si dans la formule (5), et un groupe éthylène lié à Si est lié à un atome de carbone *1 ou à un atome de carbone *2 d'un cycle cyclohexane.

10. Stratifié selon l'une quelconque des revendications 7 à 9, dans lequel la composition d'agent antiadhésif contenant un agent de réticulation.

11. Stratifié selon l'une quelconque des revendications 7 à 10, dans lequel la couche adhésive est formée à partir d'une composition adhésive contenant un composé ayant une structure siloxane.

12. Stratifié selon la revendication 11, dans lequel la composition adhésive contient un composant durcissable (A).

13. Stratifié selon la revendication 12, dans lequel le composant (A) est durcissable par une réaction d'hydrosilylation.

14. Stratifié selon la revendication 12 ou la revendication 13, dans lequel
le composant (A) contient :
un polyorganosiloxane (a1) ayant un groupe alcényle ayant 2 à 40 atomes de carbone et lié à un atome de silicium ;
un polyorganosiloxane (a2) ayant un groupe Si-H ; et
un catalyseur à base de métal du groupe du platine (A2).

15. Procédé de fabrication d'un substrat semi-conducteur traité, le procédé comprenant :
une première étape consistant à traiter le substrat semi-conducteur du stratifié selon l'une quelconque des revendications 7 à 14 ;
une deuxième étape consistant à séparer l'un de l'autre le substrat semi-conducteur traité dans la première étape et le substrat de support ; et
une troisième étape consistant à nettoyer le substrat semi-conducteur séparé avec une composition d'agent de nettoyage.

16. Procédé de fabrication d'un substrat semi-conducteur traité, selon la revendication 15, dans lequel la deuxième étape comprend une étape consistant à irradier la couche de séparation avec de la lumière.

17. Procédé de fabrication d'un substrat semi-conducteur traité, selon la revendication 15 ou la revendication 16, dans lequel la composition d'agent de nettoyage contient un sel d'ammonium quaternaire et un solvant.

18. Procédé de fabrication d'un substrat semi-conducteur traité, selon la revendication 17, dans lequel le sel d'ammonium quaternaire est un sel d'ammonium quaternaire contenant un halogène.

19. Procédé de fabrication d'un substrat semi-conducteur traité, selon la revendication 18, dans lequel le sel d'ammonium quaternaire contenant un halogène est un sel d'ammonium quaternaire contenant du fluor.
